(19) Europäisches Patentamt
European Patent Office
Office européen des brevets

(11) EP 3 605 591 A1

(12) # EUROPEAN PATENT APPLICATION
published in accordance with Art. 153(4) EPC

(43) Date of publication:
**05.02.2020 Bulletin 2020/06**

(21) Application number: **18774420.6**

(22) Date of filing: **28.02.2018**

(51) Int Cl.:
***H01L 21/336*** (2006.01) ***C01B 32/158*** (2017.01)
***H01L 21/208*** (2006.01) ***H01L 21/312*** (2006.01)
***H01L 29/786*** (2006.01) ***H01L 51/05*** (2006.01)
***H01L 51/30*** (2006.01)

(86) International application number:
**PCT/JP2018/007469**

(87) International publication number:
**WO 2018/180146 (04.10.2018 Gazette 2018/40)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**MA MD TN**

(30) Priority: **27.03.2017 JP 2017060426**

(71) Applicant: **Toray Industries, Inc.**
**Tokyo 103-8666 (JP)**

(72) Inventors:
- **ISOGAI, Kazuki**
  **Otsu-shi**
  **Shiga 520-8558 (JP)**
- **MURASE, Seiichiro**
  **Otsu-shi**
  **Shiga 520-8558 (JP)**
- **SAKII, Daisuke**
  **Otsu-shi**
  **Shiga 520-8558 (JP)**

(74) Representative: **Hoefer & Partner Patentanwälte mbB**
**Pilgersheimer Straße 20**
**81543 München (DE)**

(54) **SEMICONDUCTOR DEVICE, COMPLEMENTARY SEMICONDUCTOR DEVICE, MANUFACTURING METHOD OF SEMICONDUCTOR DEVICE, WIRELESS COMMUNICATION DEVICE AND PRODUCT TAG**

(57) The present invention addresses the problem of providing a semiconductor device having stable n-type semiconductor characteristics without deterioration over time. The purpose of the present invention is to provide a semiconductor device provided with: a substrate; a source electrode, a drain electrode and a gate electrode; a semiconductor layer which contacts the source electrode and the drain electrode; a gate insulation layer which insulates the semiconductor layer from the gate electrode; and a second insulation layer which contacts the semiconductor layer on a side opposite to the gate insulation layer with respect to the semiconductor layer, wherein the semiconductor device is characterized in that the semiconductor layer contains carbon nanotubes, the second insulation layer contains electron-donating compounds including at least any one selected from among nitrogen atoms and phosphorous atoms, and the oxygen permeability of the second insulation layer is equal to or less than 4.0 cc/($m^2$·24h·atm).

EP 3 605 591 A1

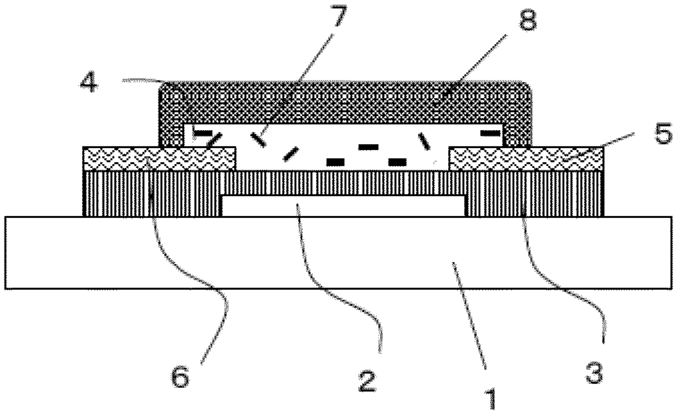


Fig. 1

## Description

### TECHNICAL FIELD

The present invention relates to semiconductor devices, complementary semiconductor devices, semiconductor device production methods, wireless communication devices, and merchandise tags.

### BACKGROUND ART

In recent years, development has been promoted for wireless communication systems in which the RFID (Radio Frequency IDentification) technology is used for contactless tags. RFID systems perform wireless communication between a wireless transceiver called a reader/writer and an RFID tag.

RFID tags are expected to be utilized in various applications such as logistics management, merchandise management, shoplifting prevention, and the like, and have been introduced in some of the applications, for example, merchandise tags and IC cards such as transportation cards. An RFID tag has an IC chip and an antenna. The antenna mounted in the RFID tag receives carrier waves transmitted from readers/writers and thus operates a drive circuit in the IC chip.

RFID tags are expected to be used for every kind of merchandise. For that purpose, the production cost of RFID tags needs to be reduced. In view of this, studies have been made on utilizing flexible and inexpensive processes for production processes of RFID tags, wherein the flexible and inexpensive processes are based on getting rid of production processes that use vacuum and high temperature and on using coating and printing technologies.

For example, in the case of a transistor in a drive circuit in an IC chip, it is conceivable that an organic semiconductor to which an inkjet technology or a screening technology is applicable is used as a material for a semiconductor layer. In view of this, field-effect transistors (hereinafter referred to as FETs) in which carbon nanotubes (CNTs) or organic semiconductors are used in place of conventional inorganic semiconductors are vigorously studied (see, for example, Patent Document 1).

A drive circuit in an IC chip generally includes a complementary circuit composed of a p-type FET and an n-type FET for purposes of suppression of power consumption and the like. It is known, however, that an FET with CNTs used therein (hereinafter referred to as CNT-FET) usually exhibits the characteristics of a p-type semiconductor device in the atmosphere. In view of this, studies have been made on converting the characteristics of a CNT-FET into an n-type semiconductor device, for example, by heating the CNT-FET under vacuum or doping oxygen, potassium, or the like to the CNT (see, for example, Patent Document 2 and Non-Patent Document 1).

### Citation List

#### Patent Documents

Patent Document 1: WO 2009/139339
Patent Document 2: US 2003/122133 A1

#### Non-Patent Document

Non-Patent Document 1: Nano Letters. 1, p. 453-456 (2001)

### SUMMARY OF INVENTION

#### Technical Problem

However, a CNT-FET produced by such a technology as described in Patent Document 2 and Non-Patent Document 1 changes in semiconductor characteristics over time in the atmosphere, and accordingly, has a problem in that such a CNT-FET must be handled under vacuum or under an inert gas atmosphere such as nitrogen.

In view of this, an object of the present invention is to provide a semiconductor device that is free from deterioration over time, is stable, and has n-type semiconductor characteristics.

Solution to Problem

To solve the above-mentioned problems, the present invention has the following constitution. That is, the present invention is a semiconductor device, including:

a substrate;
a source electrode, a drain electrode, and a gate electrode;
a semiconductor layer in contact with the source electrode and the drain electrode;
a gate insulating layer insulating the semiconductor layer from the gate electrode; and
a second insulating layer in contact with the semiconductor layer on the opposite side of the semiconductor layer from the gate insulating layer;
wherein the semiconductor layer contains a carbon nanotube;
wherein the second insulating layer contains an electron-donating material having one or more selected from a nitrogen atom and a phosphorus atom; and
wherein the second insulating layer has an oxygen permeability of 4.0 cc/($m^2$·24h·atm) or less.

Advantageous Effects of Invention

The present invention makes it possible to obtain a semiconductor device in which a CNT that is free from deterioration over time in the atmosphere and stable is used. In addition, the present invention can provide: a complementary semiconductor device for which the above-mentioned semiconductor device is used; and a wireless communication device and a merchandise tag for both of which the complementary semiconductor device is used.

BRIEF DESCRIPTION OF DRAWINGS

Fig. 1 is a schematic cross-sectional view depicting a semiconductor device which is one of the embodiments of the present invention.
Fig. 2 is a schematic cross-sectional view depicting a semiconductor device which is one of the embodiments of the present invention.
Fig. 3 is a schematic cross-sectional view depicting a semiconductor device which is one of the embodiments of the present invention.
Fig. 4 is a schematic cross-sectional view depicting a semiconductor device which is one of the embodiments of the present invention.
Fig. 5A is a cross-sectional view depicting production steps of a semiconductor device which is one of the embodiments of the present invention.
Fig. 5B is a cross-sectional view depicting production steps of a semiconductor device which is one of the embodiments of the present invention.
Fig. 6 is a schematic cross-sectional view depicting a complementary semiconductor device which is one of the embodiments of the present invention.
Fig. 7 is a schematic cross-sectional view depicting a complementary semiconductor device which is one of the embodiments of the present invention.
Fig. 8 is a schematic cross-sectional view depicting a complementary semiconductor device which is one of the embodiments of the present invention.
Fig. 9 is a schematic diagram describing a function of a complementary semiconductor device which is one of the embodiments of the present invention.
Fig. 10A is a cross-sectional view depicting production steps of a complementary semiconductor device which is one of the embodiments of the present invention.
Fig. 10B is a cross-sectional view depicting production steps of a complementary semiconductor device which is one of the embodiments of the present invention.
Fig. 11 is a block diagram depicting an example of a wireless communication device for which a semiconductor device or a complementary semiconductor device which is one of the embodiments of the present invention is used.
Fig. 12 is a schematic cross-sectional view depicting a semiconductor device which is one of the embodiments of the present invention.

DESCRIPTION OF EMBODIMENTS

Below, preferred embodiments of a semiconductor device, a complementary semiconductor device, a semiconductor device production method, a wireless communication device, and a merchandise tag according to the present invention will be described in detail. However, the present invention is not to be limited to the following embodiments, and can be embodied with various modifications in accordance with the purpose and application.

<Semiconductor Device>

A semiconductor device according to an embodiment of the present invention is a semiconductor device, including: a substrate; a source electrode, a drain electrode, and a gate electrode; a semiconductor layer in contact with the source electrode and the drain electrode; a gate insulating layer insulating the semiconductor layer from the gate electrode; and a second insulating layer in contact with the semiconductor layer on the opposite side of the semiconductor layer from the gate insulating layer; wherein the semiconductor layer contains a carbon nanotube; wherein the second insulating layer contains an electron-donating material having one or more selected from a nitrogen atom and a phosphorus atom; and wherein the second insulating layer has an oxygen permeability of 4.0 cc/($m^2$·24h·atm) or less.

Fig. 1 is a schematic cross-sectional view depicting a first example of a semiconductor device according to an embodiment of the present invention. The semiconductor device has: an insulating substrate 1 on which a gate electrode 2 is formed; a gate insulating layer 3 covering the gate electrode; a source electrode 5 and a drain electrode 6 provided on the gate insulating layer; a semiconductor layer 4 provided between the electrodes; and a second insulating layer 8 covering the semiconductor layer. The semiconductor layer 4 contains a carbon nanotube 7.

This structure is what is called a bottom-gate/bottom-contact structure in which a gate electrode is disposed below a semiconductor layer, and a source electrode and a drain electrode are disposed on the underside of the semiconductor layer.

Fig. 2 is a schematic cross-sectional view depicting a second example of a semiconductor device according to an embodiment of the present invention. The semiconductor device has: an insulating substrate 1 on which a gate electrode 2 is formed; a gate insulating layer 3 covering the gate electrode; a semiconductor layer 4 provided on the gate insulating layer; a source electrode 5 and a drain electrode 6 formed on the semiconductor layer; and a second insulating layer 8 provided on them. The semiconductor layer 4 contains a carbon nanotube 7.

This structure is what is called a bottom-gate/top-contact structure in which a gate electrode is disposed below a semiconductor layer, and a source electrode and a drain electrode are disposed on the top side of the semiconductor layer.

The structure of a semiconductor device according to an embodiment of the present invention is not to be limited to these. In addition, the below-mentioned description equally applies regardless of the structure of a semiconductor device, unless otherwise specified.

(Substrate)

The substrate may be of any material as long as at least the surface of the substrate on which the electrode system is to be disposed has insulating properties. Preferable examples of substrates include: ones composed of an inorganic material such as a silicon wafer, glass, sapphire, or an alumina sintered material; and ones composed of an organic material such as polyimide, polyvinyl alcohol, polyvinyl chloride, polyethylene terephthalate, polyvinylidene fluoride, polysiloxane, polyvinyl phenol (PVP), polyester, polycarbonate, polysulfone, polyether sulfone, polyethylene, polyphenylene sulfide, or polyparaxylene.

In addition, the substrate may also be, for example, one which is a plurality of materials layered one on another, such as a silicon wafer with a PVP film formed thereon or a polyethylene terephthalate material with a polysiloxane film formed thereon.

The substrate preferably has low oxygen permeability. The oxygen permeability of the substrate is preferably 4.0 cc/($m^2$·24h·atm) or less, more preferably 2.5 cc/($m^2$·24h·atm) or less, still more preferably 1.5 cc/($m^2$·24h·atm) or less. The lower limit is not limited to a particular value, and is approximately 0.001 cc/($m^2$·24h·atm) or more, taking into consideration the characteristics of a practical material.

In the present invention, the oxygen permeability of a substrate or a second insulating layer is a value calculated from the thickness thereof and the oxygen permeability coefficients of the materials contained therein; that is, a value determined by multiplying the oxygen permeability coefficients by the thickness. The oxygen permeability coefficient of a material is determined on the basis of JIS K 7126-2 2006 (Plastics - Film and sheeting - Determination of gas-transmission rate). As below-mentioned in detail, the thickness of the second insulating layer is calculated on the basis of an observation for which a scanning electron microscope (SEM) is used. A conversion of the oxygen permeability coefficient is made on the basis of the film thickness to calculate an oxygen permeability. In the case of a laminated film,

the oxygen permeability coefficient and film thickness of each layer are calculated, and the oxygen permeability coefficient of a laminated film is calculated using the following equation.

$$(\text{Film Thickness of Laminated Film} / \text{Oxygen Permeability Coefficient of Laminated Film}) = \Sigma((\text{Film Thickness of Layer i}) / (\text{Oxygen Permeability Coefficient of Layer i}))$$

Here, i represents the i-th layer. $\Sigma$ is the sum of all layers constituting the laminated film. The oxygen permeability is calculated by multiplying the oxygen permeability coefficient of the laminated film by the film thickness of the laminated film.

(Electrode)

The materials used for the gate electrode, source electrode, and drain electrode may be any electrically conductive materials which can be generally used for electrodes. Examples thereof include, but are not limited to: electrically conductive metal oxides such as tin oxide, indium oxide and indium tin oxide (ITO); metals such as platinum, gold, silver, copper, iron, tin, zinc, aluminum, indium, chromium, lithium, sodium, potassium, cesium, calcium, magnesium, palladium, molybdenum, amorphous silicon, and polysilicon, and alloys thereof; inorganic electrically conductive substances such as copper iodide and copper sulfide; polythiophene, polypyrrole, and polyaniline; a complex of polyethylenedioxythiophene and polystyrene sulfonic acid, and the like; electrically conductive polymers whose electrical conductivities are enhanced by doping with iodine or the like; carbon materials and the like; materials containing an organic component and an electrical conductor; and the like.

These electrode materials may be used singly, or a plurality of these materials may be used as a laminate or a mixture.

The electrode preferably contains, among others, an organic component and an electrical conductor from the viewpoint that such an electrode affords increased electrode flexibility, good adhesion between a substrate and a gate insulating layer even in bending, and good electrical connection between wiring and a semiconductor layer.

The organic component is not particularly limited, and may be, for example, a monomer, an oligomer, a polymer, a photopolymerization initiator, a plasticizer, a leveling agent, a surfactant, a silane coupling agent, an antifoaming agent, or a pigment. Among these, an oligomer or polymer is preferred as an organic component, from the viewpoint of improving the bending resistance of the electrode.

The oligomer or polymer is not limited to a particular one, and an acrylic resin, an epoxy resin, a novolac resin, a phenol resin, a polyimide precursor, a polyimide, or the like can be used. Among these, an acrylic resin is preferred, from the viewpoint of improving crack resistance to bending an electrode. This is assumed to be because, an acrylic resin has a glass transition temperature of 100°C or lower, and thus softens during the thermal curing of the conductive film to increase the bond between electrical conductor particles.

The acrylic resin is a resin which contains at least a structure derived from an acrylic monomer, as a repeating unit. Specific examples of acrylic monomers include all olefinic compounds containing a carbon-carbon double bond, and preferred examples thereof include:

acrylic monomers such as methyl acrylate, acrylic acid, 2-ethylhexyl acrylate, ethyl methacrylate, n-butyl acrylate, i-butyl acrylate, i-propane acrylate, glycidyl acrylate, N-methoxymethyl acrylamide, N-ethoxymethyl acrylamide, N-n-butoxymethyl acrylamide, N-isobutoxymethyl acrylamide, butoxy triethylene glycol acrylate, dicyclopentanyl acrylate, dicyclopentenyl acrylate, 2-hydroxyethyl acrylate, isobornyl acrylate, 2-hydroxypropylacrylate, isodecyl acrylate, isooctyl acrylate, lauryl acrylate, 2-methoxyethyl acrylate, methoxyethylene glycol acrylate, methoxydiethylene glycol acrylate, octafluoropentyl acrylate, phenoxyethyl acrylate, stearyl acrylate, trifluoroethyl acrylate, acrylamide, aminoethyl acrylate, phenyl acrylate, phenoxyethyl acrylate, 1-naphthyl acrylate, 2-naphthyl acrylate, thiophenol acrylate, and benzylmercaptan acrylate; those obtained by replacing the acrylate in these monomers with methacrylate;
styrenes such as styrene, p-methylstyrene, o-methylstyrene, m-methylstyrene, $\alpha$-methylstyrene, chloromethylstyrene, and hydroxymethylstyrene;
$\gamma$-methacryloxypropyltrimethoxysilane; 1-vinyl-2-pyrrolidone;
and the like.

These acrylic monomers may be used singly, or in combination of two or more kinds thereof.

An electrical conductor may be of any electrically conductive material which can be generally used for electrodes, and is preferably electroconductive particles. Using electroconductive particles as an electrical conductor allows irregularities to be formed on the surface of an electrode containing the electroconductive particles. The gate insulating film infiltrates into the irregularities to produce an anchoring effect, thereby improving the adhesion between the electrode and the gate insulating film. Enhanced adhesion between an electrode and a gate insulating film has the effect of enhancing the bending resistance of the electrode and the effect of suppressing fluctuation in electrical characteristics when voltage is repeatedly applied to a semiconductor device. These effects improve the reliability of a semiconductor device.

Examples of electroconductive particles include gold, silver, copper, nickel, tin, bismuth, lead, zinc, palladium, platinum, aluminum, tungsten, molybdenum, carbon, and the like. More preferable electroconductive particles are electroconductive particles containing at least one element selected from the group consisting of gold, silver, copper, nickel, tin, bismuth, lead, zinc, palladium, platinum, aluminum, and carbon. These electroconductive particles may be used singly, used as an alloy, or used as a particle mixture.

Among these, particles of gold, silver, copper, or platinum are preferred, from the viewpoint of electrical conductivity. Among others, particles of silver are more preferred, from the viewpoint of cost and stability.

As an index of the irregularities of the surface of an electrode, the arithmetic average roughness (Ra) of the surface of the electrode may be used, for example. The surface of the electrode preferably has an Ra of, for example, from 5 nm to 200 nm. An Ra of 5 nm or more allows the above-mentioned anchoring effect to be expressed effectively. Further, an Ra of 200 nm or less enables a gate insulating film having no pinhole defect to be produced. Preventing pinhole defects from occurring in the gate insulating film can prevent a short circuit from occurring in a semiconductor device.

In this regard, Ra in the present invention is a value determined by making a measurement by the following method using a surface profilometer or atomic force microscope (AFM). In the case of using a surface profilometer, Ra is measured at any selected five points on the electrode, and the average value of the measured values is taken. Also in the case of using an AFM, Ra is measured at any selected five points on the conductive film, and the average value of the measured values is taken. These measurement methods are used as appropriate depending on the size of the conductive film to be measured. In cases where the Ra can be measured by either method, the value measured by the surface profilometer is used.

The electroconductive particles in an electrode preferably have an average particle size of from 0.01 μm to 5 μm, and more preferably from 0.01 μm to 2 μm. In cases where the average particle size of the electroconductive particles is 0.01 μm or more, the probability of contact between the electroconductive particles is improved, and it is possible to decrease the specific resistance of the produced electrode and lower the probability of disconnection. In addition, in cases where the average particle size of the electroconductive particles is 5 μm or less, the electrode results in having high bending resistance. In addition, in cases where the average particle size of the electroconductive particles is 2 μm or less, the surface smoothness, pattern accuracy, and dimensional accuracy of the electrode are further enhanced.

In this regard, the average particle size of the electroconductive particles in an electrode in the present invention is a value measured by the following method. The cross-section of an electrode is observed using a scanning electron microscope at a magnification ratio of 10000×. From the obtained image, 100 particles are randomly selected, the particle size of each particle is measured, and the arithmetic average value of the sizes is regarded as the average particle size. In cases where the particles have a spherical shape, the diameter of each particle is taken as the particle size of the particle. In cases where the particles have a shape other than a spherical shape, the average value of the maximum width and the minimum width of the widths of one particle observed using an electron microscope is calculated as the particle size of the particle.

The amount of electrical conductor in the electrode is preferably from 70 wt% to 95 wt% with respect to the weight of the electrode, and it is more preferable that the lower limit thereof is 80 wt% or more, and that the upper limit thereof is 90 wt% or less. When the amount of the electrical conductor is within the above described range, the specific resistance of the electrode can be decreased, and the probability of disconnection can be lowered.

In addition, the width and thickness of each of the gate electrode, source electrode, and drain electrode, and the spacing between the source electrode and the drain electrode can be designed to be any value. For example, it is preferred that each electrode has a width of from 10 μm to 10 mm, that each electrode has a thickness of from 0.01 μm to 100 μm, and that the spacing between the source electrode and the drain electrode is from 1 μm to 1 mm, but the width, the thickness, and the spacing are not limited to these values.

Examples of methods of forming an electrode include, without particular limitation, methods using known technologies, such as resistance heating evaporation, electron beaming, sputtering, plating, CVD, ion plating coating, inkjet, and printing. In addition, other examples of methods of forming an electrode include a method in which a paste containing the organic component and the electrical conductor is applied onto an insulating substrate using a known technique such as a spin-coating method, a blade coating method, a slit die coating method, a screen printing method, a bar coater

method, a casting method, a transfer printing method, an immersion and withdrawal method, or the like, and dried using an oven, a hot plate, infrared ray, or the like to form an electrode.

In addition, a method of forming an electrode pattern may be a method in which an electrode thin film formed by the above described method is patterned into a desired form by a known photolithography method or the like, or may be a method in which a pattern is formed via a mask having a desired shape, when performing the vapor deposition or sputtering of an electrode substance.

(Gate Insulating Layer)

The material to be used for the gate insulating layer is not particularly limited, and examples thereof include: inorganic materials such as silicon oxide and alumina; organic polymer materials such as polyimide, polyvinyl alcohols, polyvinyl chloride, polyethylene terephthalate, polyvinylidene fluoride, polysiloxane, and polyvinyl phenol (PVP); and mixtures of an inorganic material powder and an organic material. Among these, the gate insulating layer preferably contains an organic compound containing a bond between silicon and carbon.

Examples of organic compounds include a silane compound represented by the general formula (9), an epoxy group-containing silane compound represented by the general formula (10), a condensation product thereof, and a polysiloxane containing any of these as a copolymerization component. Among these, the polysiloxane is more preferred, from the viewpoint that it has high insulation properties and is capable of being cured at a low temperature.

$$R^{14}_{m}Si(OR^{15})_{4-m} \qquad (9)$$

Here, $R^{14}$ represents a hydrogen atom, an alkyl group, a heterocyclic group, an aryl group, or an alkenyl group. In cases where a plurality of $R^{14}$s are present, the respective $R^{14}$s may be the same or different. $R^{15}$ represents a hydrogen atom, an alkyl group, an acyl group, or an aryl group. In cases where a plurality of $R^{15}$s are present, the respective $R^{15}$s may be the same or different. m represents an integer of 1 to 3.

$$R^{16}_{n}R^{17}_{l}Si(OR^{18})_{4-n-l} \qquad (10)$$

Here, $R^{16}$ represents an alkyl group containing one or more epoxy groups as a part of the chain. In cases where a plurality of $R^{16}$s are present, the respective $R^{16}$s may be the same or different. $R^{17}$ represents a hydrogen atom, an alkyl group, a heterocyclic group, an aryl group, or an alkenyl group. In cases where a plurality of $R^{17}$s are present, the respective $R^{17}$s may be the same or different. $R^{18}$ represents a hydrogen atom, an alkyl group, an acyl group, or an aryl group. In cases where a plurality of $R^{18}$s are present, the respective $R^{18}$s may be the same or different. 1 represents an integer of 0 to 2, and n represents 1 or 2, with the proviso that $1 + n \leq 3$.

The meaning of each of the alkyl group, acyl group, and aryl group in $R^{14}$ to $R^{18}$ has the same meaning as in the below-mentioned description of $R^{19}$ to $R^{24}$.

The heterocyclic group in each of $R^{14}$ and $R^{17}$ represents a group derived from an aliphatic ring containing an atom other than a carbon atom within the ring and optionally contains or does not contain a substituent, examples of the ring including a pyran ring, a piperidine ring, or an amide ring. The number of carbon atoms in the heterocyclic group is not limited to a particular one, but it is preferably within the range of from 2 to 20.

The alkenyl group in each of $R^{14}$ and $R^{17}$ represents an unsaturated aliphatic hydrocarbon group containing a double bond and optionally contains or does not contain a substituent, examples of the alkenyl group including a vinyl group, an allyl group, a butadienyl group or the like. The number of carbon atoms in the alkenyl group is not particularly limited, but it is preferably within the range of from 2 to 20.

The alkyl group having an epoxy group(s) as a part of the chain, in $R^{16}$, represents an alkyl group having a 3-membered ring ether structure formed by two adjacent carbon atoms being linked by one oxygen atom, as a part of the chain. Examples of such an alkyl group include the following two alkyl groups. One is an alkyl group wherein, in the main chain that is the portion where carbon atoms extend continuously for the longest length, two adjacent carbon atoms are used. The other one is an alkyl group wherein, in what is called a side chain that is a portion other than the main chain, two adjacent carbon atoms are used.

By incorporating the silane compound represented by the general formula (9) as a copolymerization component of a polysiloxane, it is possible to improve the insulation properties and chemical resistance of the resulting film while maintaining a high transparency in the visible light region, and to form an insulating film with fewer traps therein.

Further, it is preferred that at least one of the $R^{14}$s in the general formula (9), which are present in a number of m, be an aryl group, because it allows for improving the flexibility of the resulting insulating film, and to prevent the occurrence of cracks.

Specific examples of the silane compound represented by the general formula (9) include vinyltrimethoxysilane, vinyltriethoxysilane, 3-methacryloxypropyltrimethoxysilane, 3-methacryloxypropyltriethoxysilane, methyltrimethoxysilane, methyltriethoxysilane, ethyltrimethoxysilane, ethyltriethoxysilane, propyltrimethoxysilane, propyltriethoxysilane, hexyltrimethoxysilane, octadecyltrimethoxysilane, octadecyltriethoxysilane, phenyltrimethoxysilane, phenyltriethoxysilane, p-tolyltrimethoxysilane, benzyltrimethoxysilane, α-naphthyltrimethoxysilane, β-naphthyltrimethoxysilane, 3-aminopropyltriethoxysilane, N-(2-aminoethyl)-3-aminopropyltrimethoxysilane, 3-chloropropyltrimethoxysilane, dimethyldimethoxysilane, dimethyldiethoxysilane, diphenyldimethoxysilane, diphenyldiethoxysilane, methylphenyldimethoxysilane, methylvinyldimethoxysilane, methylvinyldiethoxysilane, 3-aminopropylmethyldimethoxysilane, N-(2-aminoethyl)-3-aminopropylmethyldimethoxysilane, 3-chloropropylmethyldimethoxysilane, 3-chloropropylmethyldiethoxysilane, cyclohexylmethyldimethoxysilane, 3-methacryloxypropyldimethoxysilane, octadecylmethyldimethoxysilane, trimethoxysilane, trifluoroethyltrimethoxysilane, trifluoroethyltriethoxysilane, trifluoroethyltriisopropoxysilane, trifluoropropyltrimethoxysilane, trifluoropropyltriethoxysilane, trifluoropropyltriisopropoxysilane, heptadecafluorodecyltrimethoxysilane, heptadecafluorodecyltriethoxysilane, heptadecafluorodecyltriisopropoxysilane, tridecafluorooctyltriethoxysilane, tridecafluorooctyltrimethoxysilane, tridecafluorooctyltriisopropoxysilane, trifluoroethylmethyldimethoxysilane, trifluoroethylmethyldiethoxysilane, trifluoroethylmethyldiisopropoxysilane, trifluoropropylmethyldimethoxysilane, trifluoropropylmethyldiethoxysilane, trifluoropropylmethyldiisopropoxysilane, heptadecafluorodecylmethyldimethoxysilane, heptadecafluorodecylmethyldiethoxysilane, heptadecafluorodecylmethyldiisopropoxysilane, tridecafluorooctylmethyldimethoxysilane, tridecafluorooctylmethyldiethoxysilane, tridecafluorooctylmethyldiisopropoxysilane, trifluoroethylethyldimethoxysilane, trifluoroethylethyldiethoxysilane, trifluoroethylethyldiisopropoxysilane, trifluoropropylethyldimethoxysilane, trifluoropropylethyldiethoxysilane, trifluoropropylethyldiisopropoxysilane, heptadecafluorodecylethyldimethoxysilane, heptadecafluorodecylethyldiethoxysilane, heptadecafluorodecylethyldiisopropoxysilane, tridecafluorooctylethyldiethoxysilane, tridecafluorooctylethyldimethoxysilane, tridecafluorooctylethyldiisopropoxysilane, p-trifluorophenyltriethoxysilane, and the like.

To increase the crosslinking density and to improve the chemical resistance and insulation properties, it is preferable to use, among the above mentioned silane compounds, one wherein m = 1, such as vinyltrimethoxysilane, vinyltriethoxysilane, methyltrimethoxysilane, methyltriethoxysilane, ethyltrimethoxysilane, ethyltriethoxysilane, propyltrimethoxysilane, propyltriethoxysilane, hexyltrimethoxysilane, octadecyltrimethoxysilane, octadecyltriethoxysilane, phenyltrimethoxysilane, p-tolyltrimethoxysilane, benzyltrimethoxysilane, α-naphthyltrimethoxysilane, β-naphthyltrimethoxysilane, trifluoroethyltrimethoxysilane, trimethoxysilane, or p-trifluorophenyltriethoxysilane. Further, from a mass production viewpoint, it is particularly preferable to use one wherein $R^{15}$ is a methyl group, such as vinyltrimethoxysilane, methyltrimethoxysilane, ethyltrimethoxysilane, propyltrimethoxysilane, hexyltrimethoxysilane, octadecyltrimethoxysilane, octadecyltrimethoxysilane, phenyltrimethoxysilane, p-tolyltrimethoxysilane, benzyltrimethoxysilane, α-naphthyltrimethoxysilane, β-naphthyltrimethoxysilane, trifluoroethyltrimethoxysilane, or trimethoxysilane.

In addition, it is more preferred that two or more kinds of the silane compounds represented by the general formula (9) are used in combination. In particular, the use of a silane compound containing an alkyl group and a silane compound containing an aryl group in combination is particularly preferred, because it allows for providing high insulation properties and flexibility for preventing the occurrence of cracks in a balanced manner.

Specific examples of the epoxy group-containing silane compound represented by the general formula (10) include γ-glycidoxypropyltrimethoxysilane, β-(3,4-epoxycyclohexyl)ethyltrimethoxysilane, γ-glycidoxypropyltriethoxysilane, β-(3,4-epoxycyclohexyl)ethyltriethoxysilane, γ-glycidoxypropyltriisopropoxysilane, β-(3,4-epoxycyclohexyl)ethyltriisopropoxysilane, γ-glycidoxypropylmethyldimethoxysilane, β-(3,4-epoxycyclohexyl)ethylmethyldimethoxysilane, γ-glycidoxypropylmethyldiethoxysilane, β-(3,4-epoxycyclohexyl)ethylmethyldiethoxysilane, γ-glycidoxypropylmethyldiisopropoxysilane, β-(3,4-epoxycyclohexyl)ethylmethyldiisopropoxysilane, γ-glycidoxypropylethyldimethoxysilane, β-(3,4-epoxycyclohexyl)ethylethyldimethoxysilane, γ-glycidoxypropylethyldiethoxysilane, β-(3,4-epoxycyclohexyl)ethylethyldiethoxysilane, γ-glycidoxypropylethyldiisopropoxysilane, β-(3,4-epoxycyclohexyl)ethylethyldiisopropoxysilane, β-(3,4-epoxycyclohexyl)propyltrimethoxysilane, γ-glycidoxyethyltrimethoxysilane, and the like.

To increase the crosslinking density and to improve the chemical resistance and insulation properties of the gate insulating layer, it is preferable to use, among the above mentioned silane compounds, one wherein n = 1, and 1 = 0, such as γ-glycidoxypropyltrimethoxysilane, β-(3,4-epoxycyclohexyl)ethyltrimethoxysilane, γ-glycidoxypropyltriethoxysilane, β-(3,4-epoxycyclohexyl)ethyltriethoxysilane, γ-glycidoxypropyltriisopropoxysilane, β-(3,4-epoxycyclohexyl)ethyltriisopropoxysilane, β-(3,4-epoxycyclohexyl)propyltrimethoxysilane, or γ-glycidoxyethyltrimethoxysilane. Further, from a mass production viewpoint, it is particularly preferable to use one wherein $R^{18}$ is a methyl group, such as γ-glycidoxypropyltrimethoxysilane, β-(3,4-epoxycyclohexyl)ethyltrimethoxysilane, β-(3,4-epoxycyclohexyl)propyltrimethoxysilane, or γ-glycidoxyethyltrimethoxysilane.

Preferably, the gate insulating layer further contains a metal compound containing a bond between a metal atom and an oxygen atom. Examples of such metal compounds include, without particular limitation, metal oxides, metal hydroxides, and the like. The metal atom to be contained in the metal compound is not limited to a particular one as long as it forms a metal chelate. Examples of metal atoms include magnesium, aluminum, titanium, chromium, manganese, cobalt, nickel, copper, zinc, gallium, zirconium, ruthenium, palladium, indium, hafnium, platinum, and the like. Among these, aluminum is preferred, from the viewpoint of ease of availability, cost, and the stability of the resulting

metal chelate.

In the gate insulating layer, the metal atom is preferably contained in an amount of from 10 to 180 parts by weight, with respect to 100 parts by weight of the total amount of carbon atoms and silicon atoms. This is because the insulation properties of the gate insulating layer can thus be more improved. The weight ratio of the amount of the metal atom with respect to 100 parts by weight of the total amount of carbon atoms and silicon atoms in the gate insulating layer can be measured by X-ray photoelectron spectroscopy (XPS).

The gate insulating layer preferably has a film thickness of from 0.05 to 5 μm, and more preferably from 0.1 to 1 μm. A film thickness within the above range facilitates the formation of a uniform thin film. The film thickness can be measured using an atomic force microscope or by an ellipsometric method.

The method of producing a gate insulating layer is not particularly limited, and examples thereof include a method in which a coating film obtained by coating a substrate with a composition containing a material for forming an insulating layer and by drying the composition is subjected to a heat-treatment, as necessary. Examples of coating methods include known coating methods such as a spin-coating method, a blade coating method, a slit die coating method, a screen printing method, a bar coater method, a casting method, a transfer printing method, an immersion and withdrawal method, an inkjet method, and the like. Temperatures at which coating films are heat-treated are preferably in the range of from 100 to 300°C.

Here, an insulating layer is formed, for example, by coating a substrate with a composition, drying, and heat-treating it, in which the composition contains (A) an aluminum chelate, (B) a polysiloxane having a weight average molecular weight of 1000 or more, and (C) a solvent, and the content of the (B) component is from 5 to 90 parts by weight with respect to 100 parts by weight of the (A) component. The insulating layer thus obtained generally contains an organic compound containing a bond between a silicon atom and a carbon atom and a compound containing a bond between an aluminum atom and an oxygen atom. The insulating layer contains aluminum atoms in an amount of from 10 to 180 parts by weight, with respect to 100 parts by weight of the total amount of carbon atoms and silicon atoms.

In this regard, the above-mentioned relationship between the composition and the content ratios of the atoms in the insulating layer is a rough tendency, and the above-mentioned relationship is not always satisfied, depending on, for example, the kind of the metal atom and the like.

The gate insulating layer may be a monolayer or multilayer. In addition, one layer may be composed of a plurality of insulating materials, or an insulating multilayer may be formed of a plurality of insulating materials that are layered one on another.

(CNT)

As a CNT, any of a single-walled CNT which is one carbon film (graphene sheet) rolled cylindrically, a double-walled CNT which is two graphene sheets rolled concentrically, and a multi-walled CNT which is a plurality of graphene sheets rolled concentrically may be used. A single-walled CNT is preferably used in order to obtain high semiconductor characteristics. CNTs can be obtained by an arc-discharge method, a chemical vapor deposition method (CVD method), a laser ablation method, and the like.

In addition, the CNTs more preferably contains 80 wt% or more semiconductor-type CNTs. The CNTs further preferably contains 90 wt% or more semiconductor-type CNTs, particularly preferably 95 wt% or more semiconductor-type CNTs. As methods of allowing CNTs to contain 80 wt% or more semiconductor-type CNTs, known methods can be used. Examples thereof include: a method in which ultracentrifugation is carried out in the coexistence of a density gradient agent; a method in which a particular compound is selectively attached to the surface of a semiconductor-type or metallic CNT and separation is carried out utilizing the difference in solubility; a method in which separation is carried out through electrophoresis and the like utilizing the difference in electrical properties; and the like. Examples of methods of measuring the semiconductor-type CNT content of CNTs include: a method in which calculation is carried out from the absorptive area ratio of visible and near-infrared absorption spectrum; a method in which calculation is carried out from the intensity ratio of raman spectrum; and the like.

In cases where CNTs are used for a semiconductor layer of a semiconductor device in the present invention, the length of the CNT is preferably shorter than the distance between the source electrode and the drain electrode (hereinafter referred to as an "interelectrode distance"). The average length of CNTs depends on the interelectrode distance, but is preferably 2 μm or less, more preferably 1 μm or less. Examples of methods of making CNTs shorter include an acid treatment, a freeze grinding treatment, and the like.

The average length of CNTs refers to the average value of the lengths of randomly picked up 20 CNTs. Examples of methods of measuring the average length of CNTs include a method in which 20 CNTs are randomly picked up from an image obtained using an atomic force microscope, a scanning electron microscope, a transmission electron microscope, or the like, and their lengths are averaged.

Commercially available CNTs have a length distribution, and in some cases, they include CNTs longer than an interelectrode distance. Because of this, it is preferable to add the step of making CNTs shorter than the interelectrode

distance. For example, a method in which CNTs are cut into the shape of short fibers through an acid treatment with nitric acid, sulfuric acid, or the like, an ultrasonic treatment, a freeze grinding method, or the like is effective. In addition, it is more preferable to also carry out a separation through a filter for improving the purity of CNTs.

In addition, the diameter of a CNT is, without particular limitation, preferably from 1 nm to 100 nm, more preferably 50 nm or less as the upper limit.

In the present invention, it is preferable to include the step of uniformly dispersing CNTs in a solvent and filtrating the dispersion through a filter. By obtaining CNTs smaller than the pore size of the filter from the filtrate, CNTs shorter than an interelectrode distance can be efficiently obtained. As the filter in this case, a membrane filter is preferably used. The pore size of the filter used for filtration should be smaller than an interelectrode distance, and is preferably from 0.5 to 10 μm.

(CNT Composite)

A CNT used in the present invention is preferably a CNT composite in which a conjugated polymer is attached to at least a part of the surface of a CNT. Here, a conjugated polymer refers to a compound whose repeating unit has a conjugate structure and whose polymerization degree is 2 or more.

By allowing a conjugated polymer to be attached on at least a part of the surface of a CNT, it becomes possible to uniformly disperse the CNTs in a solution, without deteriorating the high electrical properties of the CNT. A CNT film in which CNTs are uniformly dispersed can be formed by a coating method using a solution in which CNTs are uniformly dispersed. This allows the film to achieve high semiconductor characteristics.

The state where a conjugated polymer is attached to at least a part of the surface of a CNT, refers to a state in which a part of or the entire surface of the CNT is covered by the conjugated polymer. It is assumed that the conjugated polymer is able to cover the CNT, because π-electron clouds derived from the conjugated structures of the CNT and the polymer overlap with one another, to generate an interaction therebetween.

Whether the CNT is covered by a conjugated polymer or not can be determined by the reflected color of the CNT. The reflected color of a covered CNT is closer to the reflected color of the conjugated polymer, differently from the reflected color of an uncovered CNT. Quantitatively, an elemental analysis such as X-ray photoelectron spectroscopy (XPS) can be used to identify the presence of a substance attached to the CNT and to measure the weight ratio of the attached substance to the CNT.

In addition, the conjugated polymer preferably has a weight average molecular weight of 1000 or more for easier attachment to the CNT.

Examples of the method of allowing a conjugated polymer to be attached to the CNT include: (I) a method in which CNT is added to a melted conjugated polymer, followed by mixing; (II) a method in which a conjugated polymer is dissolved in a solvent, and CNT is added to the resulting solution, followed by mixing; (III) a method in which CNT is pre-dispersed in a solvent by ultrasonic waves or the like, and a conjugated polymer is added to the resulting dispersion, followed mixing: and (IV) a method in which a conjugated polymer and CNT are added to a solvent, and the resulting mixture system is irradiated by ultrasonic waves and mixed. In the present invention, any of these methods may be used singly, or a plurality of these methods may be used in combination.

Examples of the conjugated polymer include polythiophene-based polymers, polypyrrole-based polymers, polyaniline-based polymers, polyacetylene-based polymers, poly-p-phenylene-based polymers, and poly-p-phenylene vinylene-based polymers, but not particularly limited thereto. As the above described polymer, a polymer composed of one type of monomer units is preferably used. However, a polymer obtained by block copolymerization, random copolymerization, or graft polymerization of different types of monomer units is also preferably used.

Among the above-mentioned polymers, polythiophene-based polymers are preferably used in the present invention from the viewpoint that they are easily attached to CNTs and that they make it easier to form a CNT composite. Among the polythiophene-based polymers, those which contain, in the repeating units, a fused heteroaryl unit having a nitrogen-containing double bond in the ring and a thiophene unit are more preferable.

Examples of fused heteroaryl units having a nitrogen-containing double bond in the ring include units such as thienopyrrole, pyrrolochiazol, pyrrolopyridazine, benzimidazole, benzotriazole, benzoxazole, benzothiazol, benzothiadiazole, quinoline, quinoxaline, benzotriazine, thienoxazole, thienopyridine, thienothiazine, and thienopyrazine. Among these, particularly benzothiadiazole units or quinoxaline units are preferable. Having these units can increase the adhesion between CNTs and a conjugated polymer and disperse the CNTs in the semiconductor layer better.

Further, the conjugated polymer is particularly preferably one having a structure represented by the following general formula (11).

[Chem. 1]

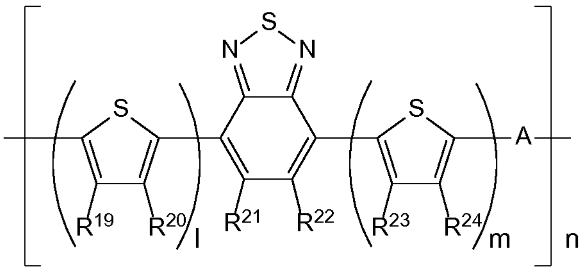

(11)

Here, $R^{19}$ to $R^{24}$ may be the same or different and each represent a hydrogen atom, alkyl, cycloalkyl, a heterocyclic group, alkenyl, cycloalkenyl, alkynyl, alkoxy, alkylthio, arylether, arylthioether, aryl, heteroaryl, halogen atom, cyano, formyl, carbamoyl, amino, alkylcarbonyl, arylcarbonyl, carboxyl, alkoxycarbonyl, aryloxycarbonyl, alkylcarbonyloxy, arylcarbonyloxy, or silyl. In addition, the adjacent groups among $R^{19}$ to $R^{24}$ may form a ring structure. A is selected from a single bond, an arylene group, a heteroarylene group other than a thienylene group, an ethenylene group, and an ethynylene group. 1 and m each represent an integer of 0 to 10, and $1 + m \geq 1$. n represents a range from 2 to 1000. When 1, m, and n are 2 or greater, $R^{19}$ to $R^{24}$ and A may be the same or different in each repeating unit.

The alkyl group represents, for example, a saturated aliphatic hydrocarbon group, such as a methyl group, an ethyl group, an n-propyl group, an isopropyl group, an n-butyl group, a sec-butyl group, or a tert-butyl group. The alkyl group may or may not contain a substituent. In cases where the alkyl group contains a substituent, the substituent is not particularly limited. Examples thereof include an alkoxy group, an aryl group, a heteroaryl group, and the like. The substituent may further contain a substituent. These descriptions of the substituents equally apply to the below-mentioned description, unless otherwise specified. The number of carbon atoms in the alkyl group is not particularly limited, but it is preferably from 1 to 20, and more preferably from 1 to 8, from the viewpoint of ease of availability and cost.

The cycloalkyl group represents, for example, an alkyl group containing a saturated alicyclic hydrocarbon group, examples of cycloalkyl groups including a cyclopropyl group, a cyclohexyl group, a norbornyl group, and an adamantyl group. The cycloalkyl group may or may not contain a substituent. The number of carbon atoms in the cycloalkyl group is not particularly limited, but it is preferably within the range of from 3 to 20.

The heterocyclic group represents a group derived from an aliphatic ring having an atom other than carbon in the ring, examples of aliphatic rings including a pyran ring, piperidine ring, amide ring, and the like. The heterocyclic group may or may not contain a substituent. The number of carbon atoms in the heterocyclic group is not particularly limited, but it is preferably within the range of from 2 to 20.

The alkenyl group represents an unsaturated aliphatic hydrocarbon group containing a double bond, examples of alkenyl groups including a vinyl group, aryl group, butadienyl group, and the like. The alkenyl group may or may not contain a substituent. The number of carbon atoms in the alkenyl group is not particularly limited, but it is preferably within the range of from 2 to 20.

The cycloalkenyl group represents, for example, an unsaturated alicyclic hydrocarbon group containing a double bond, examples of cycloalkenyl groups including a cyclopentenyl group, a cyclopentadienyl group, a cyclohexenyl group, and the like. The cycloalkenyl group may or may not contain a substituent. The number of carbon atoms in the cycloalkenyl group is not particularly limited, but it is preferably within the range of from 3 to 20.

The alkynyl group represents, for example, an unsaturated aliphatic hydrocarbon group containing a triple bond, examples of alkynyl groups including an ethynyl group. The alkynyl group may or may not contain a substituent. The number of carbon atoms in the alkynyl group is not particularly limited, but it is preferably within the range of from 2 to 20.

The alkoxy group represents, for example, a functional group in which one end of the ether bond is substituted by an aliphatic hydrocarbon group, examples of alkoxy groups including a methoxy group, an ethoxy group, a propoxy group, and the like. The alkoxy group may or may not contain a substituent. The number of carbon atoms in the alkoxy group is not particularly limited, but it is preferably within the range of from 1 to 20.

The alkylthio group represents a group in which the oxygen atom of the ether bond of an alkoxy group is substituted by a sulfur atom. The alkylthio group may or may not contain a substituent. The number of carbon atoms in the alkylthio group is not particularly limited, but it is preferably within the range of from 1 to 20.

The arylether group represents, for example, a functional group in which one end of the ether bond is substituted by an aromatic hydrocarbon group, examples of arylether groups including a phenoxy group, a naphthoxy group, and the like. The arylether group may or may not contain a substituent. The number of carbon atoms in the arylether group is not particularly limited, but it is preferably within the range of from 6 to 40.

The arylthioether group represents a group in which the oxygen atom of the ether bond of an arylether group

is substituted by a sulfur atom. The arylthioether group may or may not contain a substituent. The number of carbon atoms in the arylthioether group is not particularly limited, but it is preferably within the range of from 6 to 40.

The aryl group represents, for example, an aromatic hydrocarbon group, examples of aryl groups including a phenyl group, a naphthyl group, a biphenyl group, an anthracenyl group, a phenanthryl group, a terphenyl group, and a pyrenyl group. The aryl group may or may not contain a substituent. The number of carbon atoms in the aryl group is not particularly limited, but it is preferably within the range of from 6 to 40.

The heteroaryl group represents, for example, an aromatic group having one or more atoms other than a carbon atom in the ring, examples of heteroaryl groups including a furanyl group, a thiophenyl group, a benzofuranyl group, a dibenzofuranyl group, a pyridyl group, and a quinolinyl group. The heteroaryl group may or may not contain a substituent. The number of carbon atoms in the heteroaryl group is not particularly limited, but it is preferably within the range of from 2 to 30.

A halogen atom represents fluorine, chlorine, bromine, or iodine.

The alkylcarbonyl group represents a functional group in which one end of the carbonyl bond is substituted by an aliphatic hydrocarbon group, examples of alkylcarbonyl groups including an acetyl group, a hexanoyl group, and the like. The alkylcarbonyl group may or may not contain a substituent. The number of carbon atoms in the alkylcarbonyl group is not particularly limited, but it is preferably within the range of from 2 to 20.

The arylcarbonyl group represents, for example, a functional group in which one end of the carbonyl bond is substituted by an aromatic hydrocarbon group, examples of arylcarbonyl groups including a benzoyl group and the like. The arylcarbonyl group may or may not contain a substituent. The number of carbon atoms in the arylcarbonyl group is not particularly limited, but it is preferably within the range of from 7 to 40.

The alkoxycarbonyl group represents, for example, a functional group in which one end of the carbonyl bond is substituted by an alkoxy group, examples of alkoxycarbonyl groups including a methoxycarbonyl group and the like. The alkoxycarbonyl group may or may not contain a substituent. The number of carbon atoms in the alkoxycarbonyl group is not particularly limited, but it is preferably within the range of from 2 to 20.

The aryloxycarbonyl group represents, for example, a functional group in which one end of the carbonyl bond is substituted by an aryloxy group, examples of aryloxycarbonyl groups including a phenoxycarbonyl group and the like. The aryloxycarbonyl group may or may not contain a substituent. The number of carbon atoms in the aryloxycarbonyl group is not particularly limited, but it is preferably within the range of from 7 to 40.

The alkylcarbonyloxy group represents, for example, a functional group in which one end of the ether bond is substituted by an alkylcarbonyl group, examples of alkylcarbonyloxy groups including an acetoxy group and the like. The alkylcarbonyloxy group may or may not contain a substituent. The number of carbon atoms in the alkylcarbonyloxy group is not particularly limited, but it is preferably within the range of from 2 to 20.

The arylcarbonyloxy group represents, for example, a functional group in which one end of the ether bond is substituted by an arylcarbonyl group, examples of arylcarbonyloxy groups including a benzoyloxy group and the like. The arylcarbonyloxy group may or may not contain a substituent. The number of carbon atoms in the arylcarbonyloxy group is not particularly limited, but it is preferably within the range of from 7 to 40.

The carbamoyl group, amino group, and silyl group may or may not contain a substituent.

In cases where the adjacent groups are bound together to form a ring structure, $R^{19}$ and $R^{20}$ for example are bound together to form a conjugate or non-conjugated ring structure, according to the general formula (11). The ring structure may contain, as a constituent element, a nitrogen, oxygen, sulfur, phosphorus, or silicon atom besides carbon. Alternatively, the structure may be one in which the ring is further fused to another ring.

Next, A in the general formula (11) will be described. The arylene group represents a bivalent (two binding sites) aromatic hydrocarbon group and may be unsubstituted or substituted. In cases where it is substituted, examples of substituents include the above-mentioned alkyls, heteroaryls, and halogens. Preferable specific examples of arylene groups include phenylene, naphthylene, biphenylene, phenanthrylene, anthrylene, terphenylene, pyrenylene, fluorenylene, perylenylene, and the like.

The heteroarylene group represents a bivalent heteroaromatic ring group and may be unsubstituted or substituted. Preferable specific examples of heteroarylene groups include: pyridylene, pyrazylene, quinolinylene, isoquinolylene, quinoxalylene, acridinylene, indolylene, carbazolylene, and the like; in addition, bivalent groups derived from heteroaromatic rings such as benzofuran, dibenzofuran, benzothiophene, dibenzothiophene, benzodithiophene, benzosilol, and dibenzosilol; and the like.

In the general formula (11), 1 and m represent an integer of 0 to 10, and $1 + m \geq 1$. The structure of the general formula (11) containing a thiophene unit enhances the adhesion between the conjugated polymer and CNTs and enhances the dispersibility of the CNTs. Preferably, 1 and m are each 1 or more, more preferably satisfy $1 + m \geq 4$. In addition, $1 + m \leq 12$ is preferable from the viewpoint that the synthesis and subsequent polymerization of monomers are easy.

n represents the polymerization degree of a conjugated polymer and is in the range of from 2 to 1000. Considering the easier attachment to CNTs, n is preferably in the range of from 3 to 500. In the present invention, a polymerization

degree n is a value determined on the basis of the weight average molecular weight. Weight average molecular weights are determined through measurement using GPC (gel permeation chromatography) and conversion using a polystyrene standard sample.

Also for easier formation of CNT composites, the conjugated polymer is preferably soluble in a solvent. In the general formula (11), at least one of $R^{19}$ to $R^{24}$ is preferably an alkyl group.

Examples of conjugated polymers include those having the following structures.

[Chem. 2]

[1]

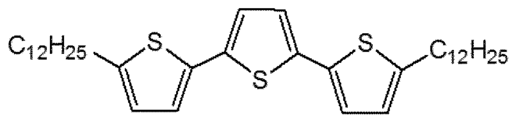

[2]

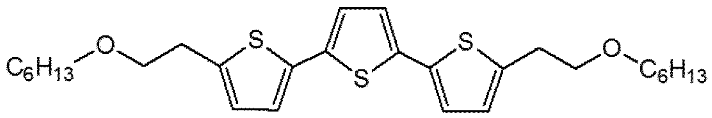

[3]

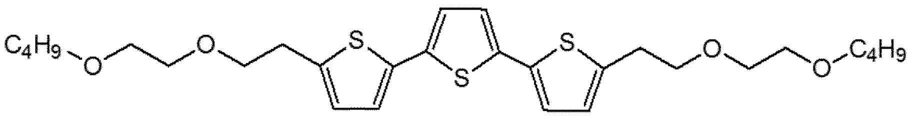

[4]

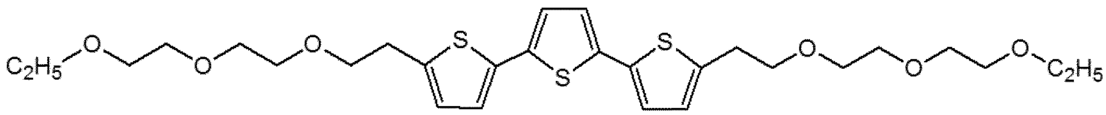

[5]

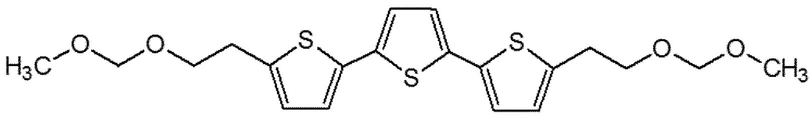

[6]

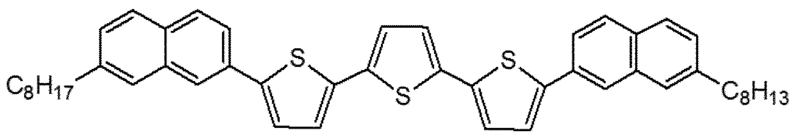

[7]

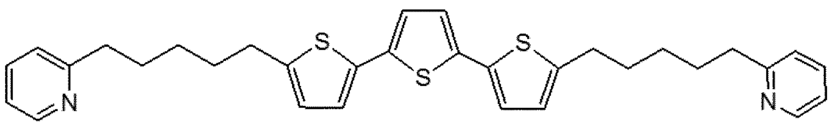

[8]

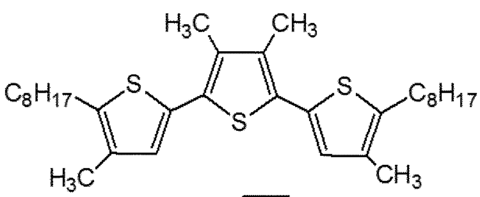

[9]

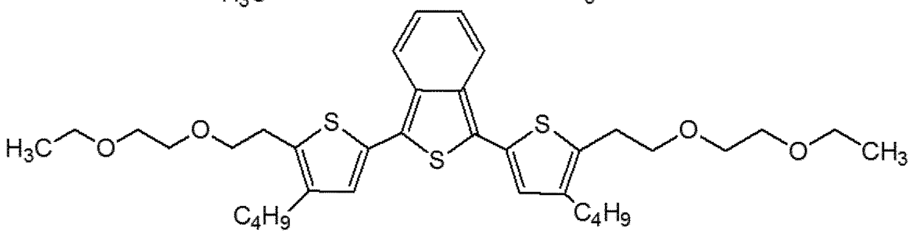

[Chem. 3]

[10]

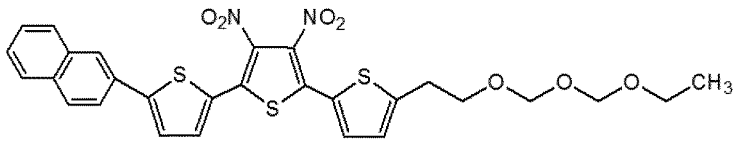

[11]

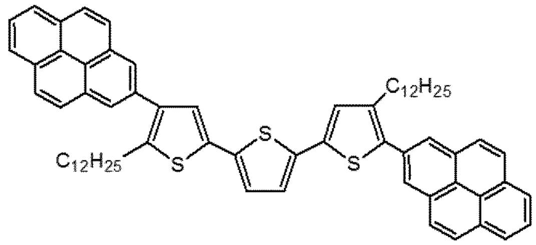

[12]

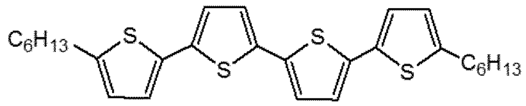

[13]

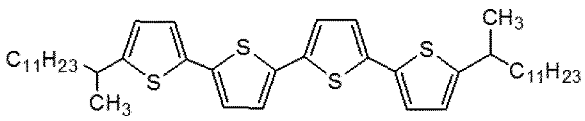

[14]

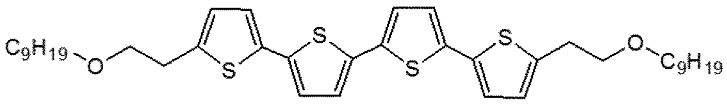

[15]

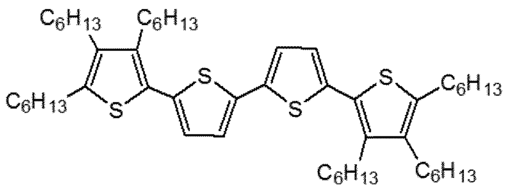

[16]

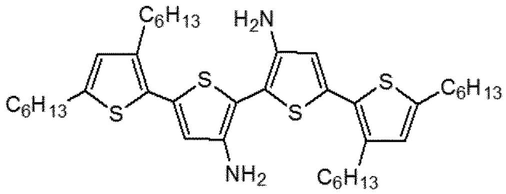

[17]

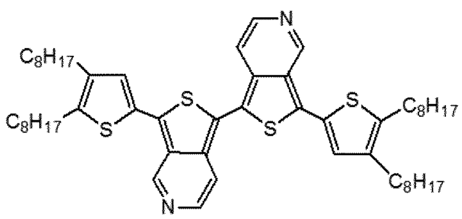

[Chem. 4]

[18]

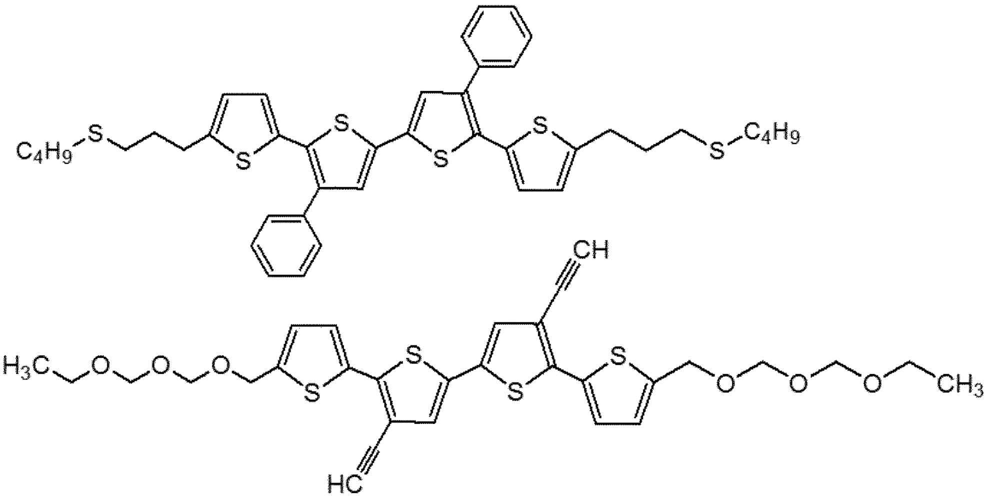

[19]

[20]

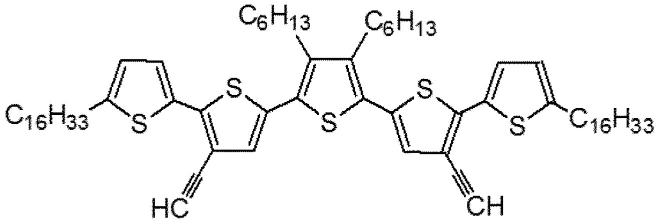

[21]

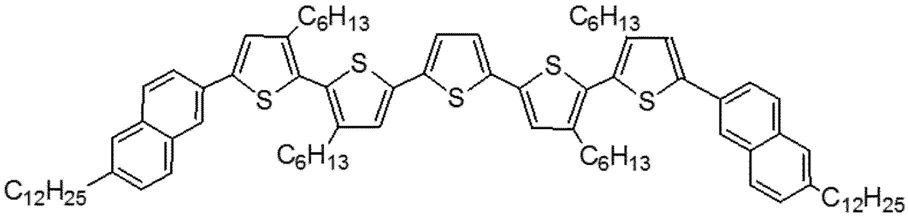

[22]

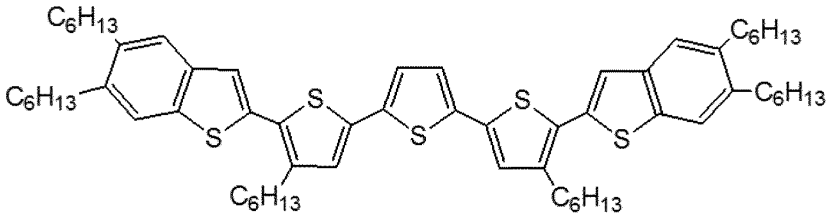

[23]

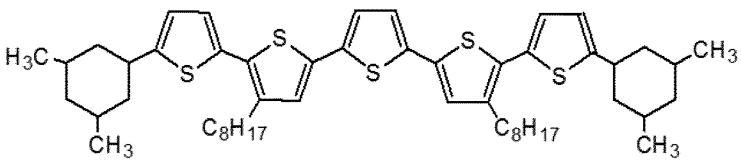

[24]

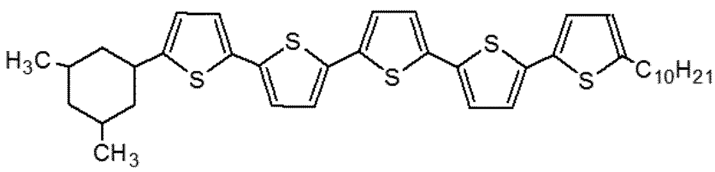

[Chem. 5]

[25]

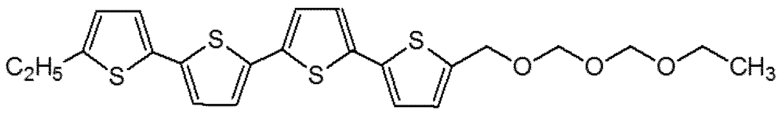

[26]

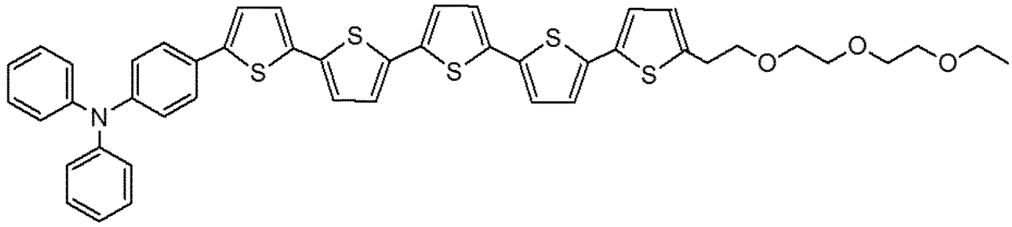

[27]

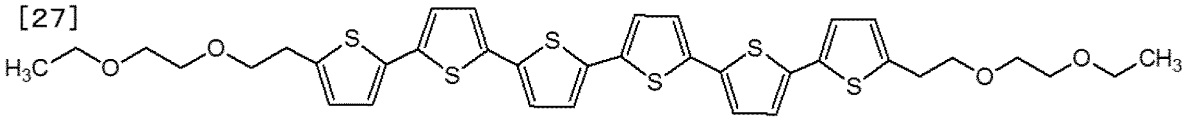

[28]

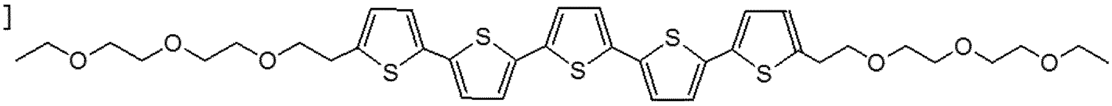

[29]

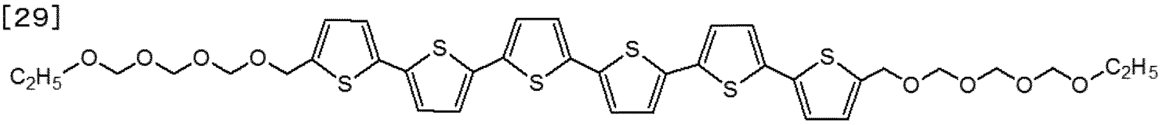

[30]

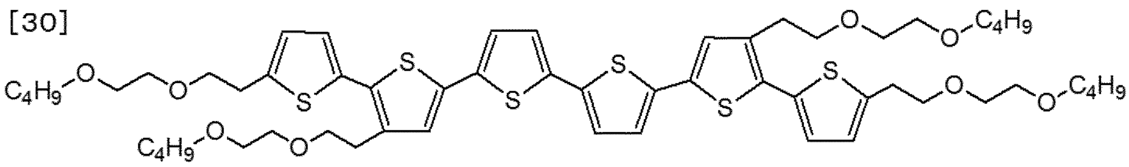

[31]

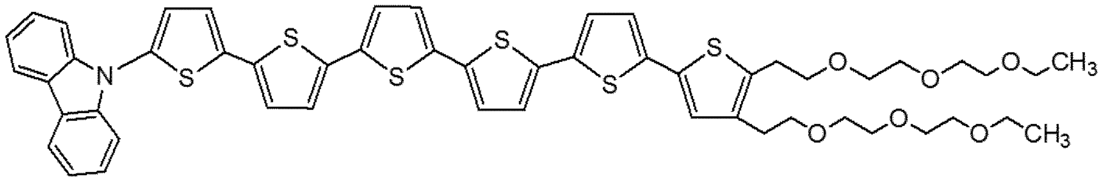

[32]

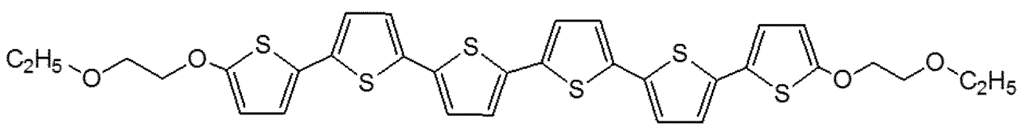

[Chem. 6]

[33]

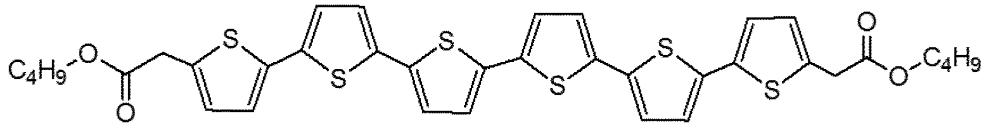

[34]

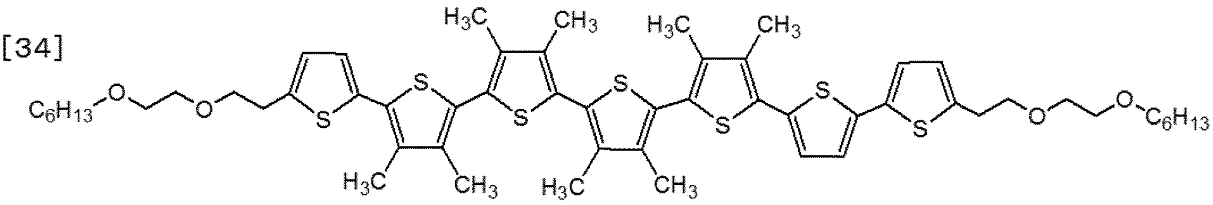

[35]

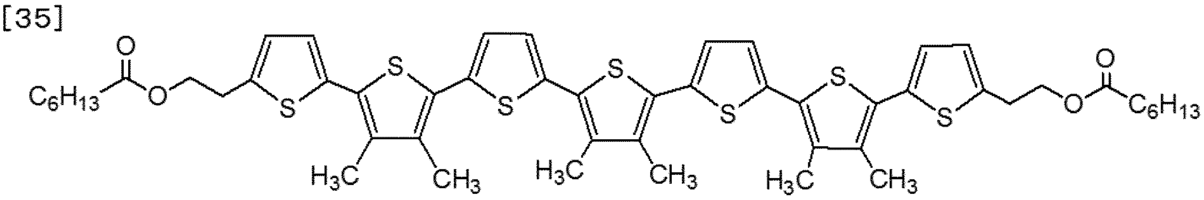

[36]

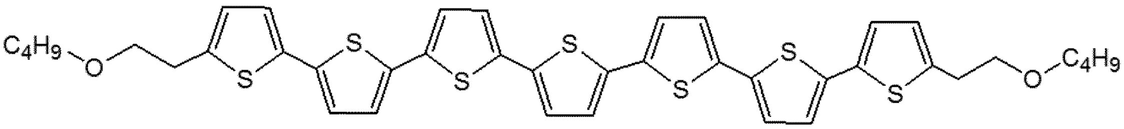

[37]

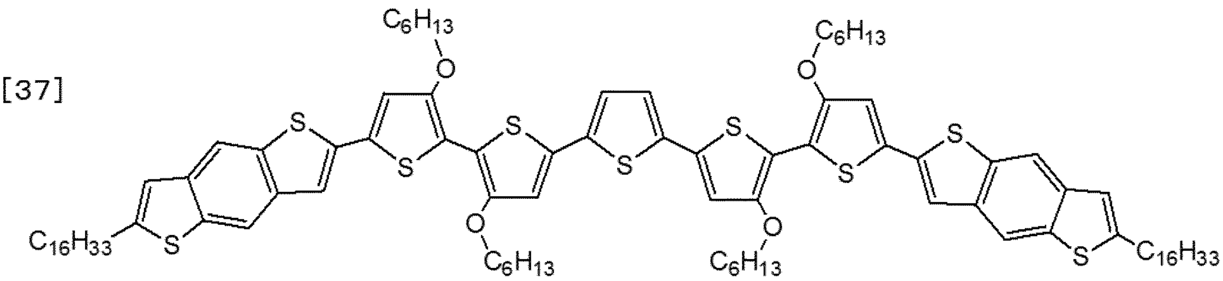

[38]

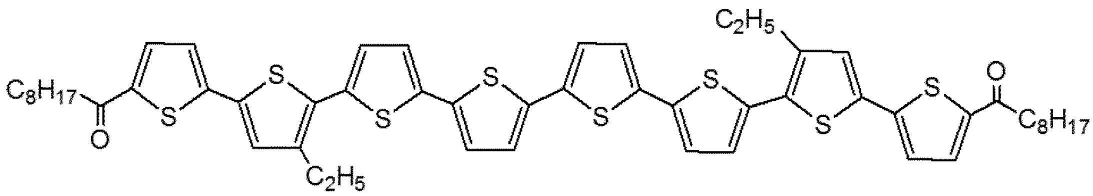

[39]

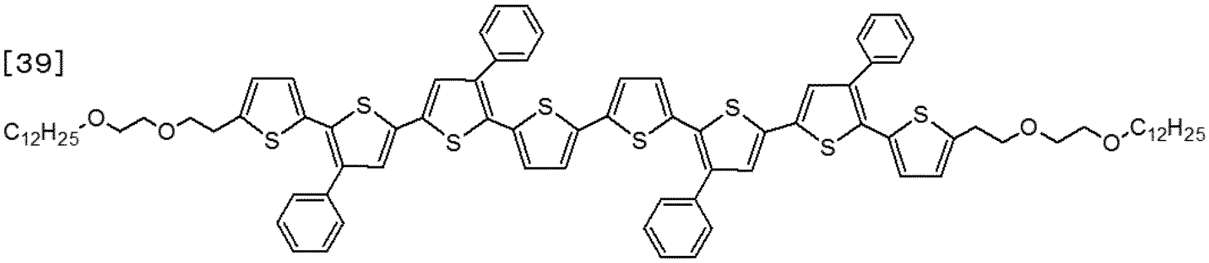

[Chem. 7]

[40]

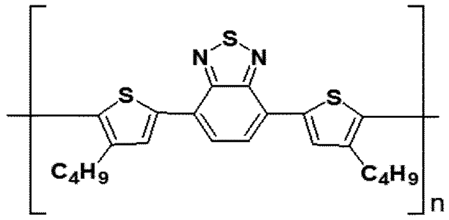

[41]

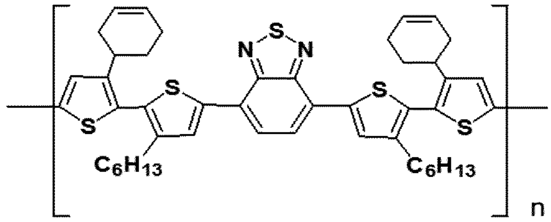

[42]

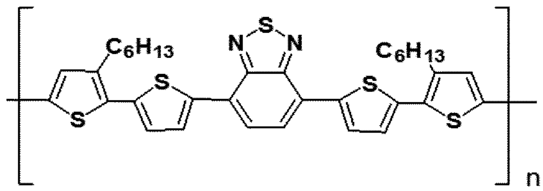

[43]

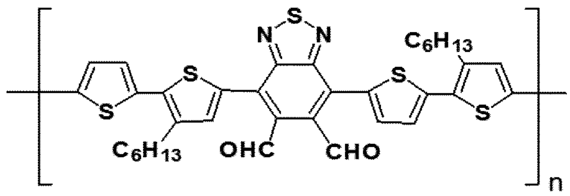

[44]

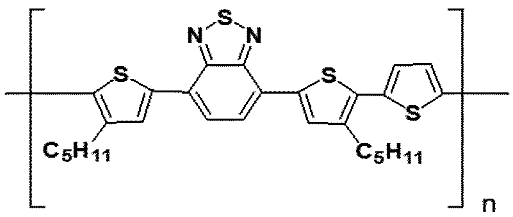

[45]

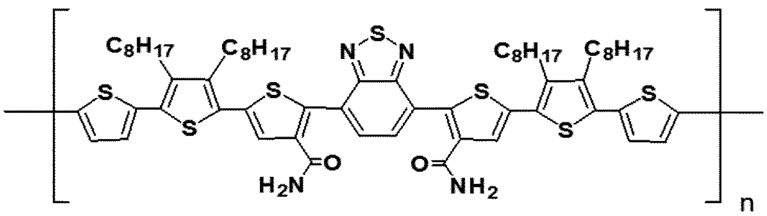

[Chem. 8]

[46]

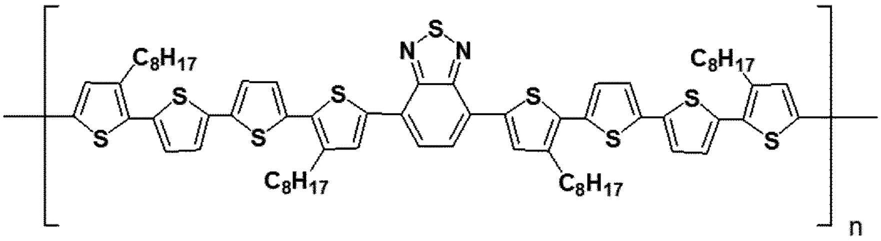

[47]

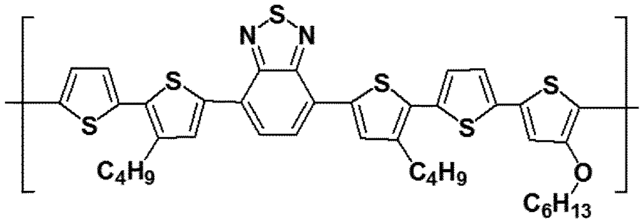

[48]

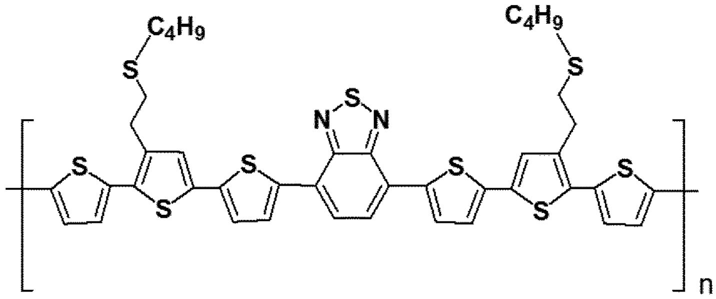

[49]

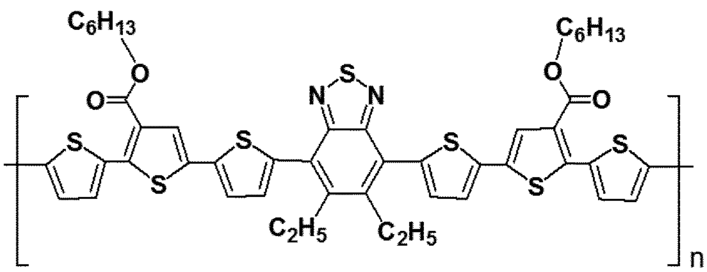

[50]

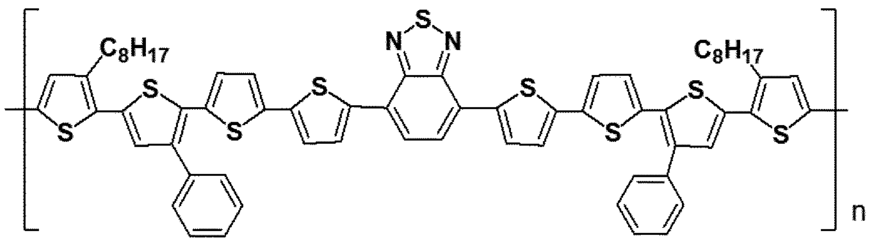

[Chem. 9]

[51]

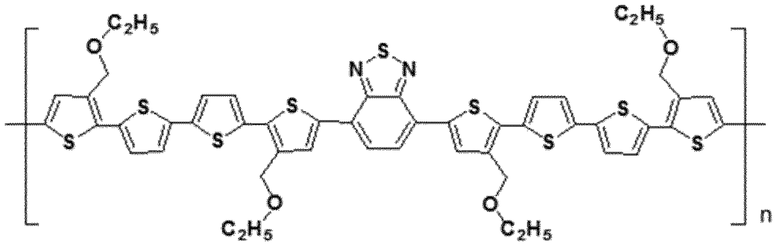

[52]

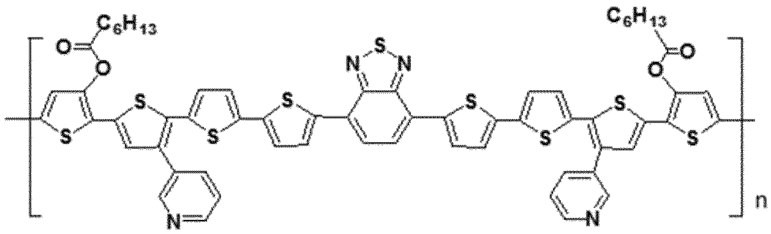

[53]

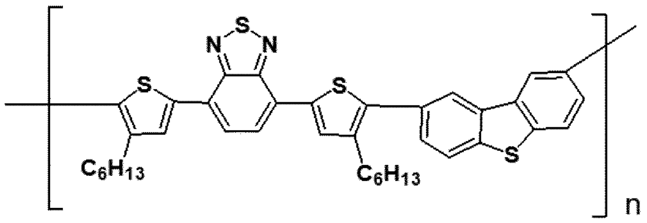

[54]

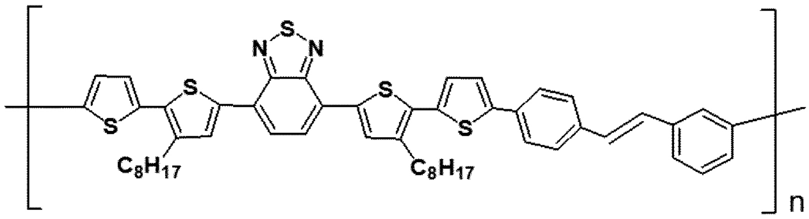

[55]

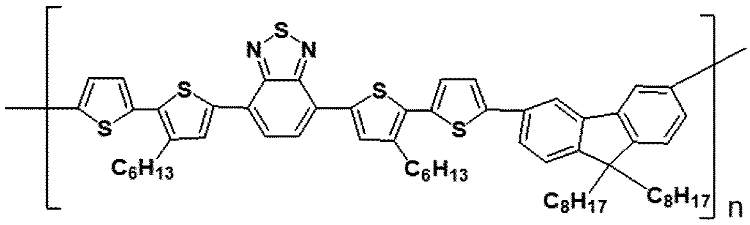

[56]

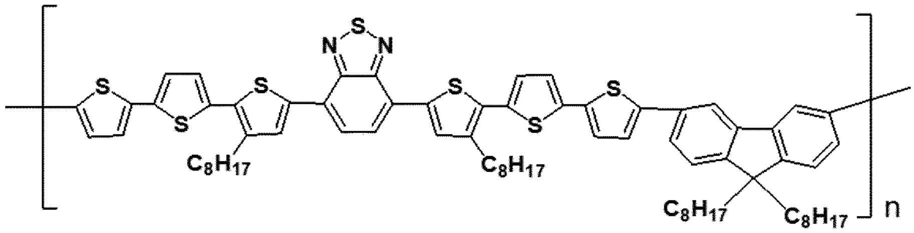

[Chem. 10]

[57]

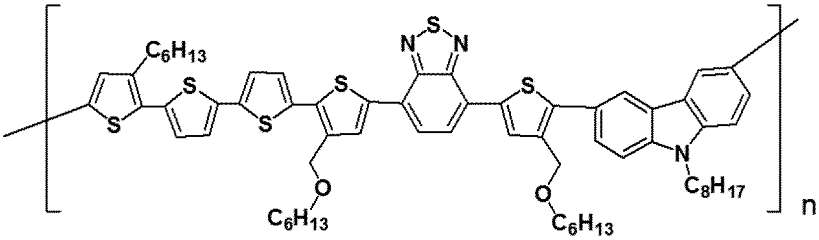

[58]

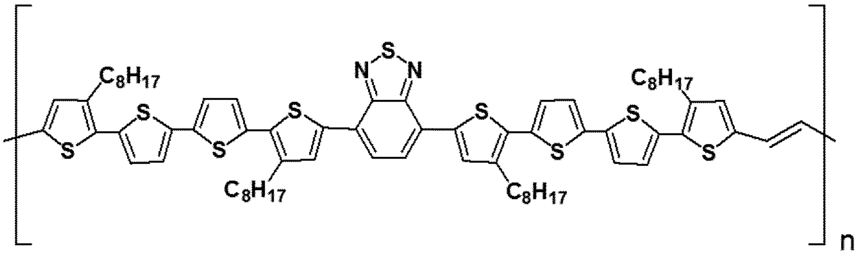

[59]

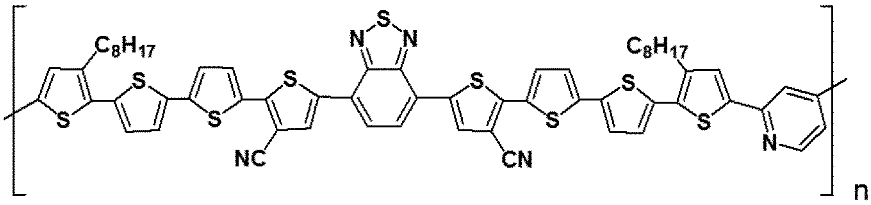

[60]

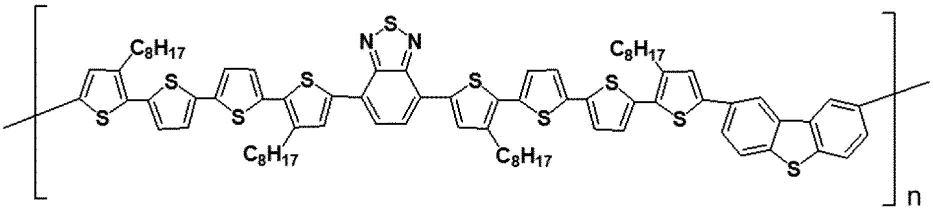

[61]

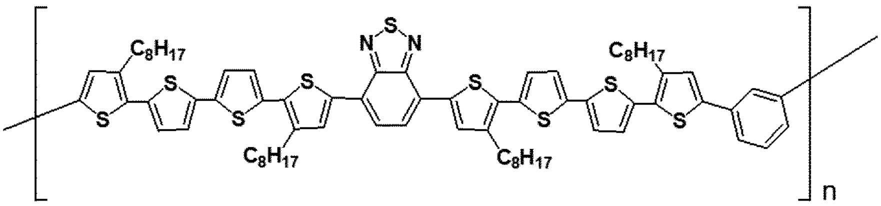

[Chem. 11]

[62]

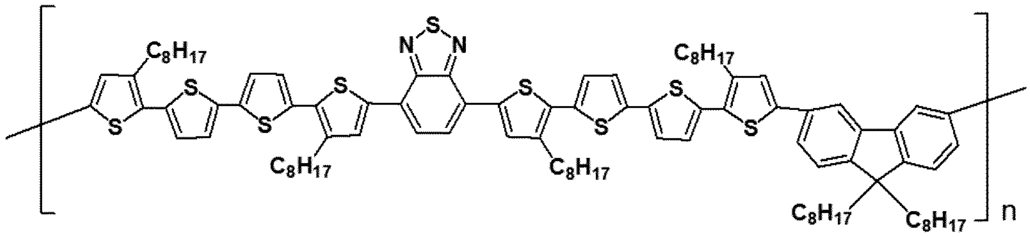

[63]

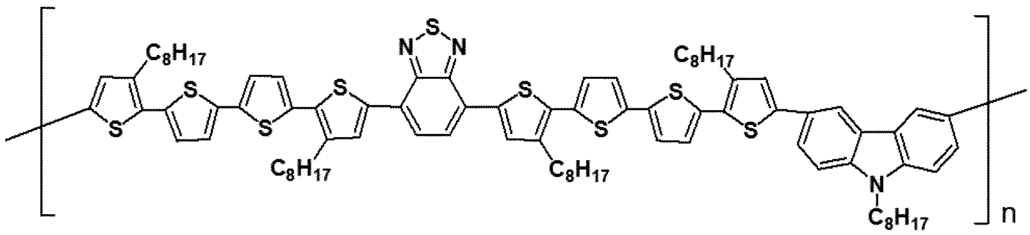

[64]

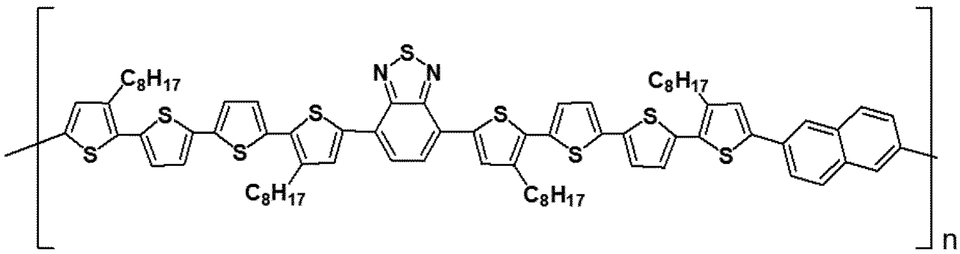

[65]

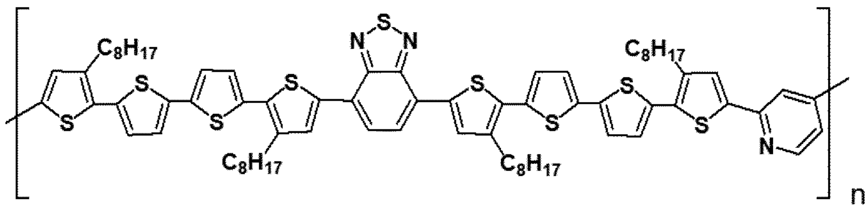

[66]

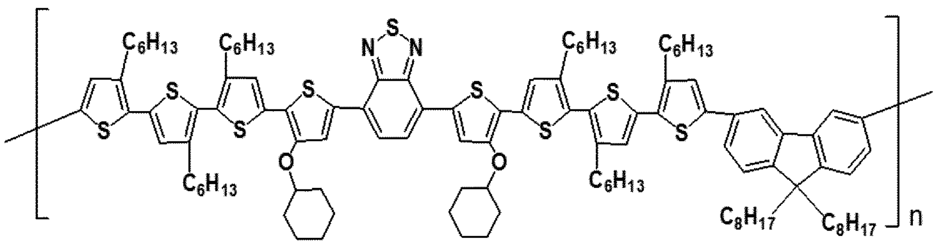

[Chem. 12]

[67]

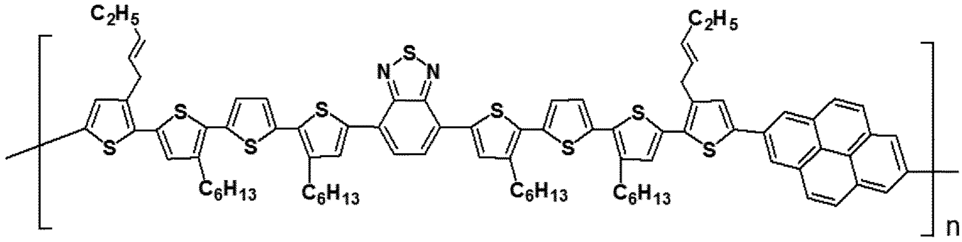

[68]

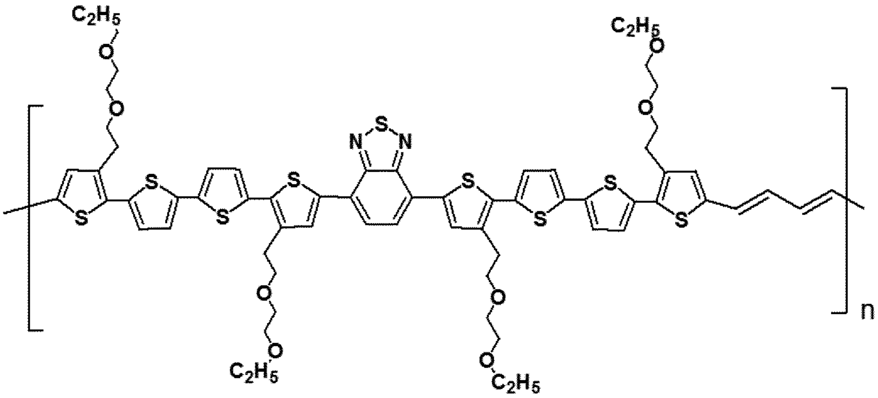

[69]

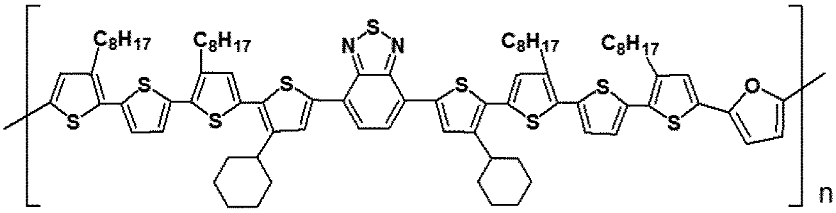

[70]

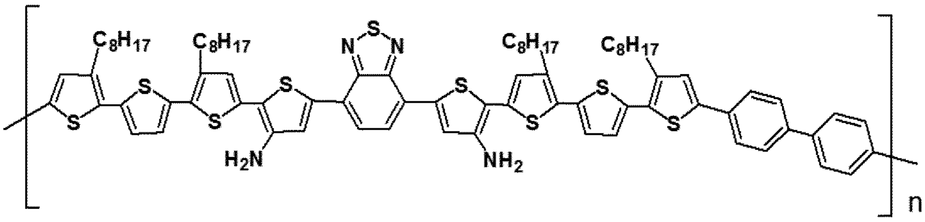

[71]

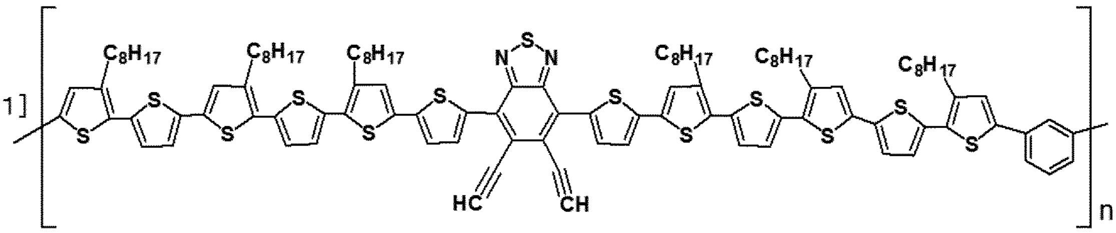

[Chem. 13]

[72]

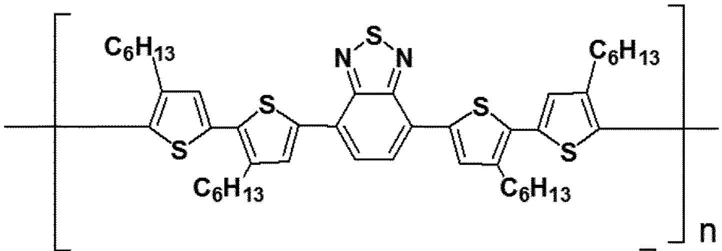

[73]

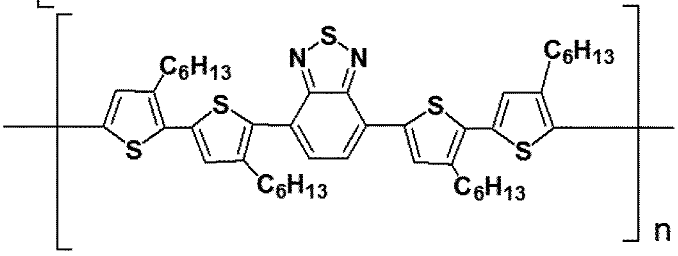

[74]

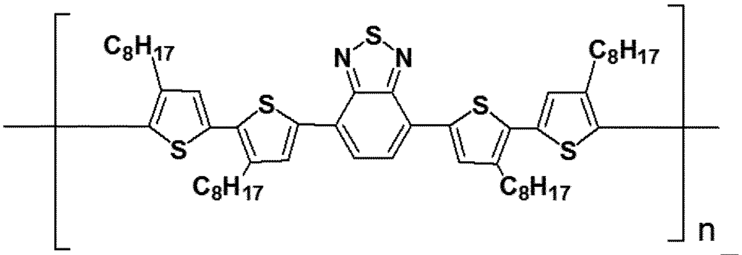

[75]

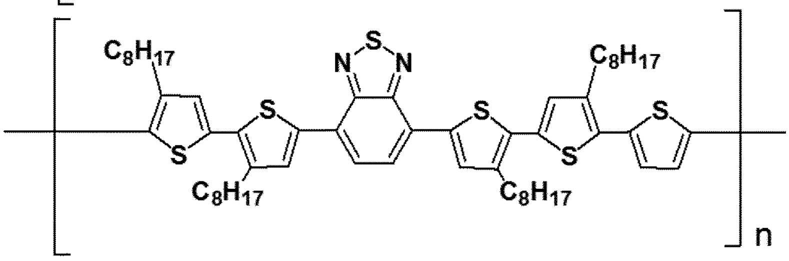

[76]

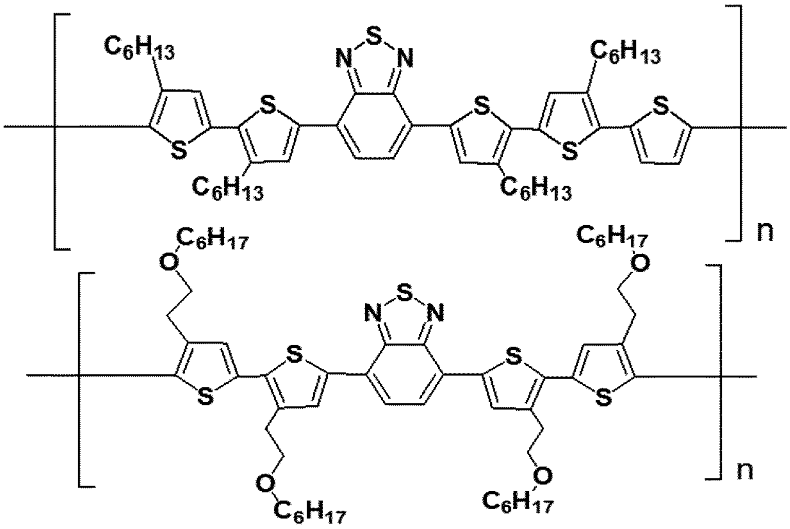

[77]

[Chem. 14]

[78] 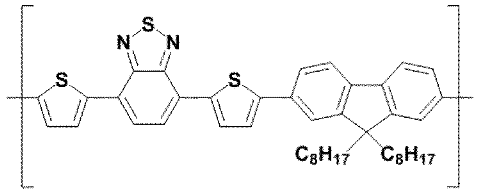

[79] 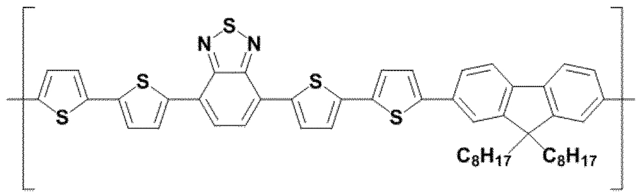

[80] 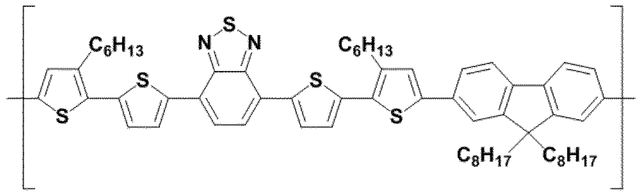

[81] 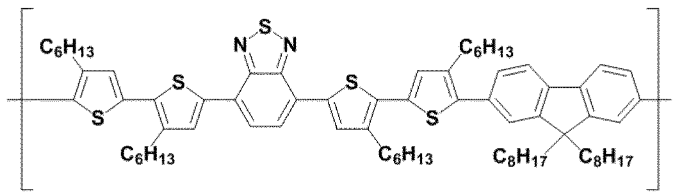

[82] 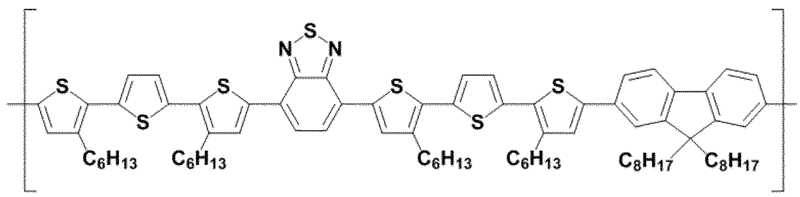

[83] 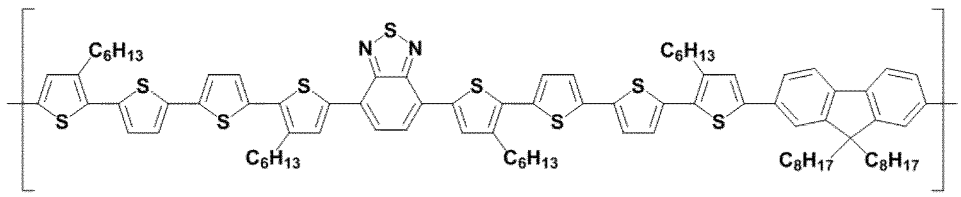

Here, each n has the above-mentioned meaning, that is, is in the range of from 2 to 1000, preferably in the range of from 3 to 500.

Conjugated polymers can be synthesized using known methods. Examples of methods of linking thiophenes to each other include: a method in which halogenated thiophene and thiopheneboronic acid or thiopheneboronate ester are coupled in the presence of a palladium catalyst; and a method in which halogenated thiophene and a thiophene Grignard reagent are coupled in the presence of a nickel or palladium catalyst. Also in cases where another unit and a thiophene unit are linked, another halogenated unit and a thiophene unit can be coupled in the same manner. In addition, conjugated polymers can be obtained by introducing a polymerizable functional group to the end of the thus obtained monomer and allowing the polymerization to progress in the presence of a palladium catalyst or a nickel catalyst.

Conjugated polymers from which impurities such as those from raw materials used in synthesis processes and

the by-products have been removed are preferably used. As a method of removing impurities, for example, a silica gel column graphy method, a Soxhlet's extraction method, a filtration method, an ion exchange method, a chelation method, and the like can be used. Two or more of these methods may be combined.

(Semiconductor Layer)

The semiconductor layer contains CNTs. In this case, the CNTs is preferably allowed to be present as a CNT composite. The semiconductor layer may further contain an organic semiconductor and an insulating material to the extent that its electrical characteristics are not impaired.

The semiconductor layer preferably has a film thickness of from 1 nm to 100 nm. A film thickness within this range facilitates the formation of a uniform thin film. The film thickness of the semiconductor layer is more preferably from 1 nm to 50 nm, and still more preferably from 1 nm to 20 nm. The film thickness can be measured using an atomic force microscope or by an ellipsometric method.

The semiconductor layer can be formed by a dry method such as resistance heating evaporation, electron beaming, sputtering, or CVD, but it is preferable to use a coating method, from the viewpoint of production cost and adaptability to a large area. Specific examples of preferred coating methods include a spin-coating method, a blade coating method, a slit die coating method, a screen printing method, a bar coater method, a casting method, a transfer printing method, an immersion and withdrawal method, an inkjet method, and the like. From among these, a coating method is preferably selected in accordance with the desired coating film properties, such as a method including thickness control, orientation control, or the like of the coating film. In addition, the formed coating film may be annealed in the atmosphere, under a reduced pressure, or in an atmosphere of an inert gas such as nitrogen or argon.

(Second Insulating Layer)

A second insulating layer is formed on the opposite side of the semiconductor layer from the gate insulating layer. The opposite side of the semiconductor layer from the gate insulating layer refers to, for example, the top side of the semiconductor layer in cases where the gate insulating layer is under the semiconductor layer. Forming the second insulating layer allows the semiconductor layer to be protected.

In the present invention, the second insulating layer refers to a layer formed on the opposite side of the semiconductor layer from the gate insulating layer, wherein the second insulating layer has i) a layer containing an electron-donating material having one or more selected from a nitrogen atom and a phosphorus atom and ii) a layer having a layer whose oxygen permeability is 4.0 cc/($m^2$·24h·atm) or less. Here, i) and ii) above may be combined into one layer having both characteristics. In addition, the second insulating layer is provided in contact with the semiconductor layer. The electron-donating properties refer to the capability of one compound to donate an electron to another compound. Electron-donating materials are compounds having the capability to donate an electron. Allowing the second insulating layer to contain such an electron-donating material enables a CNT-FET usually showing p-type semiconductor characteristics to be converted into a semiconductor device showing n-type semiconductor characteristics.

Examples of electron-donating materials include amidic compounds, imidic compounds, urea compounds, amine compounds, imine compounds, aniline compounds, nitrile compounds, alkylphosphine compounds, and the like.

Examples of amidic compounds include polyamides, formamides, acetamide, poly-N-vinylacetamide, N,N-dimethylformamide, acetanilide, benzanilide, N-methylbenzanilide, sulfonamide, nylons, polyvinylpyrrolidone, N-methylpyrrolidone, polyvinylpolypyrrolidone, β-lactam, γ-lactam, δ-lactam, ε-caprolactam, and the like.

Examples of imidic compounds include polyimide, phthalimide, maleimide, alloxan, succinimide, and the like.

Examples of urea compounds include uracil, thymine, urea, and acetohexamide.

Examples of amine compounds include methylamine, dimethylamine, trimethylamine, ethylamine, diethylamine, triethylamine, diisopropylethylamine, cyclohexylamine, methylcyclohexylamine, dimethylcyclohexylamine, dicyclohexylamine, dicyclohexylmethylamine, tricyclohexylamine, cyclooctylamine, cyclodecylamine, cyclododecylamine, 1-azabicyclo[2.2.2]octane(quinuclidine), 1,8-diazabicyclo[5.4.0]undeca-7-ene (DBU), 1,5-diazabicyclo[4.3.0]nona-5-ene (DBN), 1,5,7-triazabicyclo[4.4.0]deca-5-ene (TBD), 7-methyl-1,5,7-triazabicyclo[4.4.0]deca-5-ene (MTBD), poly(melamine-co-formaldehyde), tetramethylethylene diamine, diphenylamine, triphenylamine, phenylalanine, and the like.

Examples of imine compounds include ethyleneimine, N-methylhexane-1-imine, N-methyl-1-butyl-1-hexaneimine, propane-2-imine, methanediimine, N-methylethaneimine, ethane-1,2-diimine, and the like.

Examples of aniline compounds include aniline, methylaminobenzoic acid, and the like.

Examples of nitrile compounds include acetonitrile, acrylonitrile, and the like. Examples of other compounds include polyurethane, allantoin, 2-imidazolidinone, 1,3-dimethyl-2-imidazolidinone, dicyandiamidine, citrulline, piperidine, imidazole, pyrimidine, julolidine, poly(melamine-co-formaldehyde), and the like.

Examples of alkylphosphine compounds include tributylphosphine, tri-tert-butylphosphine, triphenylphosphine, and the like.

The electron-donating material is, among these, preferably a compound having a nitrogen atom, more preferably a compound containing a ring structure containing a nitrogen atom, from the viewpoint of the preservation stability of a semiconductor device and the easiness of adjustment of characteristics. Examples of compounds containing a ring structure containing a nitrogen atom include polyvinylpyrrolidone, N-methylpyrrolidone, polyvinylpolypyrrolidone, β-lactam, γ-lactam, δ-lactam, ε-caprolactam, polyimides, phthalimide, maleimide, alloxan, succinimide, uracil, thymine, 2-imidazolidinone, 1,3-dimethyl-2-imidazolidinone, quinuclidine, DBU, DBN, TBD, MTBD, piperidine, imidazole, pyrimidine, julolidine, and the like.

In addition, the electron-donating material is particularly preferably one or more compounds selected from amidine compounds and guanidine compounds. Examples of amidine compounds include DBU, DBN, and the like. Examples of guanidine compounds include TBD, MTBD, and the like. These compounds are preferable because they have particularly high electron-donating properties and accordingly, further enhance the performance of an n-type semiconductor device as an FET in which CNTs are used.

The second insulating layer has an oxygen permeability of 4.0 cc/($m^2$·24h·atm) or less. This enhances the stability of the semiconductor characteristics shown over time in the atmosphere. This is considered to be because oxygen in the atmosphere suppresses oxidization of CNTs and an electron-donating material. This effect is large in cases where the electron-donating material has a nitrogen atom, larger in cases where the electron-donating material is a compound containing a ring structure containing a nitrogen atom, even larger in cases where the electron-donating material is one or more compounds selected from amidine compounds and guanidine compounds. These materials have particularly excellent electron-donating properties, but are particularly more likely to be oxidized by oxygen in the atmosphere when in a semiconductor device. In cases where these compounds are used, allowing the second insulating layer to have an oxygen permeability of 4.0 cc/($m^2$·24h·atm) or less enables a semiconductor device to achieve enhanced preservation stability and in addition, to express excellent mobility as n-type semiconductor.

The oxygen permeability of the second insulating layer is more preferably 2.5 cc/($m^2$·24h·atm) or less, still more preferably 1.5 cc/($m^2$·24h·atm) or less. The lower limit is not limited to a particular value, and is preferably 0.001 cc/($m^2$·24h·atm) or more.

From the viewpoint of the performance stability of a semiconductor device, the second insulating layer preferably further contains a polymer compound having one or more structures selected from the group consisting of a hydroxy group, cyano group, fluoro group, chloro group, and amide bond. This is because these polymer compounds have high oxygen blocking properties, and in addition, enable a film to be formed by drying under moderate annealing conditions in a process of forming the second insulating layer by a coating method. The above-mentioned oxidization of CNTs and an electron-donating material by oxygen in the atmosphere is notable in cases where the annealing is carried out at high temperature. Accordingly, these polymer compounds that can be dried under more moderate annealing conditions are preferable.

Examples of polymer compounds having a hydroxy group include polyvinyl phenols, polyvinyl alcohols, ethylene-vinyl alcohol copolymers, vinyl acetate-vinyl alcohol copolymers, and the like.

Examples of polymer compounds having a cyano group include cyanoacrylate, polyacrylonitrile, polyallylcyanide, and the like.

Examples of polymer compounds having a fluoro group include polyvinyl fluoride, polyvinylidene fluoride, vinylidene fluoride-trifluoroethylene copolymers, and the like.

Examples of polymer compounds having a chloro group include polyvinyl chloride, polyvinylidene chloride, vinyl chloride-vinyl acetate copolymers, and the like.

Examples of polymer compounds having an amide bond include nylon 6, nylon 66, polyphenylene terephthalamide, and the like.

Among others, vinyl alcohol resins are particularly preferable from the viewpoint of the oxygen blocking properties in a thin film. Examples of vinyl alcohol resins include polyvinyl alcohols, ethylene-vinyl alcohol copolymers, and the like.

The second insulating layer preferably has a film thickness of 1.0 μm or more, more preferably 3.0 μm or more. Having a film thickness in this range can enhance the oxygen blocking properties of the second insulating layer. In addition, the upper limit of the film thickness of the second insulating layer is not limited to a particular value, and is preferably 1 mm or less, more preferably 100 μm or less. Having a film thickness in this range enables the second insulating layer to secure flexibility and accordingly, have good adhesion to the semiconductor layer even in bending. Because of this, it is possible to suppress, for example, an event in which an external force, such as bending, applied to a semiconductor device causes voids and/or cracks in the second insulating layer, and decreases the oxygen blocking properties.

The film thickness of the second insulating layer is determined as the arithmetic average of the values obtained by calculating the film thicknesses of ten positions randomly selected from the image of the second insulating layer portion positioned on the semiconductor layer, in which the image is obtained by measuring the cross-section of the second insulating layer using a scanning electron microscope.

The second insulating layer can be formed using a dry method, examples of which include, without particular limitation, resistance heating evaporation, electron beaming, sputtering, and CVD, but it is preferable to use a coating method, in terms of production cost and adaptability to a large area. The coating method includes at least the step of applying a composition in which a material for forming the second insulating layer is dissolved.

Specific examples of preferred coating methods include a spin-coating method, a blade coating method, a slit die coating method, a screen printing method, a bar coater method, a casting method, a transfer printing method, an immersion and withdrawal method, an inkjet method, and a drop casting method. From among these, a coating method is preferably selected in accordance with the desired coating film properties, such as a method including thickness control, orientation control, or the like of the coating film.

In cases where the second insulating layer is formed using a coating method, a solvent in which an insulating material used for the second insulating layer is dissolved is not limited to a particular one, and an organic solvent is preferable. Specific examples of solvents include: ethers such as ethylene glycol monomethyl ether, ethylene glycol monoethyl ether, propylene glycol monomethyl ether, propylene glycol monoethyl ether, propylene glycol mono-n-butyl ether, propylene glycol mono-t-butyl ether, ethylene glycol dimethyl ether, ethylene glycol diethyl ether, ethylene glycol dibutyl ether, diethylene glycol ethylmethyl ether, and the like; esters such as ethylene glycol monoethyl ether acetate, propylene glycol monomethyl ether acetate, propyl acetate, butyl acetate, isobutyl acetate, 3-methoxybutyl acetate, 3-methyl-3-methoxybutyl acetate, methyl lactate, ethyl lactate, butyl lactate, and the like; ketones such as acetone, methylethyl ketone, methylpropyl ketone, methylbutyl ketone, methylisobutyl ketone, cyclopentanone, 2-heptanone, and the like; alcohols such as butyl alcohols, isobutyl alcohols, pentanol, 4-methyl-2-pentanol, 3-methyl-2-butanol, 3-methyl-3-methoxy butanol, diacetone alcohols, and the like; aromatic hydrocarbons such as toluene, xylene, and the like.

As a solvent, two or more of these may be used. They preferably contain, among others, a solvent having a boiling point of from 110 to 200°C at 1 atm. A solvent having a boiling point of 110°C or more allows its volatilization to be suppressed when the solution is applied, and affords good coating properties. A solvent having a boiling point of 200°C or less allows a smaller amount thereof to remain in an insulating film and affords a second insulating layer having better heat resistance and chemical resistance.

In addition, the formed coating film may be annealed and/or dried by hot air in the atmosphere, under a reduced pressure, or in an atmosphere of an inert gas such as nitrogen or argon. Specifically, the annealing is carried out, for example, under the conditions: from 50 to 150°C, from three to 30 minutes, and a nitrogen atmosphere. Such a drying step enables an insufficiently dried coating film to be dried sufficiently.

The second insulating layer may be a monolayer or multilayer, and one layer may be formed out of a plurality of insulating materials, or a plurality of insulating materials may be formed into a multilayer. It is more preferable that the second insulating layer contains at least a first layer provided nearer to the semiconductor layer and a second layer provided farther from the semiconductor layer, that the first layer contains an electron-donating material, and that the second layer has an oxygen permeability of 4.0 cc/($m^2$·24h·atm) or less. The oxygen permeability of the second layer is more preferably 2.5 cc/($m^2$·24h·atm) or less, still more preferably 1.5 cc/($m^2$·24h·atm) or less.

In this constitution, the first layer has a function that converts a p-type semiconductor device into an n-type semiconductor device. In addition, the second layer has a function that enhances the stability shown over time in the atmosphere. Separating the functions in this manner makes it more likely to achieve the conversion of a p-type semiconductor device into an n-type semiconductor device and to enhance the stability shown over time in the atmosphere.

Fig. 3 is a schematic cross-sectional view depicting a third example of a semiconductor device according to an embodiment of the present invention. The semiconductor device has: an insulating substrate 1 on which a gate electrode 2 is formed; a gate insulating layer 3 covering the gate electrode; a source electrode 5 and a drain electrode 6 provided on the gate insulating layer; a semiconductor layer 4 provided between the electrodes; and a second insulating layer 8 covering the semiconductor layer. The second insulating layer 8 is composed of: a first layer 9 in contact with the semiconductor layer 4; and a second layer 10 covering the first layer 9. The semiconductor layer 4 contains a carbon nanotube 7.

Fig. 4 is a schematic cross-sectional view depicting a fourth example of a semiconductor device according to an embodiment of the present invention. The semiconductor device has: an insulating substrate 1 on which a gate electrode 2 is formed; a gate insulating layer 3 covering the gate electrode; a semiconductor layer 4 provided on the gate insulating layer; a source electrode 5 and a drain electrode 6 formed on the semiconductor layer; and a second insulating layer 8 provided on them. The second insulating layer 8 is composed of: a first layer 9 in contact with the semiconductor layer 4; and a second layer 10 covering the first layer 9. The semiconductor layer 4 contains a carbon nanotube 7.

The first layer may further contain a polymer compound such as an acrylic resin, methacryl resin, olefinic polymer, polystyrene, and polysiloxane.

Examples of materials used for the second layer include: inorganic compounds such as silicon oxide and silicon nitride; polymer compounds such as acrylic resins, methacryl resins, olefinic polymers, polystyrene, polysiloxane, and polyvinyl alcohols; and the like.

The second layer preferably contains a polymer compound having one or more structures selected from the group consisting of a hydroxy group, cyano group, fluoro group, chloro group, and amide bond. The reason why such polymer compounds are preferable and specific examples thereof are as above-mentioned, and among the polymer compounds, vinyl alcohol resins are particularly preferable.

In addition, the first layer and the second layer may each be one layer formed from a plurality of insulating materials. In addition, the second layer may be a monolayer or multilayer. In cases where the second layer is a multilayer, the above-mentioned materials are preferably used for each layer. In addition, the oxygen permeability of the second layer in this case refers to the oxygen permeability of the plurality of layers as a whole.

The absolute value of a difference in solubility parameter between the materials constituting the first layer and the second layer is preferably 5.0 $(MPa)^{1/2}$ or more, more preferably 6.0 $(MPa)^{1/2}$ or more, further preferably 8.0 $(MPa)^{1/2}$ or more. In addition, the upper limit of the value is not limited to a particular one, and is preferably 15.0 $(MPa)^{1/2}$ or less, more preferably 10.0 $(MPa)^{1/2}$ or less. This range makes it possible to suppress the mixing of the first layer and the second layer and to express the conversion into an n-type semiconductor device effectively even in cases where the film thickness of the first layer is small in the order of dozens of μm. This constitution is particularly preferable in cases where a semiconductor device is used in a complementary circuit. Examples of materials for the first layer include acrylic resins, methacryl resins, olefinic polymers, polystyrene, and the like, and examples of materials for the second layer include vinyl alcohol resins such as polyvinyl alcohols, ethylene-vinyl alcohol copolymers, and the like.

Here, a solubility parameter is a value calculated from the kinds and ratios of the materials constituting the layer, using the generally used estimation technique of Fedors described in Poly. Eng. Sci., vol. 14, No.2, pp 147-154 (1974) and the like. For example, the solubility parameter of polymethyl methacrylate can be calculated at 19.4 $(MPa)^{0.5}$, and the solubility parameter of polyvinyl alcohol can be calculated at 28.8 $(MPa)^{0.5}$.

In cases where the layer is composed of a mixture of a plurality of materials, the solubility parameter is calculated by taking the sum of the values obtained by multiplying the solubility parameters of the constituent materials by the respective mole fractions. For example, in cases where the layer is composed of a component A and a component B, the solubility parameter is calculated by the following equation:

$$\text{(Solubility Parameter of Layer)} = \text{(Solubility Parameter of Component A)} \times \text{(Mole Fraction of Component A)} + \text{(Solubility Parameter of Component B)} \times \text{(Mole Fraction of Component B)}$$

For example, in cases where the layer contains polymethyl methacrylate (having a solubility parameter of 19.4 $(MPa)^{0.5}$) at 97 wt% (the mole fraction: 97.8%) and diazabicycloundecene (having a solubility parameter of 20.3 $(MPa)^{0.5}$) at 3 wt% (the mole fraction: 2.2%), the solubility parameter of the layer is 19.4 $(MPa)^{0.5}$.

The first layer preferably has a film thickness of 50 nm or more, more preferably 100 nm or more. In addition, the film thickness of the first layer is preferably 10 μm or less, more preferably 3.0 μm or less. A film thickness within the above range facilitates the formation of a uniform thin film.

The second layer preferably has a film thickness of 1.0 μm or more, more preferably 3.0 μm or more. Having a film thickness in this range can enhance the oxygen blocking properties. In addition, the upper limit of the film thickness of the first layer is not limited to a particular value, and is preferably 1 mm or less, more preferably 100 μm or less. Having a film thickness in this range enables the second insulating layer to secure flexibility and accordingly, have good adhesion to the semiconductor layer even in bending. Because of this, it is possible to suppress, for example, an event in which an external force, such as bending, applied to a semiconductor device causes voids and/or cracks in the second insulating layer, and decreases the oxygen blocking properties.

In cases where the second insulating layer contains a first layer and a second layer, a method of forming each layer is as above-mentioned with reference to the method of forming the second insulating layer, and is not limited to a particular one, and each layer is preferably formed by a coating method. In this case, the first layer is first formed by a coating method, and then, the second layer is formed. In view of this, the drying temperature at which the second layer is formed is preferably equal to or lower than the glass transition temperature of the first layer. Using this condition can suppress the mixing of the first layer and the second layer. Also in cases where the film thickness of the first layer is small in the order dozens of μm, it is possible to effectively express the conversion of a p-type semiconductor device into an n-type semiconductor device and the function that controls the characteristics such as a threshold voltage. The condition that the drying temperature of the second layer is equal to or lower than the glass transition temperature of the first layer is preferable particularly in cases where such a method of forming the second insulating layer is used to produce a complementary circuit.

The second insulating layer preferably has a water vapor permeability of 20 $g/(m^2 \cdot 24h)$ or less. This further

enhances the stability of the semiconductor characteristics shown over time in the atmosphere. This is considered to be because a change caused to the semiconductor device characteristics by a change in humidity is suppressed. The water vapor permeability of the second insulating layer is more preferably 10 g/($m^2$·24h) or less, still more preferably 1 g/($m^2$·24h) or less. The lower limit is not limited to a particular value, and is usually 0.001 g/($m^2$·24h) or more from a practical viewpoint.

(Protective Layer)

The constitution of a semiconductor device preferably includes a protective layer preferably in contact with the second insulating layer on the opposite side of the second insulating layer from the gate electrode. Here, the protective layer has a water vapor permeability of 20 g/($m^2$·24h) or less. The protective layer preferably has a water vapor permeability of 5 g/($m^2$·24h) or less. In this constitution, the second insulating layer has a function that converts a p-type semiconductor device into an n-type semiconductor device and an oxygen blocking function, and the protective layer has a humidity blocking function. That is, the protective layer is a layer that has an oxygen permeability of more than 4.0 cc/($m^2$·24h·atm). Separating the functions in this manner makes it more likely to achieve the conversion of a p-type semiconductor device into an n-type semiconductor device and to enhance the stability shown over time in the atmosphere, compared with the above-mentioned constitution in which the second insulating layer has water vapor blocking properties. The water vapor permeability of the protective layer is more preferably 10 g/($m^2$·24h) or less, still more preferably 1 g/($m^2$·24h) or less. The lower limit is not limited to a particular value, and is preferably 0.001 g/($m^2$·24h) or more.

Fig. 12 is a schematic cross-sectional view depicting an example of a semiconductor device according to an embodiment of the present invention, in which a protective layer is provided. The semiconductor device has: an insulating substrate 1 on which a gate electrode 2 is formed; a gate insulating layer 3 covering the gate electrode; a source electrode 5 and a drain electrode 6 provided on the gate insulating layer; a semiconductor layer 4 provided between the electrodes; a second insulating layer 8 covering the semiconductor layer; and a protective layer 14 covering the second insulating layer 8. The second insulating layer 8 is composed of: a first layer 9 in contact with the semiconductor layer 4; and a second layer 10 covering the first layer 9. The semiconductor layer 4 contains a carbon nanotube 7.

The protective layer preferably contains one or more selected from fluorine resins, chlorine resins, nitrile resins, polyesters, and polyolefins. These polymers have low water vapor permeability, and in addition, enable a film to be formed by drying under moderate annealing conditions in a process of forming a barrier layer by a coating method.

Fluorine resins are polymers containing a fluorine atom, and examples of fluorine resins include polyvinyl fluoride, polyvinylidene fluoride, polytetrafluoroethylene, polychlorotrifluoroethylene, vinylidene fluoride-trifluoroethylene copolymers, and the like.

Chlorine resins are polymers containing a chlorine atom, and examples of chlorine resins include polyvinyl chloride, polyvinylidene chloride, vinyl chloride-vinyl acetate copolymers, and the like.

Nitrile resins are polymers containing a nitrile group, and examples of nitrile resins include polyacrylonitrile, polyallyl cyanide, and the like.

Examples of polyesters include polyethylene terephthalate and the like.

Examples of polyolefins include polyethylene, polypropylene, polybutadiene, polystyrene, cycloolefin polymers, and the like.

From the viewpoint of water vapor permeation, fluorine resins, chlorine resins, and polyolefinic resins are more preferable, and among others, polytetrafluoroethylene, polychlorotrifluoroethylene, polyvinylidene chloride, and cycloolefin polymers are preferable.

The above-mentioned water vapor permeability is determined on the basis of JIS K 7129 2008 (Plastics - Film and sheeting - Determination of water vapor transmission rate).

In a semiconductor device according to an embodiment of the present invention, the electric current flowing between the source electrode and the drain electrode (source-drain current) can be controlled by varying the gate voltage. The mobility, μ($cm^2$/V·s), in the semiconductor device can be calculated using the following equation (a).

$$\mu = (\delta Id / \delta Vg) L \cdot D / (W \cdot \varepsilon r \cdot \varepsilon \cdot Vsd) \times 10000 \qquad (a)$$

wherein Id is a source-drain current (A); Vsd is a source-drain voltage (V); Vg is a gate voltage (V); D is a gate insulating layer thickness (m); L is a channel length (m); W is a channel width (m); εr is a relative permittivity of the gate insulating layer; ε is permittivity of vacuum ($8.85 \times 10^{-12}$ F/m); and δ represents the quantity of change in the applicable physical quantity.

In addition, a threshold voltage can be determined from the intersection between the extension of a linear

portion and the Vg axis in an Id-Vg graph.

N-type semiconductor devices are operated by the source-drain conduction which is effected by applying a positive voltage equal to or greater than the threshold voltage to the gate electrode. An n-type semiconductor device having a high function and good characteristics has a low threshold voltage in absolute value and high mobility.

P-type semiconductor devices are operated by the source-drain conduction which is effected by applying a negative voltage equal to or smaller than the threshold voltage to the gate electrode. A p-type semiconductor device having a high function and good characteristics has a low threshold voltage in absolute value and high mobility.

(Method of Producing Semiconductor Device)

A method of producing a semiconductor device according to an embodiment of the present invention is not limited to a particular one, and preferably includes a step in which a semiconductor layer is formed by a coating method. Forming a semiconductor layer by a coating method includes at least: the step of applying a solution in which a material for forming the semiconductor layer is dissolved; and the step of drying the coating film. In addition, forming the second insulating layer, the first layer, and the second layer preferably includes a step in which the composition is applied and dried as above-mentioned. Below, a method of producing a semiconductor device according to an embodiment of the present invention will be described specifically, taking, as an example, a case where a semiconductor device having a structure shown in Fig. 3 is produced.

First, as shown in Fig. 5(a), a gate electrode 2 is formed on an insulating substrate 1 by the above-mentioned method.

Next, as shown in Fig. 5 (b), a solution containing an organic compound containing a bond between a silicon atom and a carbon atom is applied and dried to form a gate insulating layer 3.

Next, as shown in Fig. 5 (c), a source electrode 5 and a drain electrode 6 are simultaneously formed using the same material on top of the gate insulating layer 3 by the above-mentioned method.

Next, as shown in Fig. 5 (d), a semiconductor layer 4 is formed between the source electrode 5 and the drain electrode 6 by the above-mentioned method.

Next, as shown in Fig. 5 (e), a first layer is formed by the above-mentioned method so as to cover the semiconductor layer 4, and then, as shown in Fig. 5 (f), a second layer is formed by the above-mentioned method so as to cover the first layer. Forming the second insulating layer in this manner allows a semiconductor device to be produced.

<Complementary Semiconductor Device>

A complementary semiconductor device according to an embodiment of the present invention includes: an n-type semiconductor device containing the above-mentioned semiconductor device; and a p-type semiconductor device. The p-type semiconductor device includes a substrate; a source electrode, a drain electrode, and a gate electrode; a semiconductor layer in contact with the source electrode and the drain electrode; a gate insulating layer insulating the semiconductor layer from the gate insulating layer; in which the semiconductor layer preferably contains a CNT. In addition, the CNT is more preferably used as a CNT composite in which a conjugated polymer is attached to at least a part of the surface of the CNT.

Fig. 6 is a schematic cross-sectional view depicting a first example of a complementary semiconductor device according to an embodiment of the present invention.

A p-type semiconductor device 101 and an n-type semiconductor device 201 containing a semiconductor device according to the present invention are formed on the surface of an insulating substrate 1. The p-type semiconductor device has a gate electrode 2 formed on the insulating substrate 1, a gate insulating layer 3 covering the gate electrode, a source electrode 5 and a drain electrode 6 provided on the gate insulating layer, and a semiconductor layer 4 provided between the electrodes. Each semiconductor layer 4 contains a carbon nanotube 7.

In the same manner as the n-type semiconductor device according to an embodiment of the present invention, the p-type semiconductor device preferably has a second insulating layer in contact with the semiconductor layer of the p-type semiconductor device on the opposite side of the semiconductor layer from the gate insulating layer. Forming the second insulating layer makes it possible to adjust the semiconductor characteristics of a p-type semiconductor device, such as mobility and a threshold voltage. In addition, forming the second insulating layer enables the semiconductor layer to be protected from an external environment such as oxygen or moisture.

It is preferable that the second insulating layer of the p-type semiconductor device contains at least a first layer provided nearer to the semiconductor layer and a second layer provided farther from the semiconductor layer. In this constitution, for example, the first layer has a function that controls the characteristics of the p-type semiconductor device, such as a threshold voltage. In addition, the second layer has a function that enhances the stability shown over time in the atmosphere. Separating the functions in this manner makes it more likely to control the characteristics such as a threshold voltage and to enhance the stability shown over time in the atmosphere.

Fig. 7 is a schematic cross-sectional view depicting a second example of a complementary semiconductor device according to an embodiment of the present invention. A p-type semiconductor device 101 and an n-type semiconductor device 201 are formed on the surface of an insulating substrate 1. The n-type semiconductor device 201 contains the above-mentioned semiconductor device according to an embodiment of the present invention. The p-type semiconductor device 101 has: an insulating substrate 1 on which a gate electrode 2 is formed; a gate insulating layer 3 covering the gate electrode; a source electrode 5 and a drain electrode 6 provided on the gate insulating layer; a semiconductor layer 4 provided between the electrodes; and a second insulating layer 11 covering the semiconductor layer.

Fig. 8 is a schematic cross-sectional view depicting a third example of a complementary semiconductor device according to an embodiment of the present invention. A p-type semiconductor device 101 and an n-type semiconductor device 201 are formed on the surface of an insulating substrate 1. The n-type semiconductor device 201 contains the above-mentioned semiconductor device according to an embodiment of the present invention. The p-type semiconductor device 101 has: an insulating substrate 1 on which a gate electrode 2 is formed; a gate insulating layer 3 covering the gate electrode; a source electrode 5 and a drain electrode 6 provided on the gate insulating layer; a semiconductor layer 4 provided between the electrodes; and a third insulating layer 11 covering the semiconductor layer. The third insulating layer 11 is composed of: a first layer 12 in contact with the semiconductor layer 4; and a second layer 13 covering the first layer 12.

For a complementary semiconductor device according to an embodiment of the present invention, it is preferable that the source electrode and drain electrode of the p-type semiconductor device and the source electrode and the drain electrode of an n-type semiconductor device are all constituted by the same material. The reason is that this requires fewer kinds of materials used and enables these electrodes to be produced in the same step.

That the electrodes are constituted by the same material means that the electrodes contain the same element which has the highest mole fraction among the elements contained in each electrode. The kinds and contents of the elements in the electrodes can be identified by elemental analysis such as X-ray photoelectron spectroscopy (XPS).

In addition, it is preferable that the gate insulating layer of the p-type semiconductor device and the gate insulating layer of the n-type semiconductor device are composed of the same material. The reason is that this requires fewer kinds of materials used and enables these electrodes to be produced in the same step.

That these insulating layers are composed of the same material means that the insulating layers have the same kinds of and the same composition ratios of elements which are each contained at 1 mol% or more in the composition constituting each insulating layer. Whether the kinds and composition ratios of elements are the same can be determined by X-ray photoelectron spectroscopy (XPS).

Regarding the second insulating layer, at least part of the second insulating layer of the p-type semiconductor device is preferably constituted by the same material as the second layer of the second insulating layer of the n-type semiconductor device. One of the reasons is that this requires fewer kinds of materials and also enables these electrodes to be produced in the same step. Another reason is that the second layer of the second insulating layer preferably has an oxygen permeability of 4.0 cc/($m^2$·24h·atm) or less, and accordingly that it is possible to suppress the characteristic change caused over time to the p-type semiconductor device and the complementary semiconductor device. It is more preferable that the second layer of the p-type semiconductor device and the second layer of the n-type semiconductor device are composed of the same material. As above-mentioned, this is because separating the functions makes it easier to control the characteristics and to enhance the stability shown over time in the atmosphere.

That these second layers are composed of the same material means that the second layers have the same kinds of and the same composition ratios of elements which are each contained at 1 mol% or more in the composition constituting each insulating layer. Whether the kinds and composition ratios of elements are the same can be determined by X-ray photoelectron spectroscopy (XPS).

In addition, it is preferable that the constitution of a semiconductor device includes a protective layer preferably in contact with the second insulating layer of the p-type semiconductor device on the opposite side of the second insulating layer from the gate electrode, that this protective layer and the protective layer of the n-type semiconductor device are composed of the same material, and that the former protective layer has a water vapor permeability of 20 g/($m^2$·24h) or less. In this constitution, the second insulating layer has: a function that represents the semiconductor characteristics of the p-type semiconductor device, such as mobility and a threshold voltage; and an oxygen blocking function, and the protective layer has a humidity blocking function. This further enhances the stability of the p-type semiconductor device characteristics shown over time in the atmosphere, and this enhancement further enhances the stability shown over time by the complementary semiconductor device in the atmosphere. The water vapor permeability of the protective layer is more preferably 10 g/($m^2$·24h) or less, still more preferably 1 g/($m^2$·24h) or less. The lower limit is not limited to a particular value, and is preferably 0.001 g/($m^2$·24h) or more.

For a complementary semiconductor device according to an embodiment of the present invention, it is preferable that the p-type semiconductor device and the n-type semiconductor device have the same structure. The reason is that this requires fewer kinds of materials used and enables these electrodes to be produced in the same step. Having the

same structure means that the forming order of the semiconductor layer, gate insulating layer, and electrodes formed on the substrate is the same, and the number of layers is the same. The p-type semiconductor device and the n-type semiconductor device having the same structure simplifies the processes of producing the p-type semiconductor device and the n-type semiconductor device simultaneously and improves the production efficiency of the complementary semiconductor device.

The complementary semiconductor devices shown in Fig. 6 to Fig. 8 are all examples in which the p-type semiconductor device and the n-type semiconductor device have the same bottom-gate/bottom-contact structure.

Next, the members of the p-type semiconductor device included in the complementary semiconductor device according to the present invention will be described in detail. The below-mentioned description equally applies to all embodiments, unless otherwise specified.

(Substrate)

The substrate in the p-type semiconductor device may be of any material as long as at least that surface of the substrate on which the electrode system is to be disposed has insulating properties. Specific examples of and preferable examples of the material include the same material as the material used for the substrate in the n-type semiconductor device.

(Electrode)

The materials used for the gate electrode, source electrode, and drain electrode in the p-type semiconductor device may be any electrically conductive materials which can be generally used for electrodes. Specific examples of and preferable examples of the material include the same material as the material used for the electrode in the n-type semiconductor device.

(Gate Insulating Layer)

The material to be used for the gate insulating layer in the p-type semiconductor device is not particularly limited, and examples thereof include: inorganic materials such as silicon oxide and alumina; organic polymer materials such as polyimides, polyvinyl alcohols, polyvinyl chloride, polyethylene terephthalate, polyvinylidene fluoride, polysiloxanes, and polyvinyl phenol (PVP); and mixtures of inorganic material powders and organic materials. Specific examples of and preferable examples of the material include the same material as the material used for the gate insulating layer in the n-type semiconductor device.

(Semiconductor Layer)

The semiconductor layer of the p-type semiconductor device preferably contains a CNT, more preferably contains a CNT composite in which a conjugated polymer is attached to at least a part of the surface of a CNT. The semiconductor layer may further contain an organic semiconductor and an insulating material to the extent that the electrical characteristics of the CNT or the CNT composite are not impaired. Specific examples of and preferable examples of the material include the same material as the material used for the semiconductor layer in the n-type semiconductor device.

(Second Insulating Layer)

Specific examples of and preferable examples of materials used for the second insulating layer in the p-type semiconductor device and of the constitution of the second insulating layer in the p-type semiconductor device include the same materials and constitution as used for the second insulating layer in the n-type semiconductor device.

The second insulating layer of the p-type semiconductor device preferably has a film thickness of 1 μm or more, more preferably 3 μm or more. In addition, the upper limit of the film thickness of the second insulating layer is not limited to a particular value, and is preferably 1 mm or less, more preferably 100 μm or less.

In cases where the second insulating layer of the p-type semiconductor device contains a first layer provided nearer to the semiconductor layer and a second layer provided farther from the semiconductor layer, the first layer preferably has a film thickness of 50 nm or more, more preferably 100 nm or more. In addition, the first layer preferably has a film thickness of 10 μm or less, more preferably 3 μm or less. The second layer preferably has a film thickness of 1 μm or more, more preferably 3 μm or more. In addition, the upper limit of the film thickness of the first layer is not limited to a particular value, and is preferably 1 mm or less, more preferably 100 μm or less.

(Protective Layer)

Specific examples of and preferable examples of materials used for the protective layer of the p-type semiconductor device include the same material as used for the protective layer of the n-type semiconductor device.

(Characteristics of Complementary Semiconductor Device)

The equivalent circuit of a complementary semiconductor device according to an embodiment of the present invention is shown in Fig. 9, and the operation of the equivalent circuit will be described below.

First, an input signal ($V_{in}$) varies between Low "L" (ground potential GND) and High "H" ($V_{DD}$). When the input signal is given at "L", the p-type semiconductor device 51 conducts, and the n-type semiconductor device 52 is cut off, whereby the output signal is given at "H". Conversely, when the input signal is "H", the n-type semiconductor device 52 conducts, and the p-type semiconductor device 51 is cut off, whereby the output signal is given at "L".

For example, when the threshold voltage of the n-type semiconductor device 52 is positively large and when the input signal is given at "H", the n-type semiconductor device 52 does not conduct completely, and the output signal is not given at "L".

In addition, in a complementary semiconductor device, the variation of the output signal (gain) relative to the variation of the input signal correlates to the mobility in the semiconductor layer. A complementary semiconductor device having a high gain has high performance.

Accordingly, for example, a complementary semiconductor device in which the p-type semiconductor device and the n-type semiconductor device each have a small threshold voltage absolute value and in which the semiconductor layer has high mobility is one which achieves low power consumption and has good characteristics.

(Method of Producing Complementary Semiconductor Device)

Methods of producing a complementary semiconductor device according to an embodiment of the present invention are not limited to particular ones. The methods of forming the electrodes and insulating layers constituting each semiconductor device are as above-mentioned. Complementary semiconductor devices such as shown in Fig. 6 to Fig. 8 can be produced by suitably selecting the order of forming the electrodes and the insulating layers.

From the viewpoint of production cost and process simpleness, the p-type semiconductor device and the n-type semiconductor device should not be formed separately but is preferably formed simultaneously. Accordingly, it is preferable that the p-type semiconductor device and the n-type semiconductor device have the same structure.

A method of producing a complementary semiconductor device according to an embodiment of the present invention preferably includes a step in which the device is formed by applying each of a semiconductor layer of the p-type semiconductor device and a semiconductor layer of the n-type semiconductor device and by drying each layer. More preferably, the following production steps are further included:

(1) the step of forming the source electrode and drain electrode of the p-type semiconductor device and the source electrode and drain electrode of the n-type semiconductor device in the same step;
(2) the step of forming the gate insulating layer of the p-type semiconductor device and the gate insulating layer of the n-type semiconductor device in the same step by applying a composition containing a compound containing a bond between a silicon atom and a carbon atom and by drying the composition; and
(3) the step of forming the semiconductor layer of the p-type semiconductor device and the semiconductor layer of the n-type semiconductor device in the same step.

Here, forming two electrodes or layers in the same step means forming both of the two electrodes or layers together by carrying out once a process required to form the electrodes or layers.

Any of these steps is applicable even if the p-type semiconductor device and the n-type semiconductor device have different structures, but is easier to apply when they have the same structure.

Below, a method of producing a complementary semiconductor device according to an embodiment of the present invention will be described specifically, taking, as an example, a case where a complementary semiconductor device having a structure shown in Fig. 8 is produced.

First, as shown in Fig. 10 (a), a gate electrode 2 is formed in each of the p-type semiconductor device region 101 and the n-type semiconductor device region 201 on an insulating substrate 1 by the above-mentioned method.

Next, as shown in Fig. 10 (b), a solution of a compound containing a bond between a silicon atom and a carbon atom is applied and dried to form a gate insulating layer 3 in each of the p-type semiconductor device region 101 and the n-type semiconductor device region 201.

Next, as shown in Fig. 10 (c), a source electrode 5 and a drain electrode 6 are simultaneously formed using

the same material on top of each gate insulating layer 3 in the p-type semiconductor device region 101 and the n-type semiconductor device region 201 by the above-mentioned method.

Next, as shown in Fig. 10 (d), a semiconductor layer 4 is formed between the source electrode 5 and the drain electrode 6 in each of the p-type semiconductor device region 101 and the n-type semiconductor device region 201 by the above-mentioned method.

Next, as shown in Fig. 10 (e), a first layer 12 of a second insulating layer 11 and a first layer 9 of a second insulating layer 8 are formed so as to cover the semiconductor layer 4 of the p-type semiconductor device and the semiconductor layer 4 of the n-type semiconductor device respectively, by the above-mentioned method.

Then, as shown in Fig. 10 (f), a second layer 13 and a second layer 10 are formed so as to cover the first layer 12 of the second insulating layer 11 and the first layer 9 of the second insulating layer 8 respectively by the above-mentioned method, whereby a complementary semiconductor device can be produced.

<Wireless Communication Device>

Next, a wireless communication device according to an embodiment of the present invention containing the above-mentioned semiconductor device or complementary semiconductor device will be described. This wireless communication device is a device, such as an RFID, in which an RFID tag receives carrier waves transmitted from an antenna mounted in a reader/writer, whereby telecommunications are performed.

Specific operations to be performed are, for example, as follows. The antenna of an RFID tag receives a wireless signal transmitted from the antenna mounted in a reader/writer. Then, an alternating current generated in response to the signal is converted into a direct current by a rectifier circuit to make the RFID tag electromotive. Next, the electromotive RFID tag receives a command from the wireless signal and carries out an operation in response to the command. Thereafter, a response as a result of executing the command is transmitted as a wireless signal from the antenna of the RFID tag to the antenna of the reader/writer. The operation in response to the command is carried out at least in a known demodulation circuit, control logic circuit, and modulation circuit.

The wireless communication device according to an embodiment of the present invention includes at least the above-mentioned semiconductor device or the complementary semiconductor device and an antenna. Examples of more specific constitution of a wireless communication device according to an embodiment of the present invention include such a configuration as shown in Fig. 11. This is constituted by: a power generation unit which rectifies a modulation wave signal received from outside by an antenna 50 and supplies power to another unit; a demodulation circuit which demodulates the modulation wave signal and sends it to a control circuit; a modulation circuit which modulates data sent from the control circuit and sends it to the antenna; and the control circuit which carries out writing of data demodulated by the demodulation circuit into a memory circuit and reading of the data from the memory circuit and transmits it to the modulation circuit; in which the circuit units are electrically connected. The demodulation circuit, control circuit, modulation circuit, and memory circuit include the above-mentioned n-type semiconductor device or complementary semiconductor device, and may further include a capacitor, a resistance device, and a diode. In addition, the memory circuit further has a non-volatile rewritable memory unit such as an EEPROM (Electrically Erasable Programmable Read-Only Memory) or an FeRAM (Ferroelectric Randam Access Memory). The power generation unit is constituted by a capacitor and a diode.

The antenna, capacitor, resistance device, diode, and non-volatile rewritable memory unit may be those which are generally used, and the materials and shapes to be used are not limited to particular ones. Further, any materials may be used for electrically connecting the above-mentioned components, as long as they are electrically conductive materials which can be commonly used. In addition, any methods may be used for connecting these components, as long as they can effect electrical conduction. The widths and thicknesses of the connecting portions of each component may each be any value.

<Merchandise Tag>

Next, a merchandise tag containing a wireless communication device according to an embodiment of the present invention will be described. This merchandise tag has, for example, a base material and the above-mentioned wireless communication device covered with the base material.

The base material is formed from, for example, a non-metal material in planar shape, such as paper. For example, the base material has the structure of two planar sheets of paper pasted together, and the wireless communication device is disposed between the two sheets of paper. In the memory circuit of the wireless memory device, for example, the individual identification information for identifying items of merchandise individually is stored preliminarily.

Wireless communication is carried out between this merchandise tag and a reader/writer. A reader/writer is a device which carries out reading and writing of data with merchandise tags wirelessly. The reader/writer exchanges data with merchandise tags in merchandise circulation processes and payment. As a reader/writer, for example, those of a

portable type and those of a fixed type installed at checkout counters are available. With merchandise tags according to an embodiment of the present invention, known reader/writers can be used.

A merchandise tag according to an embodiment of the present invention includes an identification information return function. This is a function by which, when a merchandise tag receives, from a given reader/writer, a command to send individual identification information, the tag wirelessly returns individual identification information that the tag stores. On one command from a reader/writer, individual identification information is transmitted from each of many merchandise tags. This function makes it possible, for example, to simultaneously identify a large number of merchandise items in a contactless manner at checkout counters for payment for merchandise. Accordingly, it is possible to attempt easier and more rapid payment processing, as compared to identification by bar code.

In addition, for example, it is possible that, when payment is made for merchandise items, the merchandise information read by a reader/writer from the merchandise tags is transmitted to a POS (point of sale system) terminal. This function makes it possible that the sale of a merchandise item identified by the merchandise information is also registered at the POS terminal and accordingly that easier and more rapid inventory control is attempted.

## EXAMPLES

Below, the present invention will be described more specifically with reference to Examples. However, the present invention is not to be construed to be limited to the following Examples.

The molecular weight of a polymer was measured as follows. The molecular weight of a polymer was determined in terms of a polystyrene standard sample using GPC (GEL PERMEATION CHROMATOGRAPHY: HLC-8220GPC manufactured by Tosoh Corporation) (developing solvent: chloroform or tetrahydrofuran, developing rate: 0.4 ml/min.) after filtrating a sample through a membrane filter having a pore size of 0.45 μm.

The film thickness was measured as follows. The film thickness was determined as the arithmetic average of the values obtained by calculating the film thicknesses of ten positions randomly selected from the image of the second insulating layer portion positioned on the semiconductor layer or the image of the second layer of the second insulating layer, in which the images were in an image obtained from a sample using an SEM.

The oxygen permeability was calculated as follows. The oxygen permeability coefficient of a material of a layer was measured on the basis of JIS K 7126-2 2006 (Plastics - Film and sheeting - Determination of gas-transmission rate) under the conditions that are a temperature of 25°C and a humidity of 40% RH. The measurement was converted on the basis of the film thickness of the layer in a sample.

### Preparation Example 1 for Semiconductor Solution: Semiconductor Solution A

The compound [60] was synthesized using the method shown in the scheme 1.

[Chem. 15]

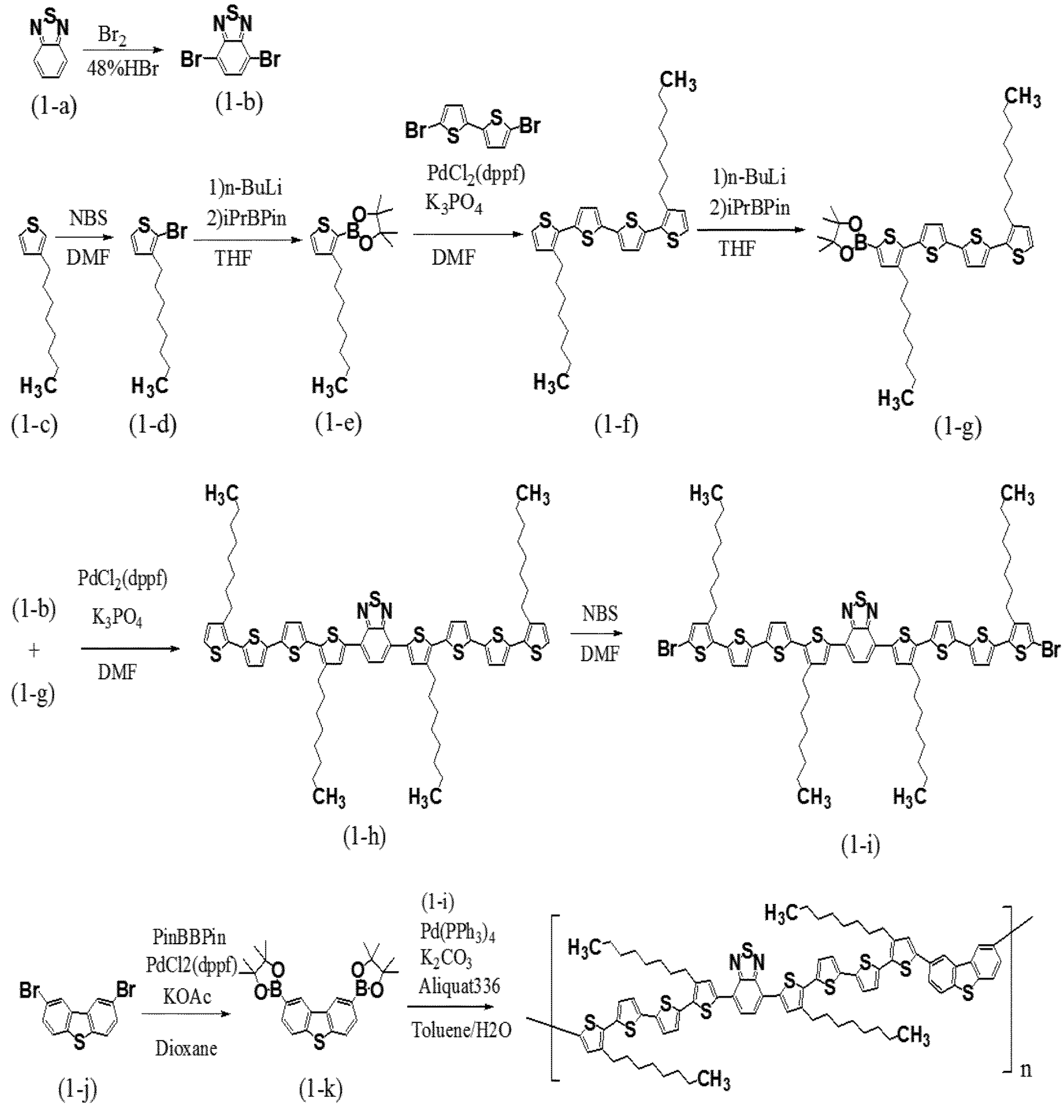


Compound [60]

## Scheme 1

To 150 ml of 48% hydrobromic acid, 4.3 g of the compound (1-a) (manufactured by Tokyo Chemical Industry Co., Ltd.) and 10 g of bromine (manufactured by Wako Pure Chemical Industries, Ltd.) were added, and the resulting mixture was stirred at 120°C for three hours. The mixture was cooled to room temperature, and the precipitated solid was filtrated through a glass filter and washed with 1000 ml of water and 100 ml of acetone. The obtained solid was dried in vacuo at 60°C to obtain 6.72 g of the compound (1-b).

In 100 ml of dimethylformamide, 10.2 g of the compound (1-c) was dissolved; to the resulting solution, 9.24 g of N-bromosuccinimide (manufactured by Wako Pure Chemical Industries, Ltd.) was added; and the resulting mixture was stirred under a nitrogen atmosphere at room temperature for three hours. To the resulting solution, 200 ml of water, 200 ml of n-hexane, and 200 ml of dichloromethane were added, and the organic layer was separated. The resulting

organic layer was washed with 200 ml of water and dried over magnesium sulfate. The resulting solution was purified by column chromatography (filler: silica gel, eluent: hexane) to obtain 14.4 g of the compound (1-d).

In 200 ml of tetrahydrofuran, 14.2 g of the compound (1-d) was dissolved, and the resulting solution was cooled to -80°C. To the resulting solution, 35 ml of n-butyllithium (1.6 M hexane solution) (manufactured by Wako Pure Chemical Industries, Ltd.) was added, and the resulting mixture was heated to -50°C and again cooled to -80°C. To the resulting mixture, 13.6 ml of 2-isopropoxy-4,4,5,5-tetramethyl-1,3,2-dioxaborolane (manufactured by Wako Pure Chemical Industries, Ltd.) was added, and the resulting mixture was heated to room temperature and stirred under a nitrogen atmosphere for four hours. To the resulting solution, 200 ml of 1 N ammonium chloride aqueous solution and 200 ml of ethyl acetate were added, and the organic layer was separated. The resulting organic layer was washed with 200 ml of water and dried over magnesium sulfate. The resulting solution was purified by column chromatography (filler: silica gel, eluent: hexane/dichloromethane) to obtain 14.83 g of the compound (1-e).

To 200 ml of dimethylformamide, 14.83 g of the compound (1-e) and 6.78 g of 5,5'-dibromo-2,2'-bithiophene (manufactured by Tokyo Chemical Industry Co., Ltd.) were added, and 26.6 g of potassium phosphate (manufactured by Wako Pure Chemical Industries, Ltd.) and 1.7 g of [bis(diphenylphosphino)ferrocene]dichloropalladium (manufactured by Sigma-Aldrich Co. LLC.) were further added under a nitrogen atmosphere, and the resulting mixture was stirred at 100°C for four hours. To the resulting solution, 500 ml of water and 300 ml of ethyl acetate were added, and the organic layer was separated. The resulting organic layer was washed with 500 ml of water and dried over magnesium sulfate. The resulting solution was purified by column chromatography (filler: silica gel, eluent: hexane) to obtain 4.53 g of the compound (1-f).

In 40 ml of tetrahydrofuran, 4.53 g of the compound (1-f) was dissolved, and the resulting solution was cooled to -80°C. To the resulting solution, 6.1 ml of n-butyllithium (1.6 M hexane solution) was added, and the resulting mixture was heated to -5°C and again cooled to -80°C. To the resulting mixture, 2.3 ml of 2-isopropoxy-4,4,5,5-tetramethyl-1,3,2-dioxaborolane was added, and the resulting mixture was heated to room temperature and stirred under a nitrogen atmosphere for two hours. To the resulting solution, 150 ml of 1 N ammonium chloride aqueous solution and 200 ml of ethyl acetate were added, and the organic layer was separated. The resulting organic layer was washed with 200 ml of water and dried over magnesium sulfate. The resulting solution was purified by column chromatography (filler: silica gel, eluent: dichloromethane/hexane) to obtain 2.31 g of the compound (1-g).

To 17 ml of dimethylformamide, 0.498 g of the compound (1-b) and 2.31 g of the compound (1-g) were added, and 2.17 g of potassium phosphate and 0.14 g of [bis(diphenylphosphino)ferrocene]dichloropalladium (manufactured by Sigma-Aldrich Co. LLC.) were further added under a nitrogen atmosphere, and the resulting mixture was stirred at 90°C for seven hours. To the resulting solution, 200 ml of water and 100 ml of chloroform were added, and the organic layer was separated. The resulting organic layer was washed with 200 ml of water and dried over magnesium sulfate. The resulting solution was purified by column chromatography (filler: silica gel, eluent: dichloromethane/hexane) to obtain 1.29 g of the compound (1-h). The $^1$H-NMR analysis results of the compound (1-h) are shown below. $^1$H-NMR ($CD_2Cl_2$, (d = ppm)): 8.00 (s, 2H), 7.84 (s, 2H), 7.20-7.15 (m, 8H), 7.04 (d, 2H), 6.95 (d, 2H), 2.88 (t, 4H), 2.79 (t, 4H), 1.77-1.29 (m, 48H), 0.88 (m, 12H)

In 15 ml of chloroform, 0.734 g of the compound (1-h) was dissolved; to the resulting solution, 0.23 g of N-bromosuccinimide and 10 ml of dimethylformamide were added; and the resulting mixture was stirred under a nitrogen atmosphere at room temperature for nine hours. To the resulting solution, 100 ml of water and 100 ml of chloroform were added, and the organic layer was separated. The resulting organic layer was washed with 200 ml of water and dried over magnesium sulfate. The resulting solution was purified by column chromatography (filler: silica gel, eluent: dichloromethane/hexane) to obtain 0.58 g of the compound (1-i).

To 7 ml of 1,4-dioxane, 0.5 g of the compound (1-j), 0.85 g of bis(pinacolato)diboron (manufactured by BASF Japan Ltd.), and 0.86 g of potassium acetate (manufactured by Wako Pure Chemical Industries, Ltd.) were added; 0.21 g of [bis(diphenylphosphino)ferrocene]dichloropalladium was further added under a nitrogen atmosphere; and the resulting mixture was stirred at 80°C for seven hours. To the resulting solution, 100 ml of water and 100 ml of ethyl acetate were added, and the organic layer was separated. The resulting organic layer was washed with 100 ml of water and dried over magnesium sulfate. The resulting solution was purified by column chromatography (filler: silica gel, eluent: dichloromethane) to obtain 57 mg of the compound (1-k).

In 6 ml of toluene, 93 mg of the compound (1-i) and 19.3 mg of the compound (1-k) were dissolved. To this, 2 ml of water, 0.18 g of potassium carbonate, 7.7 mg of tetrakis(triphenylphosphine)palladium (0) (manufactured by Tokyo Chemical Industry Co., Ltd.), and one drop of Aliquat(R) 336 (manufactured by Sigma-Aldrich Co. LLC.) were added, and the resulting mixture was stirred under a nitrogen atmosphere at 100°C for 25 hours. Then, 40 mg of phenylboronic acid was added, and the resulting mixture was stirred at 100°C for seven hours. To the resulting solution, 50 ml of methanol was added, and the produced solid was obtained by filtration and washed with methanol, water, methanol, and acetone in this order. The obtained solid was dissolved in chloroform, passed through a silica gel short column (eluent: chloroform), and then concentrated to dryness to obtain 30 mg of a compound [60]. The molecular weight of the compound [60] was measured by the above-mentioned method, and the compound was found to have a weight

average molecular weight of 4367, a number average molecular weight of 3475, and a polymerization degree n of 3.1.

To 10 ml of a solution of 2.0 mg of the compound [60] in chloroform, 1.0 mg of CNT 1 (a single-walled CNT, purity: 95%; manufactured by CNI Inc.) was added. The resulting mixture was subjected to ultrasonic stirring for four hours using an ultrasonic homogenizer (VCX-500; manufactured by Tokyo Rikakikai Co., Ltd.) at an output of 20%, while cooling on ice, thereby obtaining a CNT dispersion A (CNT composite concentration with respect to the solvent: 0.96 g/l).

Next, a semiconductor solution for forming a semiconductor layer was prepared. The CNT dispersion A obtained as described above was filtrated using a membrane filter (Omnipore Membrane, pore size: 10 μm, diameter: 25 mm; manufactured by Millipore Corporation), to remove CNT composites having a length of 10 μm or more. To the resulting filtrate, 5 ml of o-DCB (manufactured by Wako Pure Chemical Industries, Ltd.) was added. Thereafter, chloroform, which is a solvent having a low-boiling point, was removed by distillation using a rotatory evaporator, thereby obtaining a CNT dispersion B. To 1 ml of the resulting CNT dispersion B, 3 ml of o-DCB was added, to prepare the semiconductor solution B (CNT composite concentration with respect to the solvent: 0.03 g/l).

Preparation Example 2 for Semiconductor Solution: Semiconductor Solution B

The compound [72] was synthesized using the method shown in the scheme 2.

[Chem. 16]

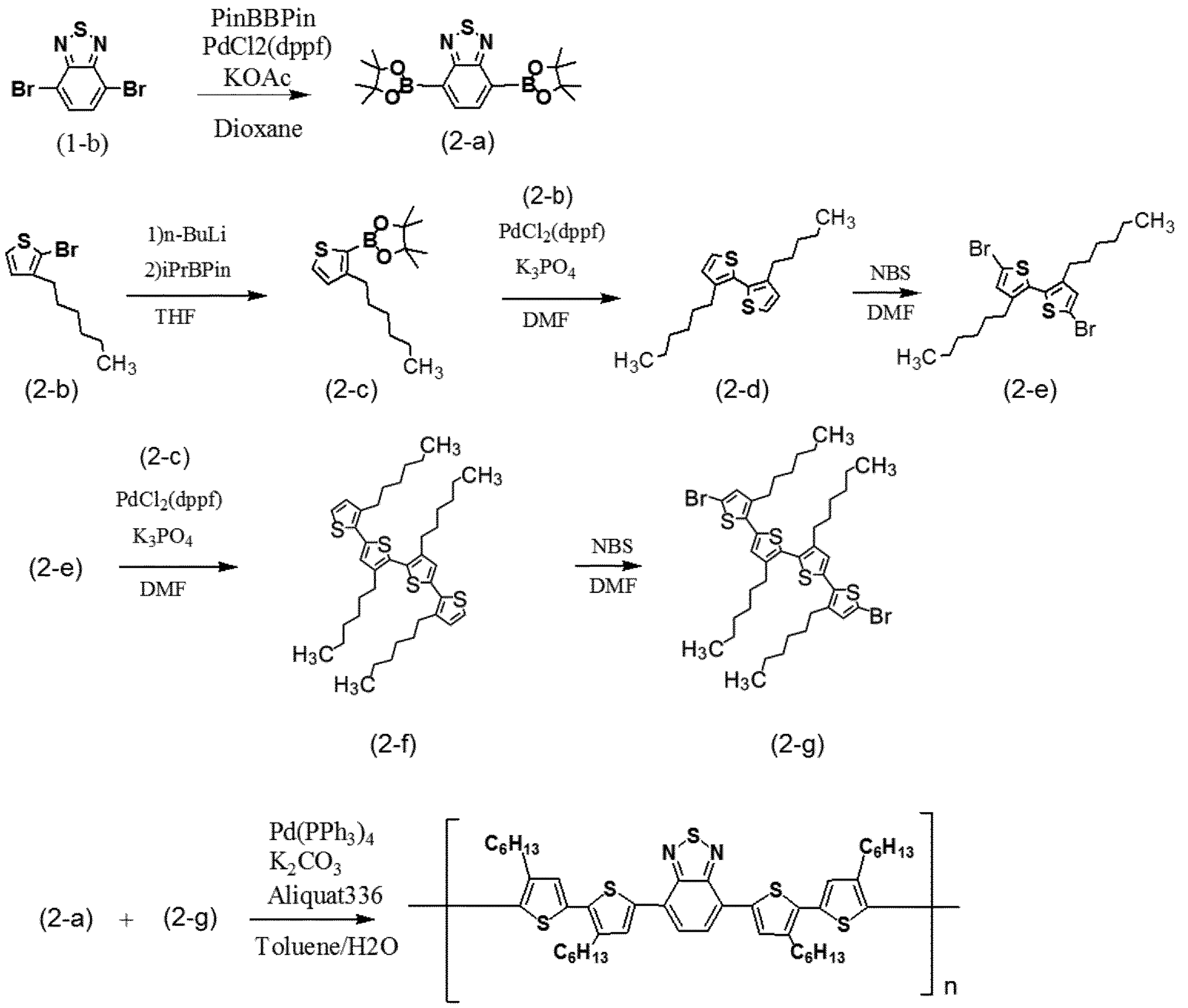


Compound [72]

Scheme 2

To 40 ml of 1,4-dioxane, 2.0 g of the compound (1-b) and 4.3 g of bis(pinacolato)diboron were added, and 4.0 g of potassium acetate and 1.0 g of [bis(diphenylphosphino)ferrocene]dichloropalladium were added under a nitrogen atmosphere; and the resulting mixture was stirred at 80°C for eight hours. To the resulting solution, 200 ml of water and 200 ml of ethyl acetate were added, and the organic layer was separated, washed with 400 ml of water, and dried over magnesium sulfate. The resulting solution was purified by column chromatography (filler: silica gel, eluent: dichloromethane/ethyl acetate) to obtain 1.3 g of the compound (2-a).

In 250 ml of tetrahydrofuran, 18.3 g of the compound (2-b) was dissolved, and the resulting solution was cooled to -80°C. To the resulting solution, 45 ml of n-butyllithium (1.6 M hexane solution) was added, and the resulting mixture was heated to -50°C and again cooled to -80°C. To the resulting mixture, 18.6 ml of 2-isopropoxy-4,4,5,5-tetramethyl-1,3,2-dioxaborolane was added, and the resulting mixture was heated to room temperature and stirred under a nitrogen atmosphere for six hours. To the resulting solution, 200 ml of 1 N ammonium chloride aqueous solution and 200 ml of ethyl acetate were added, and the organic layer was separated, washed with 200 ml of water, and dried over magnesium sulfate. The resulting solution was purified by column chromatography (filler: silica gel, eluent: hexane/dichloromethane) to obtain 16.66 g of the compound (2-c).

To 100 ml of dimethylformamide, 2.52 g of the compound (2-b) and 3.0 g of the compound (2-c) were added, and to the resulting mixture, 13 g of potassium phosphate and 420 mg of [bis(diphenylphosphino)ferrocene]dichloropalladium were added under a nitrogen atmosphere, and the resulting mixture was stirred at 90°C for five hours. To the resulting solution, 200 ml of water and 100 ml of hexane were added, and the organic layer was separated, washed with 400 ml of water, and dried over magnesium sulfate. The resulting solution was purified by column chromatography (filler: silica gel, eluent: hexane) to obtain 2.71 g of the compound (2-d).

In 8 ml of dimethylformamide, 2.71 g of the compound (2-d) was dissolved; to the resulting mixture, 16 ml of a solution of 2.88 g of N-bromosuccinimide in dimethylformamide was added; and the resulting mixture was stirred at 5°C to 10°C for nine hours. To the resulting solution, 150 ml of water and 100 ml of hexane were added, and the organic layer was separated, washed with 300 ml of water, and dried over magnesium sulfate. The resulting solution was purified by column chromatography (filler: silica gel, eluent: hexane) to obtain 3.76 g of the compound (2-e).

To 70 ml of dimethylformamide, 3.76 g of the compound (2-e) and 4.71 g of the compound (2-c) were added, and 19.4 g of potassium phosphate and 310 mg of [bis(diphenylphosphino)ferrocene]dichloropalladium were further added under a nitrogen atmosphere, and the resulting mixture was stirred at 90°C for nine hours. To the resulting solution, 500 ml of water and 200 ml of hexane were added, and the organic layer was separated, washed with 300 ml of water, and dried over magnesium sulfate. The resulting solution was purified by column chromatography (filler: silica gel, eluent: hexane) to obtain 4.24 g of the compound (2-f).

In 20 ml of chloroform, 520 mg of the compound (2-f) was dissolved; to the resulting mixture, 10 ml of a solution of 280 mg of N-bromosuccinimide in dimethylformamide was added; and the resulting mixture was stirred at 5°C to 10°C for five hours. To the resulting solution, 150 ml of water and 100 ml of dichloromethane were added, and the organic layer was separated, washed with 200 ml of water, and dried over magnesium sulfate. The resulting solution was purified by column chromatography (filler: silica gel, eluent: hexane) to obtain 610 mg of the compound (2-g).

In 30 ml of toluene, 280 mg of the compound (2-a) and 596 mg of the compound (2-g) were dissolved. To this, 10 ml of water, 1.99 g of potassium carbonate, 83 mg of tetrakis(triphenylphosphine)palladium (0), and one drop of Aliquat 336 were added, and the resulting mixture was stirred under a nitrogen atmosphere at 100°C for 20 hours. To the resulting solution, 100 ml of methanol was added, and the produced solid was obtained by filtration and washed with methanol, water, acetone, and hexane in this order. The obtained solid was dissolved in 200 ml of chloroform, passed through a silica gel short column (eluent: chloroform), then concentrated to dryness, and then washed with methanol, acetone, and methanol in this order to obtain 480 mg of a compound [72]. The molecular weight of the compound [72] was measured by the above-mentioned method, and the compound was found to have a weight average molecular weight of 29398, a number average molecular weight of 10916, and a polymerization degree n of 36.7.

A semiconductor solution B (having a CNT composite concentration of 0.03 g/l with respect to the solvent) was obtained in the same manner as in Preparation Example for the semiconductor solution A except that the compound [72] was used in place of the compound [60].

Preparation Example 3 for Semiconductor Solution: Semiconductor Solution C

In 120 ml of toluene, 0.92 g of 4,7-bis(5-bromo-2-thienyl)-2,1,3-benzothiadiazole (manufactured by Tokyo Chemical Industry Co., Ltd.) and 1.12 g of 9,9-dioctylfluorene-2,7-diboronatebis(1,3-propanediol) ester (manufactured by Sigma-Aldrich Co. LLC.) were dissolved. To this, 40 ml of water, 5.52 g of potassium carbonate, 0.23 g of tetrakis(triphenylphosphine)palladium (0), and one drop of Aliquat 336 were added, and the resulting mixture was stirred under a nitrogen atmosphere at 100°C for six hours. Then, to the resulting mixture, 0.10 g of bromobenzene was added, the resulting mixture was stirred under a nitrogen atmosphere at 100°C for one hour, 0.10 g of phenylboronic acid was added to the resulting mixture, and the resulting mixture was stirred under a nitrogen atmosphere at 100°C for one hour.

To the resulting solution, 200 ml of methanol was added, and the produced solid was obtained by filtration and washed with methanol, water, acetone, and hexane in this order. The obtained solid was dissolved in 300 ml of chloroform, passed through a silica gel short column (eluent: chloroform), then concentrated to dryness, and then washed with methanol, acetone, and methanol in this order to obtain 1.17 g of a compound [78]. The molecular weight of the compound [78] was measured by the above-mentioned method, and the compound was found to have a weight average molecular weight of 6035, a number average molecular weight of 3565, and a polymerization degree n of 5.2.

A semiconductor solution C (having a CNT composite concentration of 0.03 g/l with respect to the solvent) was obtained in the same manner as in the Preparation Example for the semiconductor solution A except that the compound [78] was used in place of the compound [60].

Composition Preparation Example 1: Gate Insulating Layer Solution A

In 203.36 g of propylene glycol monobutyl ether (boiling point: 170°C), 61.29 g (0.45 mol) of methyltrimethoxysilane, 12.31 g (0.05 mol) of 2-(3,4-epoxycyclohexyl)ethyltrimethoxysilane, and 99.15 g (0.5 mol) of phenyltrimethoxysilane were dissolved, and to the resulting mixture, 54.90 g of water and 0.864 g of phosphoric acid were added with stirring. The resulting solution was heated at a bath temperature of 105°C for two hours, and the internal temperature of the solution was raised to 90°C to distill out a component mainly composed of by-produced methanol. Subsequently, the resulting solution was heated at a bath temperature of 130°C for 2.0 hours, and the internal temperature was raised to 118°C to distill out a component mainly composed of water and propylene glycol monobutyl ether. Then, the residue was cooled to room temperature to obtain a polysiloxane solution A having a solid concentration of 26.0 wt%. The molecular weight of the obtained polysiloxane was measured by the above-mentioned method, and the weight average molecular weight was 6000.

A mixture of 10 g of the obtained polysiloxane solution A, 13.0 g of aluminumbis(ethylacetoacetate)mono(2,4-pentanedionate) (tradename "Alumichelate D"; manufactured by Kawaken Fine Chemicals Co., Ltd., hereinafter, referred to as Alumichelate D), and 42.0 g of propylene glycol monoethyl ether acetate (hereinafter, referred to as PGMEA) was stirred at room temperature for two hours to obtain a gate insulating layer solution A. The amount of the above-mentioned polysiloxane contained in this solution was 20 parts by weight with respect to 100 parts by weight of Alumichelate D.

Composition Preparation Example 2: Electron-donating Material Solution A

In 9.50 g of 1,2-dimethoxyethane (manufactured by Wako Pure Chemical Industries, Ltd.), 0.49 g of polymethylmethacrylate (PMMA, manufactured by Mitsubishi Rayon Co., Ltd.) was dissolved, and to the resulting solution, 0.016 g of DBU (manufactured by Tokyo Chemical Industry Co., Ltd.) was added. The resulting solution was filtrated through a membrane filter having a pore size of 0.45 μm to obtain an electron-donating material solution A.

Composition Preparation Example 3: Electron-donating Material Solution B

An electron-donating material solution B was obtained in the same manner as in the Preparation Example for the electron-donating material solution A except that dicyclohexylmethylamine (manufactured by Tokyo Chemical Industry Co., Ltd.) was used in place of DBU.

Composition Preparation Example 4: Electron-donating Material Solution C

An electron-donating material solution C was obtained in the same manner as in the Preparation Example for the electron-donating material solution A except that quinuclidine (manufactured by Tokyo Chemical Industry Co., Ltd.) was used in place of DBU.

Composition Preparation Example 5: Electron-donating Material Solution D

In 9.99 g of decahydronaphthalene (manufactured by Wako Pure Chemical Industries, Ltd.), 0.49 g of cycloolefin polymer (manufactured by Zeon Corporation) was dissolved, and to the resulting solution, 0.015 g of DBU (manufactured by Tokyo Chemical Industry Co., Ltd.) was added. The resulting solution was filtrated through a membrane filter having a pore size of 0.45 μm to obtain an electron-donating material solution D.

Composition Preparation Example 6: Electron-donating Material Solution E

An electron-donating material solution E was obtained in the same manner as in the Preparation Example for the electron-donating material solution A except that DBN (manufactured by Tokyo Chemical Industry Co., Ltd.) was

used in place of DBU.

Composition Preparation Example 7: Electron-donating Material Solution F

An electron-donating material solution F was obtained in the same manner as in the Preparation Example for the electron-donating material solution A except that TBD (manufactured by Tokyo Chemical Industry Co., Ltd.) was used in place of DBU.

Composition Preparation Example 8: Electron-donating Material Solution G

An electron-donating material solution G was obtained in the same manner as in the Preparation Example for the electron-donating material solution A except that MTBD (manufactured by Tokyo Chemical Industry Co., Ltd.) was used in place of DBU.

Composition Preparation Example 9: Low Oxygen Permeability Compound Solution A

In a solution mixture of 9.00 g of water and 1.00 g of isopropyl alcohol (manufactured by Wako Pure Chemical Industries, Ltd.), 0.40 g of polyvinyl alcohol (PVA-117, manufactured by Kuraray Co., Ltd.) was dissolved to obtain a low oxygen permeability compound solution A.

Composition Preparation Example 10: Low Oxygen Permeability Compound Solution B

In a solution mixture of 9.00 g of water and 1.00 g of isopropyl alcohol, 0.20 g of polyvinyl alcohol was dissolved to obtain a low oxygen permeability compound solution B.

Composition Preparation Example 11: Low Oxygen Permeability Compound Solution C

In a solution mixture of 9.00 g of water and 1.00 g of isopropyl alcohol, 0.90 g of polyvinyl alcohol was dissolved to obtain a low oxygen permeability compound solution C.

Composition Preparation Example 12: Low Oxygen Permeability Compound Solution D

In 10.00 g of dimethylformamide (manufactured by Wako Pure Chemical Industries, Ltd.), 0.80 g of polyacrylonitrile (manufactured by Sigma-Aldrich Co. LLC.) was dissolved to obtain a low oxygen permeability compound solution D.

Composition Preparation Example 13: Low Oxygen Permeability Compound Solution E

With a solution mixture of 4.50 g of water and 0.50 g of isopropyl alcohol, 5.00 g of ethylene-vinyl alcohol copolymer (EVERSOLVE #10, manufactured by Nihon Cima Co., Ltd.) was diluted to obtain a low oxygen permeability compound solution E.

Composition Preparation Example 14: Low Oxygen Permeability Compound Solution F

With a solution mixture of 4.50 g of water and 0.50 g of isopropyl alcohol, 2.50 g of ethylene-vinyl alcohol copolymer was diluted to obtain a low oxygen permeability compound solution F.

Composition Preparation Example 15: Electron-donating Material Solution H

With 9.30 g of 1-butanol (manufactured by Wako Pure Chemical Industries, Ltd.), 0.60 g of poly(melamine-co-formaldehyde) (manufactured by Sigma-Aldrich Co. LLC., a 1-butanol solution having a solid concentration of 84 wt%) was diluted, and to the resulting solution, 0.016 g DBU was added. The resulting solution was filtrated through a membrane filter having a pore size of 0.45 μm to obtain an electron-donating material solution H.

Composition Preparation Example 16: Electron-donating Material Solution I

In 7.50 g of decahydronaphthalene, 2.50 g of cycloolefin polymer was dissolved, and to the resulting solution, 0.50 g of DBU was added. The resulting solution was filtrated through a membrane filter having a pore size of 0.45 μm

to obtain an electron-donating material solution I.

Composition Preparation Example 17: Electron-donating Material Solution J

In a solution mixture of 9.00 g of water and 1.00 g of isopropylalcohol, 0.90 g of polyvinyl alcohol was dissolved, and to the resulting solution, 0.050 g of DBU was added to obtain an electron-donating material solution J.

Composition Preparation Example 18: Low Water Vapor Permeability Compound Solution A

In 7.50 g of decahydronaphthalene, 2.50 g of cycloolefin polymer was dissolved. The resulting solution was filtrated through a membrane filter having a pore size of 0.45 μm to obtain a low water vapor permeability compound solution A.

Composition Preparation Example 19: Low Water Vapor Permeability Compound Solution B

A low water vapor permeability compound solution B was obtained in the same manner as in the Preparation Example for the low water vapor permeability compound solution A except that 0.50 g of cycloolefin polymer and 9.50 g of decahydronaphthalene were used.

Composition Preparation Example 20: Low Water Vapor Permeability Compound Solution C

A low water vapor permeability compound solution C was obtained in the same manner as in the Preparation Example for the low water vapor permeability compound solution A except that 1.30 g of cycloolefin polymer and 8.70 g of decahydronaphthalene were used.

Composition Preparation Example 21: Second Insulating Layer Solution A

In 9.95 g of decahydronaphthalene, 2.49 g of polystyrene was dissolved. The resulting solution was filtrated through a membrane filter having a pore size of 0.45 μm to obtain a second insulating layer solution A.

Composition Preparation Example 22: Second Insulating Layer Solution B

In 10.10 g of decahydronaphthalene, 2.51 g of PMMA was dissolved. The resulting solution was filtrated through a membrane filter having a pore size of 0.45 μm to obtain a second insulating layer solution B.

Example 1

A semiconductor device shown in Fig. 3 was produced. On a glass substrate 1 (having a film thickness of 0.7 mm), chromium and gold were vacuum vapor deposited through a mask to a thickness of 5 nm and 50 nm respectively using a resistance heating method to form a gate electrode 2. Next, the resulting substrate was spin-coated (2000 rpm × 30 seconds) with the gate insulating layer solution A, and the coated substrate was heat-treated under a nitrogen stream at 200°C for one hour to form a gate insulating layer 3 having a film thickness of 600 nm. Next, gold was vacuum vapor deposited through a mask to a thickness of 50 nm by a resistance heating method to form a source electrode 5 and a drain electrode 6. Next, 1 μl of the semiconductor solution B was dropped between the source electrode 5 and the drain electrode 6, air-dried at 30°C for 10 minutes, and heat-treated on a hot plate under a nitrogen stream at 150°C for 30 minutes to form a semiconductor layer 4. Next, 0.5 μl of the electron-donating material solution A was dropped onto the semiconductor layer 4 so as to cover the semiconductor layer 4, and heat-treated under a nitrogen stream at 110°C for 15 minutes to form a first layer of a second insulating layer. Next, 2.0 μl of the low oxygen permeability compound solution A was dropped so as to cover the first layer of the second insulating layer, and heat-treated under a nitrogen stream at 90°C for 5 minutes to form a second layer of the second insulating layer. Thus, the semiconductor device was obtained. The source and drain electrodes (channel width) of this semiconductor device each had a width of 200 μm, and the spacing between the source and drain electrodes (channel length) was 100 μm. In this semiconductor device, the first layer of the second insulating layer had a film thickness of 2.9 μm, the second layer had a film thickness of 2.0 μm, the difference (absolute value) in solubility parameter between the first layer and the second layer was 9.4 $(MPa)^{1/2}$, the second insulating layer had an oxygen permeability of 2.2 cc/($m^2$·24h·atm), and the second layer of the second insulating layer had an oxygen permeability of 2.2 cc/($m^2$·24h·atm).

Next, on the day when the semiconductor device was produced, the characteristic of the source-drain current (Id) versus the source-drain voltage (Vsd) was measured when the gate voltage (Vg) was varied. The measurement

was made in the atmosphere using a semiconductor characterization system Model 4200-SCS (manufactured by Keithley Instruments Co., Ltd.). The mobility in the linear region was determined from the variation in the Id value at Vsd = +5V which was caused in the variation of Vg = +30 to -30V, and the threshold voltage was determined from the intersection between the extension and Vg axis of the linear portion on the Id-Vg graph. Also 20 days after this, the mobility and threshold voltage were determined in the same manner. The results are shown in Table 1.

Example 2

A semiconductor device was prepared in the same manner as in Example 1 except that the low oxygen permeability compound solution B was used in place of the low oxygen permeability compound solution A. The mobility and the threshold voltage were evaluated. In this semiconductor device, the first layer of the second insulating layer had a film thickness of 2.9 μm, the second layer had a film thickness of 1.1 μm, the difference (absolute value) in solubility parameter between the first layer and the second layer was 9.4 $(MPa)^{1/2}$, the second insulating layer had an oxygen permeability of 3.9 cc/($m^2$·24h·atm), and the second layer of the second insulating layer had an oxygen permeability of 3.9 cc/($m^2$·24h·atm). Here, in Example 2, the low oxygen permeability compound solution had a lower polyvinyl alcohol concentration than in Example 1, and accordingly, the film thickness of the second layer of the second insulating layer was a small value.

Example 3

A semiconductor device was prepared in the same manner as in Example 1 except that the low oxygen permeability compound solution C was used in place of the low oxygen permeability compound solution A. The mobility and the threshold voltage were evaluated. In this semiconductor device, the first layer of the second insulating layer had a film thickness of 2.9 μm, the second layer had a film thickness of 3.1 μm, the difference (absolute value) in solubility parameter between the first layer and the second layer was 9.4 $(MPa)^{1/2}$, the second insulating layer had an oxygen permeability of 1.4 cc/($m^2$·24h·atm), and the second layer of the second insulating layer had an oxygen permeability of 1.4 cc/($m^2$·24h·atm). Here, in Example 3, the low oxygen permeability compound solution had a higher polyvinyl alcohol concentration than in Example 1, and accordingly, the film thickness of the second layer of the second insulating layer was a large value.

Example 4

A semiconductor device was prepared in the same manner as in Example 1 except that the semiconductor solution A was used in place of the semiconductor solution B. The mobility and the threshold voltage were evaluated. In this semiconductor device, the first layer of the second insulating layer had a film thickness of 2.9 μm, the second layer had a film thickness of 2.0 μm, the difference (absolute value) in solubility parameter between the first layer and the second layer was 9.4 $(MPa)^{1/2}$, the second insulating layer had an oxygen permeability of 2.2 cc/($m^2$·24h·atm), and the second layer of the second insulating layer had an oxygen permeability of 2.2 cc/($m^2$·24h·atm).

Example 5

A semiconductor device was prepared in the same manner as in Example 4 except that the low oxygen permeability compound solution E was used in place of the low oxygen permeability compound solution A. The mobility and the threshold voltage were evaluated. In this semiconductor device, the first layer of the second insulating layer had a film thickness of 2.9 μm, the second layer had a film thickness of 4.1 μm, the difference (absolute value) in solubility parameter between the first layer and the second layer was 5.1 $(MPa)^{1/2}$, the second insulating layer had an oxygen permeability of 2.3 cc/($m^2$·24h·atm), and the second layer of the second insulating layer had an oxygen permeability of 2.3 cc/($m^2$·24h·atm).

Example 6

A first layer of a second insulating layer was formed in the same manner as in Example 4 except that the electron-donating material solution D was used in place of the electron-donating material solution A. Next, the low oxygen permeability compound solution D was applied by spraying so as to cover the first layer of the second insulating layer, and heat-treated under a nitrogen stream at 90°C for 5 minutes to form a second layer of the second insulating layer. Thus, the semiconductor device was obtained. In the same manner as in Example 1, the mobility and the threshold voltage were evaluated. In this semiconductor device, the first layer of the second insulating layer had a film thickness of 2.0 μm, the second layer had a film thickness of 100.0 μm, the difference (absolute value) in solubility parameter

between the first layer and the second layer was 8.5 $(MPa)^{1/2}$, the second insulating layer had an oxygen permeability of 3.0 cc/($m^2$·24h·atm), and the second layer of the second insulating layer had an oxygen permeability of 3.0 cc/($m^2$·24h·atm).

Example 7

A semiconductor device was prepared in the same manner as in Example 4 except that the electron-donating material solution B was used in place of the electron-donating material solution A and that the low oxygen permeability compound solution C was used in place of the low oxygen permeability compound solution A. The mobility and the threshold voltage were evaluated. In this semiconductor device, the first layer of the second insulating layer had a film thickness of 2.9 μm, the second layer had a film thickness of 3.1 μm, the difference (absolute value) in solubility parameter between the first layer and the second layer was 9.4 $(MPa)^{1/2}$, the second insulating layer had an oxygen permeability of 1.4 cc/($m^2$·24h·atm), and the second layer of the second insulating layer had an oxygen permeability of 1.4 cc/($m^2$·24h·atm).

Example 8

A semiconductor device was prepared in the same manner as in Example 7 except that the electron-donating material solution C was used in place of the electron-donating material solution B. The mobility and the threshold voltage were evaluated. In this semiconductor device, the first layer of the second insulating layer had a film thickness of 2.9 μm, the second layer had a film thickness of 3.1 μm, the difference (absolute value) in solubility parameter between the first layer and the second layer was 9.5 $(MPa)^{1/2}$, the second insulating layer had an oxygen permeability of 1.4 cc/($m^2$·24h·atm), and the second layer of the second insulating layer had an oxygen permeability of 1.4 cc/($m^2$·24h·atm).

Example 9

A semiconductor device was prepared in the same manner as in Example 7 except that the electron-donating material solution A was used in place of the electron-donating material solution B. The mobility and the threshold voltage were evaluated. In this semiconductor device, the first layer of the second insulating layer had a film thickness of 2.9 μm, the second layer had a film thickness of 3.1 μm, the difference (absolute value) in solubility parameter between the first layer and the second layer was 9.4 $(MPa)^{1/2}$, the second insulating layer had an oxygen permeability of 1.4 cc/($m^2$·24h·atm), and the second layer of the second insulating layer had an oxygen permeability of 1.4 cc/($m^2$·24h·atm).

Example 10

A semiconductor device was prepared in the same manner as in Example 7 except that the electron-donating material solution E was used in place of the electron-donating material solution B. The mobility and the threshold voltage were evaluated. In this semiconductor device, the first layer of the second insulating layer had a film thickness of 2.9 μm, the second layer had a film thickness of 3.1 μm, the difference (absolute value) in solubility parameter between the first layer and the second layer was 9.4 $(MPa)^{1/2}$, the second insulating layer had an oxygen permeability of 1.4 cc/($m^2$·24h·atm), and the second layer of the second insulating layer had an oxygen permeability of 1.4 cc/($m^2$·24h·atm).

Example 11

A semiconductor device was prepared in the same manner as in Example 7 except that the electron-donating material solution F was used in place of the electron-donating material solution B. The mobility and the threshold voltage were evaluated. In this semiconductor device, the first layer of the second insulating layer had a film thickness of 2.9 μm, the second layer had a film thickness of 3.1 μm, the difference (absolute value) in solubility parameter between the first layer and the second layer was 9.3 $(MPa)^{1/2}$, the second insulating layer had an oxygen permeability of 1.4 cc/($m^2$·24h·atm), and the second layer of the second insulating layer had an oxygen permeability of 1.4 cc/($m^2$·24h·atm).

Example 12

A semiconductor device was prepared in the same manner as in Example 7 except that the electron-donating material solution G was used in place of the electron-donating material solution B. The mobility and the threshold voltage were evaluated. In this semiconductor device, the first layer of the second insulating layer had a film thickness of 2.9 μm, the second layer had a film thickness of 3.1 μm, the difference (absolute value) in solubility parameter between the first layer and the second layer was 9.3 $(MPa)^{1/2}$, the second insulating layer had an oxygen permeability of 1.4

cc/($m^2$·24h·atm), and the second layer of the second insulating layer had an oxygen permeability of 1.4 cc/($m^2$·24h·atm).

Example 13

A semiconductor layer 4 was formed in the same manner as in Example 4. Next, a second insulating layer was formed by repeating, 18 times, the step in which 2.0 μl of the electron-donating material solution I was dropped onto the semiconductor layer 4 so as to cover the semiconductor layer 4, and heat-treated under a nitrogen stream at 110°C for 15 minutes. Thus, the semiconductor device was obtained. In the same manner as in Example 1, the mobility and the threshold voltage were evaluated. The second insulating layer in this semiconductor device had a film thickness of 450 μm and an oxygen permeability of 3.8 cc/($m^2$·24h·atm).

Example 14

A semiconductor layer 4 was formed in the same manner as in Example 4. Next, 0.5 μl of the electron-donating material solution J was dropped onto the semiconductor layer 4 so as to cover the semiconductor layer 4, and heat-treated under a nitrogen stream at 110°C for 15 minutes to form a second insulating layer. Thus, the semiconductor device was obtained. In the same manner as in Example 1, the mobility and the threshold voltage were evaluated. The second insulating layer in this semiconductor device had a film thickness of 3.1 μm and an oxygen permeability of 1.4 cc/($m^2$·24h·atm).

Example 15

A semiconductor device was prepared in the same manner as in Example 3 except that the semiconductor solution C was used in place of the semiconductor solution A. The mobility and the threshold voltage were evaluated. In this semiconductor device, the first layer of the second insulating layer had a film thickness of 2.9 μm, the second layer had a film thickness of 3.1 μm, the difference (absolute value) in solubility parameter between the first layer and the second layer was 9.4 $(MPa)^{1/2}$, the second insulating layer had an oxygen permeability of 1.4 cc/($m^2$·24h·atm), and the second layer of the second insulating layer had an oxygen permeability of 1.4 cc/($m^2$·24h·atm).

Example 16

A second insulating layer was formed in the same manner as in Example 15. Next, 0.5 μl of the low water vapor permeability compound solution B was dropped onto the semiconductor layer 4 so as to cover the semiconductor layer 4, and heat-treated under a nitrogen stream at 110°C for 15 minutes to form a protective layer. Thus, the semiconductor device was obtained. In the same manner as in Example 1, the mobility and the threshold voltage were evaluated. The protective layer in this semiconductor device had a film thickness of 4.1 μm and a water vapor permeability of 31 g/($m^2$·24h).

Example 17

A second insulating layer was formed in the same manner as in Example 15. Next, 2.0 μl of the low water vapor permeability compound solution C was dropped onto the semiconductor layer 4 so as to cover the semiconductor layer 4, and heat-treated under a nitrogen stream at 110°C for 15 minutes to form a protective layer. Thus, the semiconductor device was obtained. In the same manner as in Example 1, the mobility and the threshold voltage were evaluated. The protective layer in this semiconductor device had a film thickness of 12.8 μm and a water vapor permeability of 10 g/($m^2$·24h).

Example 18

A second insulating layer was formed in the same manner as in Example 15. Next, a protective layer was formed by repeating, four times, the step in which 2.0 μl of the low water vapor permeability compound solution A was dropped onto the semiconductor layer 4 so as to cover the semiconductor layer 4, and heat-treated under a nitrogen stream at 110°C for 15 minutes. Thus, the semiconductor device was obtained. In the same manner as in Example 1, the mobility and the threshold voltage were evaluated. The protective layer in this semiconductor device had a film thickness of 100 μm and a water vapor permeability of 1.3 g/($m^2$·24h).

Comparative Example 1

A semiconductor device was prepared in the same manner as in Example 4 except that the second layer of the second insulating layer was not formed. The mobility was evaluated. The first layer of the second insulating layer in this semiconductor device had a film thickness of 2.9 μm, and the second insulating layer had an oxygen permeability of 2500 cc/($m^2$·24h·atm).

Comparative Example 2

A semiconductor device was prepared in the same manner as in Example 4 except that the low oxygen permeability compound solution F was used in place of the low oxygen permeability compound solution A. The mobility was evaluated. In this semiconductor device, the first layer of the second insulating layer had a film thickness of 2.9 μm, the second layer had a film thickness of 2.0 μm, the difference (absolute value) in solubility parameter between the first layer and the second layer was 5.1 $(MPa)^{1/2}$, the second insulating layer had an oxygen permeability of 5.9 cc/($m^2$·24h·atm), and the second layer of the second insulating layer had an oxygen permeability of 5.9 cc/($m^2$·24h·atm).

Comparative Example 3

A semiconductor device was prepared in the same manner as in Example 4 except that the electron-donating material solution H was used in place of the electron-donating material solution A. An attempt was made to evaluate the mobility, but no change of Id was recognized with respect to Vg, and it was not possible to evaluate the mobility. The difference (absolute value) in solubility parameter between the first layer and the second layer in this semiconductor device was 1.8 $(MPa)^{1/2}$.

Example 19

A complementary semiconductor device shown in Fig. 8 was produced. On a glass substrate 1 (having a film thickness of 0.7 mm), chromium and gold were vacuum vapor deposited through a mask to a thickness of 5 nm and 50 nm respectively using a resistance heating method to form a gate electrode 2 for the p-type semiconductor device and a gate electrode 2 for the n-type semiconductor device. Next, the resulting substrate was spin-coated (2000 rpm × 30 seconds) with the gate insulating layer solution A, and the coated substrate was heat-treated under a nitrogen stream at 200°C for one hour to form a gate insulating layer 3 having a film thickness of 600 nm. Subsequently, gold was vacuum vapor deposited through a mask to a film thickness of 50 nm using a resistance heating method, to form a source electrode 5 and a drain electrode 6 for the p-type semiconductor device and a source electrode 5 and a drain electrode 6 for the n-type semiconductor device. Next, 1 μl of the semiconductor solution C was dropped between the source electrode 5 and the drain electrode 6 of the p-type semiconductor device and between the source electrode 5 and the drain electrode 6 of the n-type semiconductor device, air-dried at 30°C for 10 minutes, and heat-treated on a hot plate under a nitrogen stream at 150°C for 30 minutes to form a semiconductor layer 4 for the p-type semiconductor device and a semiconductor layer 4 for the n-type semiconductor device. Next, 0.5 μl of the electron-donating material solution A was dropped onto the semiconductor layer 4 of the n-type semiconductor device so as to cover the semiconductor layer 4 of the n-type semiconductor device, and furthermore, 0.5 μl of the second insulating layer solution A was dropped onto the semiconductor layer 4 of the p-type semiconductor device so as to cover the semiconductor layer 4 of the p-type semiconductor device, followed by heat-treating under a nitrogen stream at 110°C for 15 minutes, to form a first layer of a second insulating layer. Next, 2.0 μl of the low oxygen permeability compound solution C was dropped so as to cover the first layer of the second insulating layer of the n-type semiconductor device, and furthermore, 2.0 μl of the low oxygen permeability compound solution C was dropped so as to cover the first layer of the second insulating layer of the p-type semiconductor device, followed by heat-treating under a nitrogen stream at 90°C for five minutes to form a second layer of the second insulating layer. Thus, the p-type semiconductor device and the n-type semiconductor device were obtained. Next, the p-type semiconductor device and the n-type semiconductor device were wired to each other to form a complementary semiconductor device as shown in Fig. 9. Thus, the complementary semiconductor device was obtained.

The source and drain electrodes (channel width) of each of the p-type semiconductor device and the n-type semiconductor device had a width of 200 μm, and the spacing between the source and drain electrodes (channel length) was 100 μm.

A measurement was made in the atmosphere using a semiconductor characterization system Model 4200-SCS and a stabilized DC power supply AD-8723D (manufactured by A&D Company, Limited). In Fig. 9, $V_{DD}$ was 10 V, and the GND terminal was grounded. A change (gain) in $V_{out}$ against the $V_{in}$ change of 0→10 V and $V_{in}$(1/2 $V_{DD}$) at which $V_{out}$ becomes half of $V_{DD}$ were evaluated. In addition, 20 days after this, the gain and the 1/2$V_{DD}$ were evaluated

in the same manner. The results are shown in Table 2.

Example 20

A complementary semiconductor device was prepared in the same manner as in Example 19 except that the second insulating layer solution B was used in place of the second insulating layer solution A. The gain and the 1/2$V_{DD}$ were evaluated.

Example 21

A second insulating layer was formed in the same manner as in Example 19. A protective layer was formed by repeating, four times, the step in which 2.0 μl of the low water vapor permeability compound solution A was dropped onto the semiconductor layer 4 so as to cover the semiconductor layer 4, and heat-treated under a nitrogen stream at 110°C for 15 minutes. Thus, a complementary semiconductor device was obtained. A complementary semiconductor device was prepared in the same manner as in Example 19, and the gain and the 1/2$V_{DD}$ were evaluated.

Example 22

A complementary semiconductor device was prepared in the same manner as in Example 21 except that the second insulating layer solution B was used in place of the second insulating layer solution A. The gain and the 1/2$V_{DD}$ were evaluated.

[Table 1]

| | Semiconductor Layer | Conjugated Polymer | Second Insulating Layer | | | | | | Electron-donating Material | Oxygen Permeability of Second Insulating Layer [cc/m$^2$·24h·atm] | Oxygen Permeability of Second Layer of Second Insulating Layer [cc/m$^2$·24h·atm] | Water Vapor Permeability of Second Insulating Layer [g/m$^2$·24 h] | Protective Layer | Water Vapor Permeability of Protective Layer [g/m$^2$·24 h] | Mobility [cm$^2$/Vs] | | Threshold Voltage [V] | |
|---|---|---|---|---|---|---|---|---|---|---|---|---|---|---|---|---|---|---|
| | | | First Layer | Film Thickness of First Layer [μm] | Second Layer | Film Thickness of Second Layer [μm] | Difference (in absolute value) in Solubility Parameter [(MPa)$^{1/2}$] | Whole Film Thickness [μm] | | | | | | | on the day of production | after 20 days | on the day of production | after 20 days |
| Example 1 | Semiconductor Solution B | Compound 72 | PMMA/DBU | 2.9 | Polyvinyl Alcohol | 2.0 | 9.4 | 4.9 | DBU | 2.2 | 2.2 | 353 | - | - | 1.05 | 1.04 | 1.1 | 2.1 |
| Example 2 | Semiconductor Solution B | Compound 72 | PMMA/DBU | 2.9 | Polyvinyl Alcohol | 1.1 | 9.4 | 4.0 | DBU | 3.9 | 3.9 | 353 | - | - | 1.05 | 0.99 | 1.0 | 2.1 |
| Example 3 | Semiconductor Solution B | Compound 72 | PMMA/DBU | 2.9 | Polyvinyl Alcohol | 3.1 | 9.4 | 6.0 | DBU | 1.4 | 1.4 | 353 | - | - | 1.05 | 1.05 | 1.0 | 2.0 |
| Example 4 | Semiconductor Solution A | Compound 60 | PMMA/DBU | 2.9 | Polyvinyl Alcohol | 2.0 | 9.4 | 4.9 | DBU | 2.2 | 2.2 | 353 | - | - | 1.00 | 0.99 | 0.9 | 2.0 |
| Example 5 | Semiconductor Solution A | Compound 60 | PMMA/DBU | 2.9 | Ethylene-Vinyl Alcohol Copolymer | 4.1 | 5.1 | 7.0 | DBU | 2.3 | 2.3 | 244 | - | - | 1.01 | 1.00 | 1.0 | 1.9 |
| Example 6 | Semiconductor Solution A | Compound 60 | Cycloolefin Polymer/DBU | 2.0 | Polyacrylonitrile | 100.0 | 8.5 | 102 | DBU | 3.0 | 3.0 | 5.0 | - | - | 0.87 | 0.84 | 2.3 | 2.5 |

(continued)

| | Semiconductor Layer | Conjugated Polymer | Second Insulating Layer | | | | | | Electron-donating Material | Oxygen Permeability of Second Insulating Layer [cc/m²·24h·atm] | Oxygen Permeability of Second Layer of Second Insulating Layer [cc/m²·24h·atm] | Water Vapor Permeability of Second Insulating Layer [g/m²·24 h] | Protective Layer | Water Vapor Permeability of Protective Layer [g/m²·24 h] | Mobility [cm²/Vs] | | Threshold Voltage [V] | |
|---|---|---|---|---|---|---|---|---|---|---|---|---|---|---|---|---|---|---|
| | | | First Layer | Film Thickness of First Layer [μm] | Second Layer | Film Thickness of Second Layer [μm] | Difference (in absolute value) in Solubility Parameter [(MPa)^1/2] | Whole Film Thickness [μm] | | | | | | | on the day of production | after 20 days | on the day of production | after 20 days |
| Example 7 | Semiconductor Solution A | Compound 60 | PMMA/ Dicyclohexylmethylamine | 2.9 | Polyvinyl Alcohol | 3.1 | 9.4 | 6.0 | Dicyclohexylmethylamine | 1.4 | 1.4 | 353 | - | - | 0.78 | 0.78 | 1.0 | 2.1 |
| Example 8 | Semiconductor Solution A | Compound 60 | PMMA/Quinuclidine | 2.9 | Polyvinyl Alcohol | 3.1 | 9.5 | 6.0 | Quinuclidine | 1.4 | 1.4 | 353 | - | - | 0.82 | 0.82 | 1.1 | 2.1 |
| Example 9 | Semiconductor Solution A | Compound 60 | PMMA/ DBU | 2.9 | Polyvinyl Alcohol | 3.1 | 9.4 | 6.0 | DBU | 1.4 | 1.4 | 353 | - | - | 1.03 | 1.03 | 1.0 | 2.0 |
| Example 10 | Semiconductor Solution A | Compound 60 | PMMA/ DBN | 2.9 | Polyvinyl Alcohol | 3.1 | 9.4 | 6.0 | DBN | 1.4 | 1.4 | 353 | - | - | 1.01 | 1.01 | 0.9 | 1.9 |
| Example 11 | Semiconductor Solution A | Compound 60 | PMMA/TBD | 2.9 | Polyvinyl Alcohol | 3.1 | 9.3 | 6.0 | TBD | 1.4 | 1.4 | 353 | - | - | 0.97 | 0.97 | 1.0 | 2.0 |
| Example 12 | Semiconductor Solution A | Compound 60 | PMMA/ MTBD | 2.9 | Polyvinyl Alcohol | 3.1 | 9.3 | 6.0 | MTBD | 1.4 | 1.4 | 353 | - | - | 0.99 | 0.99 | 1.0 | 2.0 |
| Example 13 | Semiconductor Solution A | Compound 60 | Cycloolefin Polymer/ DBU | 450 | none | - | - | 450.0 | DBU | 3.8 | - | 0.3 | - | - | 0.90 | 0.85 | 2.4 | 2.4 |

(continued)

| | Semiconductor Layer | Conjugated Polymer | Second Insulating Layer | | | | | | Electron-donating Material | Oxygen Permeability of Second Insulating Layer [cc/m2·24h·atm] | Oxygen Permeability of Second Layer of Second Insulating Layer [cc/m2·24h·atm] | Water Vapor Permeability of Second Insulating Layer [g/m2·24 h] | Protective Layer | Water Vapor Permeability of Protective Layer [g/m2·24 h] | Mobility [$cm^2/Vs$] | | Threshold Voltage [V] | |
|---|---|---|---|---|---|---|---|---|---|---|---|---|---|---|---|---|---|---|
| | | | First Layer | Film Thickness of First Layer [μm] | Second Layer | Film Thickness of Second Layer [μm] | Difference (in absolute value) in Solubility Parameter [(MPa)$^{1/2}$] | Whole Film Thickness [μm] | | | | | | | on the dayof production | after 20 days | on the dayof production | after 20 days |
| Example 14 | Semiconductor Solution A | Compound 60 | Polyvinyl Alcohol/DBU | 3.1 | none | - | - | 3.1 | DBU | 1.4 | - | 1210 | - | - | 0.90 | 0.90 | 0.3 | 1.3 |
| Example 15 | Semiconductor Solution C | Compound 78 | PMMA/ DBU | 2.9 | Polyvinyl Alcohol | 3.1 | 9.4 | 6.0 | DBU | 1.4 | 1.4 | 353 | - | - | 1.01 | 1.01 | 1.1 | 2.1 |
| Example 16 | Semiconductor Solution C | Compound 78 | PMMA/ DBU | 2.9 | Polyvinyl Alcohol | 3.1 | 9.4 | 6.0 | DBU | 1.4 | 1.4 | 353 | Cycloolefin Polymer | 31 | 1.00 | 1.00 | 1.0 | 1.4 |
| Example 17 | Semiconductor Solution C | Compound 78 | PMMA/ DBU | 2.9 | Polyvinyl Alcohol | 3.1 | 9.4 | 6.0 | DBU | 1.4 | 1.4 | 353 | Cycloolefin Polymer | 10 | 1.00 | 1.00 | 1.0 | 1.2 |
| Example 18 | Semiconductor Solution C | Compound 78 | PMMA/ DBU | 2.9 | Polyvinyl Alcohol | 3.1 | 9.4 | 6.0 | DBU | 1.4 | 1.4 | 353 | Cycloolefin Polymer | 1.3 | 1.02 | 1.02 | 1.0 | 1.0 |
| Comparative Example 1 | Semiconductor Solution A | Compound 60 | PMMA/ DBU | 2.9 | none | - | - | 2.9 | DBU | 2500 | - | 353 | - | - | 0.90 | 0.21 | 0.9 | 2.1 |

(continued)

| | Semiconductor Layer | Conjugated Polymer | Second Insulating Layer | | | | | | Electron-donating Material | Oxygen Permeability of Second Insulating Layer [cc/m2·24h·atm] | Oxygen Permeability of Second Layer of Second Insulating Layer [cc/m2·24h·atm] | Water Vapor Permeability of Second Insulating Layer [g/m2·24 h] | Protective Layer | Water Vapor Permeability of Protective Layer [g/m2·24 h] | Mobility [cm2/Vs] | | Threshold Voltage [V] | |
|---|---|---|---|---|---|---|---|---|---|---|---|---|---|---|---|---|---|---|
| | | | First Layer | Film Thickness of First Layer [μm] | Second Layer | Film Thickness of Second Layer [μm] | Difference (in absolute value) in Solubility Parameter [(MPa)1/2] | Whole Film Thickness [μm] | | | | | | | on the day of production | after 20 days | on the day of production | after 20 days |
| Comparative Example 2 | Semiconductor Solution A | Compound 60 | PMMA/ DBU | 2.9 | Ethylene-Vinyl Alcohol Copolymer | 2.0 | 5.1 | 4.9 | DBU | 5.9 | 5.9 | 196 | - | - | 0.89 | 0.45 | 1.0 | 1.9 |
| Comparative Example 3 | Semiconductor Solution A | Compound 60 | Poly(melamine-co-formaldehyde/DBU DBU | - | Polyvinyl Alcohol | - | 1.8 | 4.9 | DBU | - | - | - | - | - | - | - | - | - |

[Table 2]

| | Semiconductor Layer | Conjugated Polymer | Second Insulating Layer of N-type Semiconductor Device | | | | | | | | | | Second Insulating Layer of P-type Semiconductor Device | | Protective Layer | Water Vapor Permeability of Protective Layer [g/m²·24h] | Gain | | 1/2VDD [V] | |
|---|---|---|---|---|---|---|---|---|---|---|---|---|---|---|---|---|---|---|---|---|
| | | | First Layer | Film Thickness of First Layer [μm] | Second Layer | Film Thickness of Second Layer [μm] | Difference (in absolute value) in Solubility Parameter [(MPa)$^{1/2}$] | Whole Film Thickness [μm] | Electron-donating Material | Oxygen Permeability of Second Insulating Layer [cc/m²·24h·atm] | Oxygen Permeability of Second Layer of Second Insulating Layer [cc/m²·24h·atm] | Water Vapor Permeability of Second Insulating Layer [g/m²·24h] | First Layer | Second Layer | | | on the day of production | after 20 days | on the day of production | after 20 days |
| Example 19 | Semiconductor Solution C | Compound 78 | PMMA/ DBU | 2.9 | Polyvinyl Alcohol | 3.1 | 9.4 | 6.0 | DBU | 1.4 | 1.4 | 353 | Polystyrene | Polyvinyl Alcohol | - | - | 20 | 20 | 5.5 | 6.5 |
| Example 20 | Semiconductor Solution C | Compound 78 | PMMA/ DBU | 2.9 | Polyvinyl Alcohol | 3.1 | 9.4 | 6.0 | DBU | 1.4 | 1.4 | 353 | PMMA | Polyvinyl Alcohol | - | - | 21 | 20 | 5.2 | 6.3 |
| Example 21 | Semiconductor Solution C | Compound 78 | PMMA/ DBU | 2.9 | Polyvinyl Alcohol | 3.1 | 9.4 | 6.0 | DBU | 1.4 | 1.4 | 353 | Polystyrene | Polyvinyl Alcohol | Cycloolefin Polymer | 1.3 | 22 | 22 | 5.3 | 5.5 |
| Example 22 | Semiconductor Solution C | Compound 78 | PMMA/ DBU | 2.9 | Polyvinyl Alcohol | 3.1 | 9.4 | 6.0 | DBU | 1.4 | 1.4 | 353 | PMMA | Polyvinyl Alcohol | Cycloolefin Polymer | 1.3 | 20 | 21 | 5.4 | 5.5 |

Reference Signs List

1 Substrate
2 Gate Electrode
3 Gate Insulating Layer
4 Semiconductor Layer
5 Source Electrode
6 Drain Electrode
7 Carbon Nanotube
8 Second Insulating Layer
9 First Layer of Second Insulating Layer
10 Second Layer of Second Insulating Layer
11 Third Insulating Layer
12 First Layer of Third Insulating Layer
13 Second Layer of Third Insulating Layer
14 Protective Layer
50 Antenna
51 P-type Semiconductor Device
52 N-type Semiconductor Device
101 P-type Semiconductor Device
201 N-type Semiconductor Device

## Claims

**1.** A semiconductor device, comprising:

a substrate;
a source electrode, a drain electrode, and a gate electrode;
a semiconductor layer in contact with said source electrode and said drain electrode;
a gate insulating layer insulating said semiconductor layer from said gate electrode; and
a second insulating layer in contact with said semiconductor layer on the opposite side of said semiconductor layer from said gate insulating layer;
wherein said semiconductor layer contains a carbon nanotube;
wherein said second insulating layer contains an electron-donating material having one or more selected from a nitrogen atom and a phosphorus atom; and
wherein said second insulating layer has an oxygen permeability of 4.0 cc/($m^2$·24h·atm) or less.

**2.** The semiconductor device according to claim 1, wherein said second insulating layer further comprises a polymer compound having one or more structures selected from the group consisting of a hydroxy group, cyano group, fluoro group, chloro group, and amide bond.

**3.** The semiconductor device according to claim 2, wherein said polymer compound is a vinyl alcohol resin.

**4.** The semiconductor device according to claim 1, wherein said second insulating layer comprises at least a first layer provided nearer to said semiconductor layer and a second layer provided farther from said semiconductor layer, wherein said first layer contains said electron-donating material, and
wherein said second layer has an oxygen permeability of 4.0 cc/($m^2$·24h·atm) or less.

**5.** The semiconductor device according to claim 4, wherein said second layer comprises a polymer compound having one or more structures selected from the group consisting of a hydroxy group, cyano group, fluoro group, chloro group, and amide bond.

**6.** The semiconductor device according to claim 5, wherein said polymer compound contained in said second layer is a vinyl alcohol resin.

7. The semiconductor device according to any one of claims 4 to 6, wherein a difference, in absolute value, in solubility parameter between the material constituting said first layer and the material constituting said second layer is 5.0 $(MPa)^{1/2}$ or more.

8. The semiconductor device according to any one of claims 1 to 7, wherein said electron-donating material is a compound having a nitrogen atom.

9. The semiconductor device according to any one of claims 1 to 8, wherein said electron-donating material is a compound containing a ring structure containing a nitrogen atom.

10. The semiconductor device according to any one of claims 1 to 9, wherein said electron-donating material is one or more compounds selected from an amidine compound and a guanidine compound.

11. The semiconductor device according to any one of claims 1 to 10, wherein said second insulating layer has a film thickness of 100 $\mu$m or less.

12. The semiconductor device according to any one of claims 1 to 11, wherein said second insulating layer has a water vapor permeability of 20 $g/(m^2 \cdot 24h)$ or less.

13. The semiconductor device according to any one of claims 1 to 12, comprising a protective layer in contact with said second insulating layer on the opposite side of said second insulating layer from said gate electrode, wherein said protective layer has a water vapor permeability of 20 $g/(m^2 \cdot 24h)$ or less.

14. The semiconductor device according to any one of claims 1 to 13, wherein said carbon nanotube exists as a carbon nanotube composite in which a conjugated polymer is attached to at least a part of the surface of said carbon nanotube.

15. A complementary semiconductor device, comprising: an n-type semiconductor device containing said semiconductor device according to any one of claims 1 to 14; and a p-type semiconductor device.

16. The complementary semiconductor device according to claim 15, wherein said p-type semiconductor device comprises:

a substrate;
a source electrode, a drain electrode, and a gate electrode;
a semiconductor layer in contact with said source electrode and said drain electrode; and
a gate insulating layer insulating said semiconductor layer from said gate insulating layer;
wherein said semiconductor layer of said p-type semiconductor device contains a carbon nanotube.

17. The complementary semiconductor device according to claim 16, wherein said p-type semiconductor device comprises a second insulating layer in contact with said semiconductor layer of said p-type semiconductor device on the opposite side of said semiconductor layer of said p-type semiconductor device from said gate insulating layer of said p-type semiconductor device.

18. The complementary semiconductor device according to claim 17, wherein at least part of said second insulating layer of said p-type semiconductor device is constituted by the same material as said second layer of said second insulating layer of said n-type semiconductor device.

19. The complementary semiconductor device according to claim 17 or 18, comprising a protective layer in contact with said second insulating layer of said p-type semiconductor device on the opposite side of said second insulating layer from said gate insulating layer, wherein the material used for said protective layer of said p-type semiconductor device is the same as used for said protective layer of said n-type semiconductor device, and wherein said protective layer of said p-type semiconductor device has a water vapor permeability of 20 $g/(m^2 \cdot 24h)$ or less.

20. A method of producing said semiconductor device according to any one of claims 1 to 14, said method comprising the step of forming said second insulating layer by a coating method.

21. The method of producing a semiconductor device according to claim 20, wherein said method is a method of producing said semiconductor device according to any one of claims 1 to 14,

wherein said second insulating layer comprises at least a first layer provided nearer to said semiconductor layer and a second layer provided farther from said semiconductor layer,

wherein said first layer contains said electron-donating material, and
wherein said second layer has an oxygen permeability of 4.0 cc/($m^2$·24h·atm) or less;

wherein said method comprises the steps of:

forming said first layer by a coating method; and
forming said second layer by a coating method,
wherein a drying temperature used in forming said second layer is equal to or lower than the glass transition temperature of said first layer.

**22.** A wireless communication device, comprising at least said semiconductor device according to any one of claims 1 to 14 and an antenna.

**23.** A wireless communication device, comprising at least said complementary semiconductor device according to any one of claims 15 to 19 and an antenna.

**24.** A merchandise tag, comprising said wireless communication device according to claim 22 or 23.

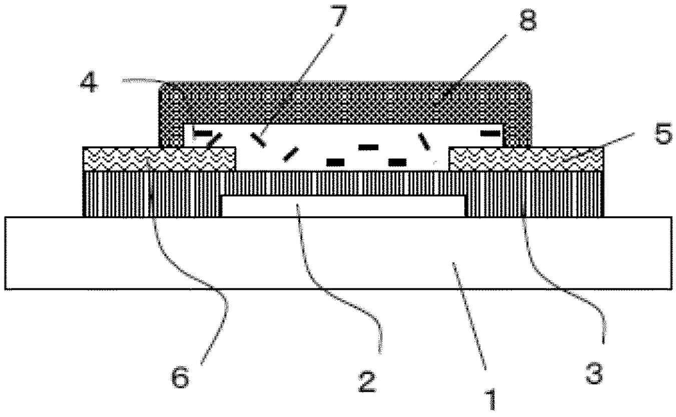


Fig. 1

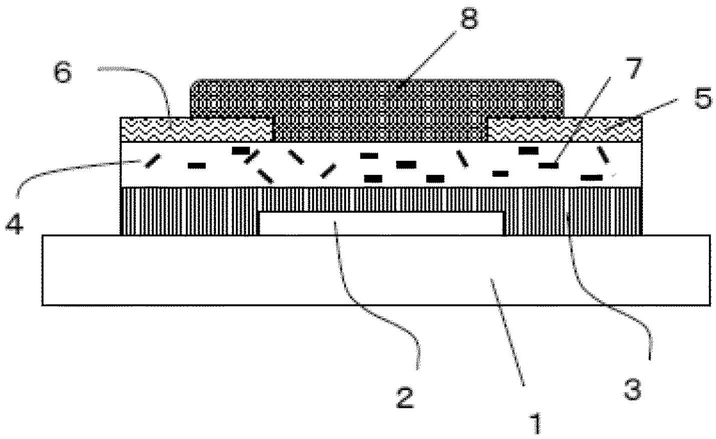


Fig. 2

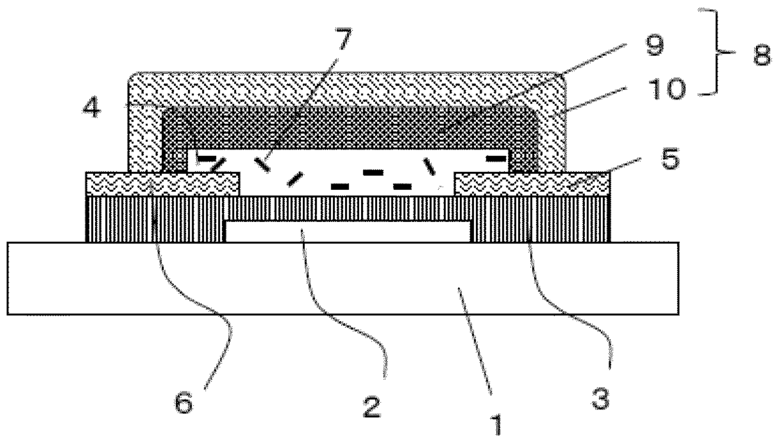


Fig. 3

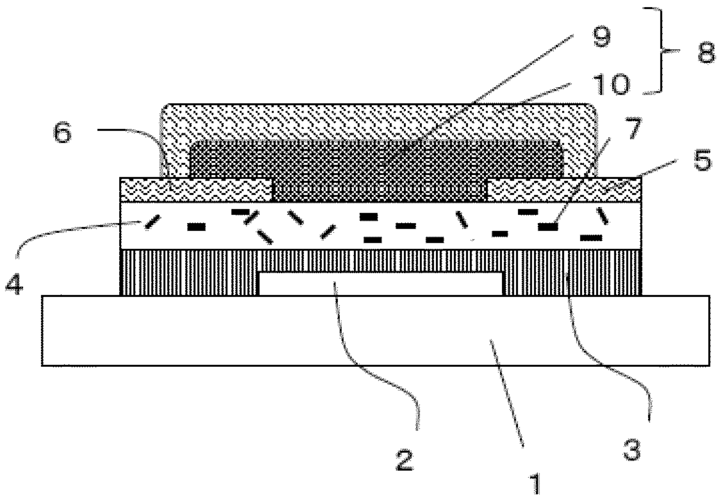


Fig. 4

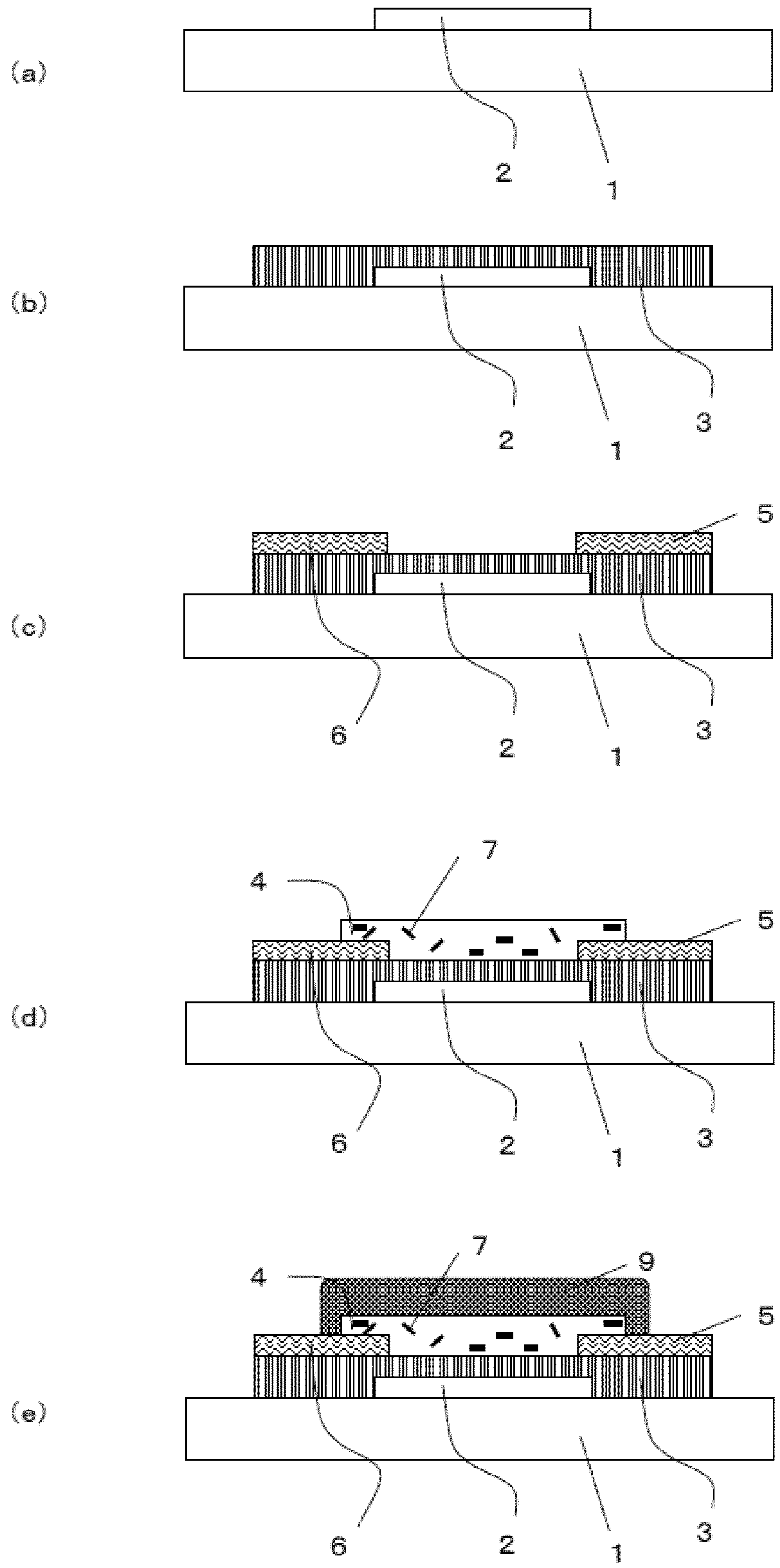


Fig. 5A

(f)

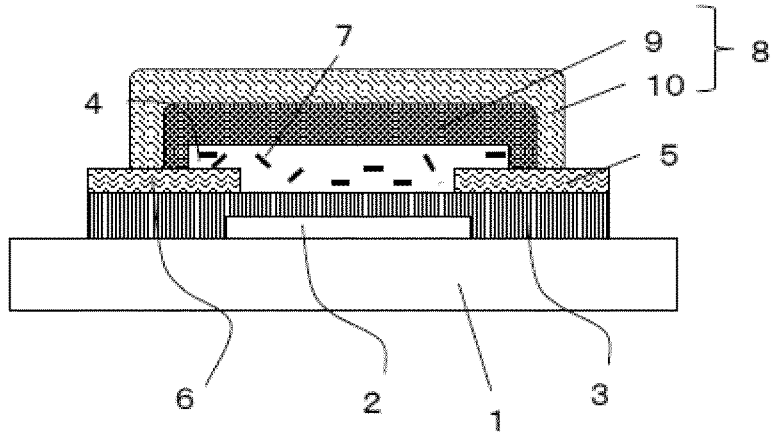


Fig. 5B

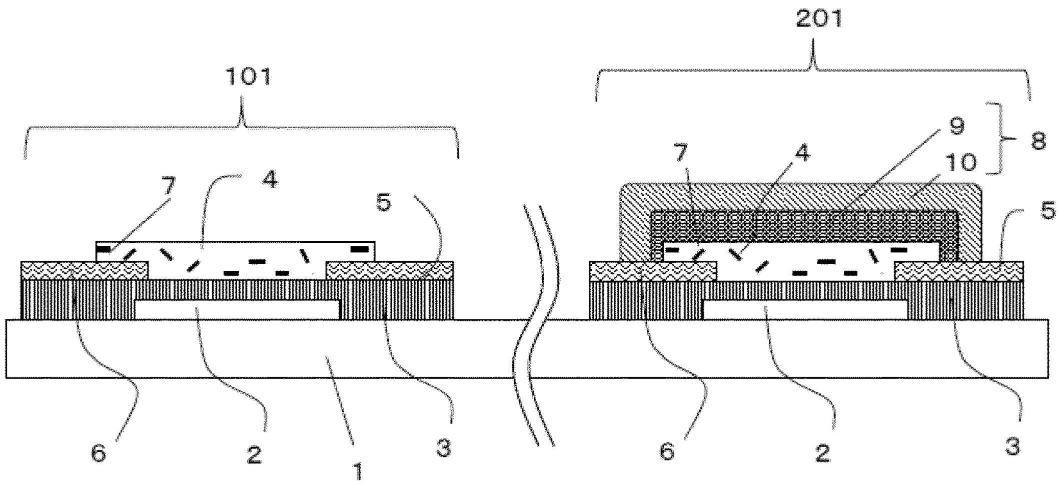


Fig. 6

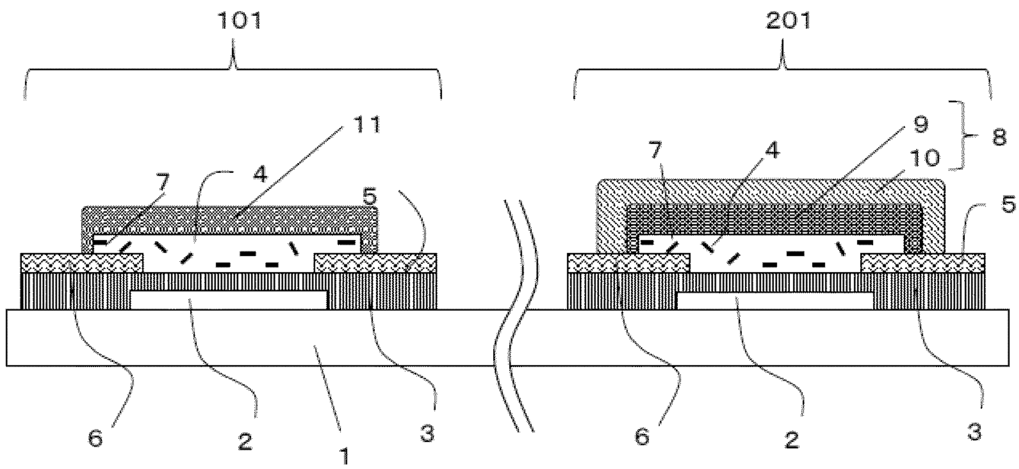


Fig. 7

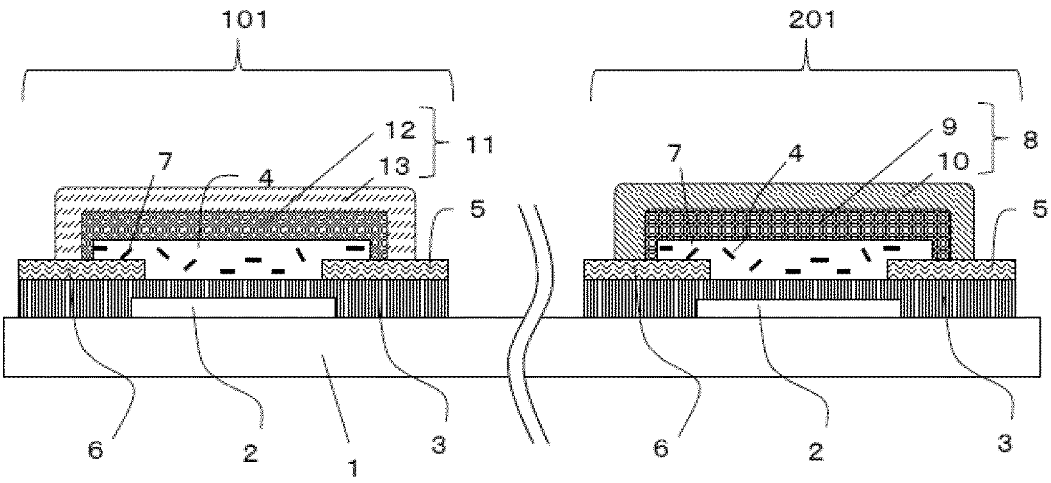


Fig. 8

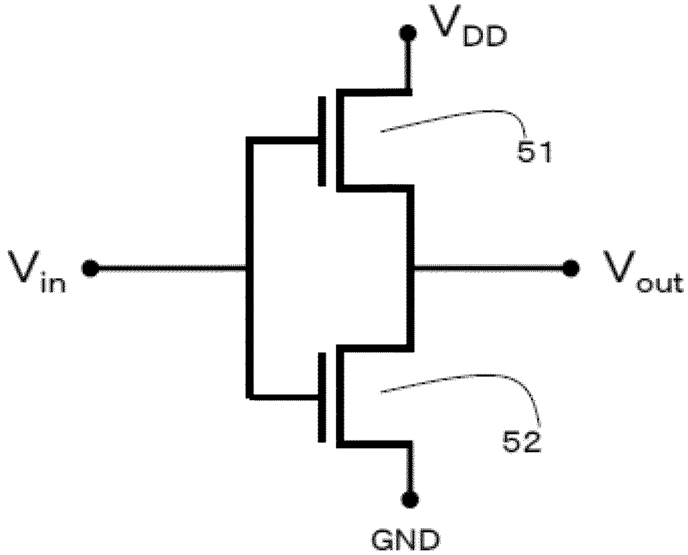


Fig. 9

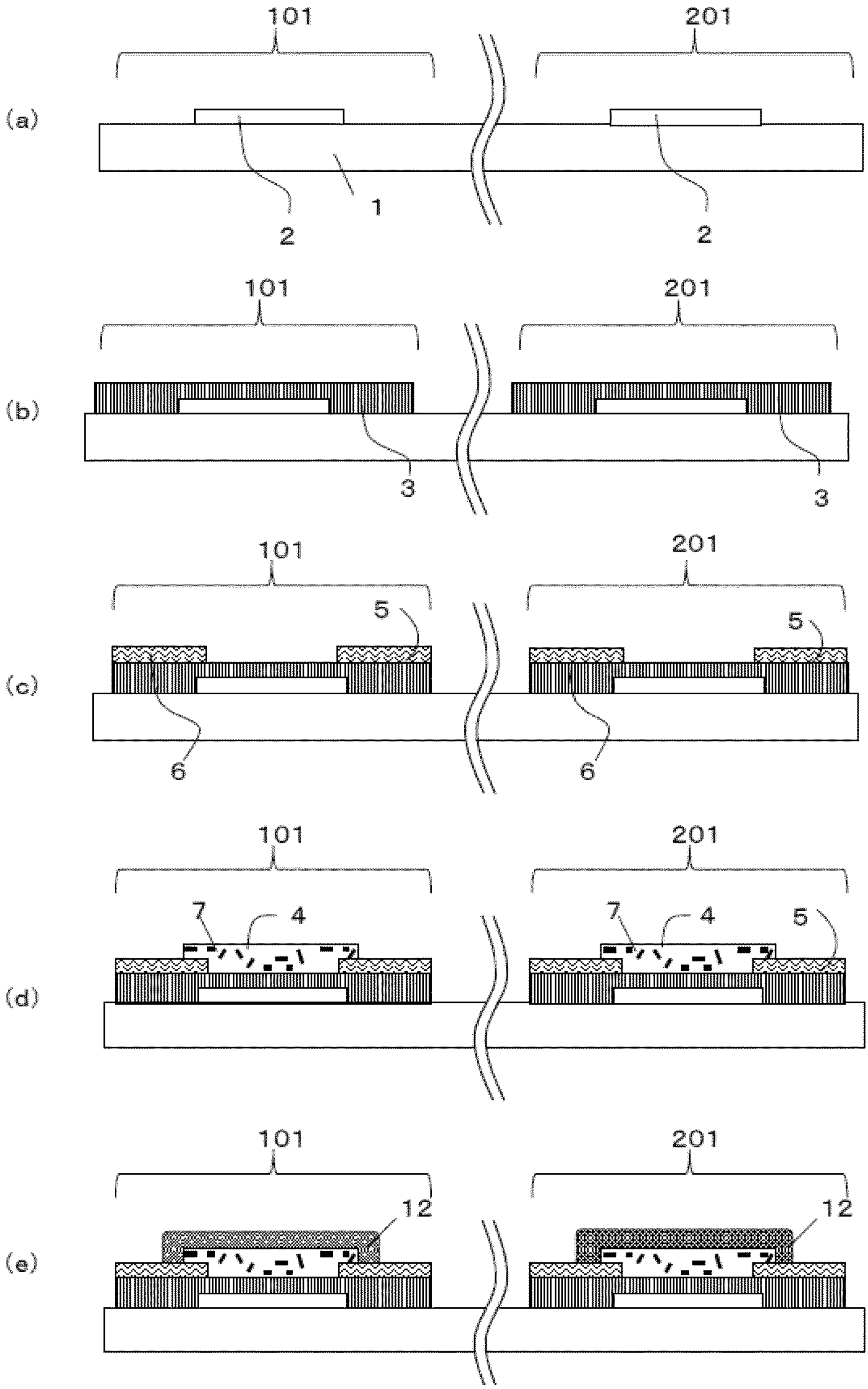
101
201
(a)
2
1
2
101
201
(b)
3
3
101
201
5
5
(c)
6
6
101
201
7
4
7
4
5
(d)
101
201
12
12
(e)

Fig. 10A

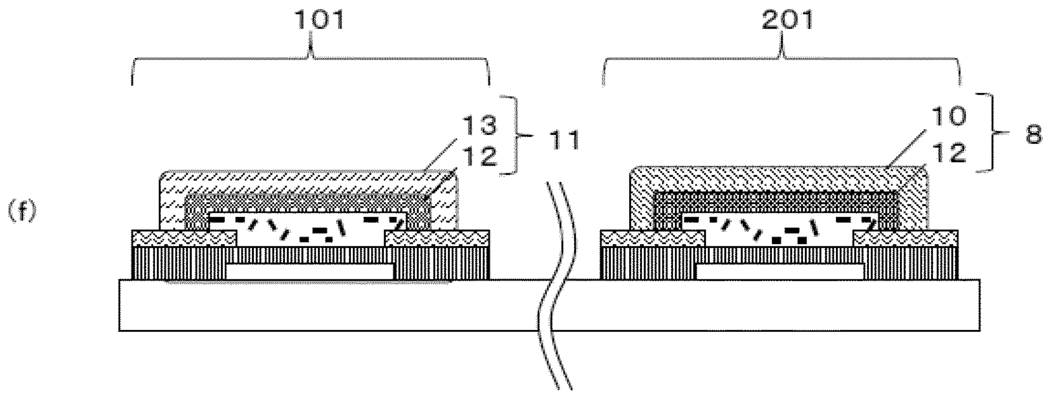


Fig. 10B

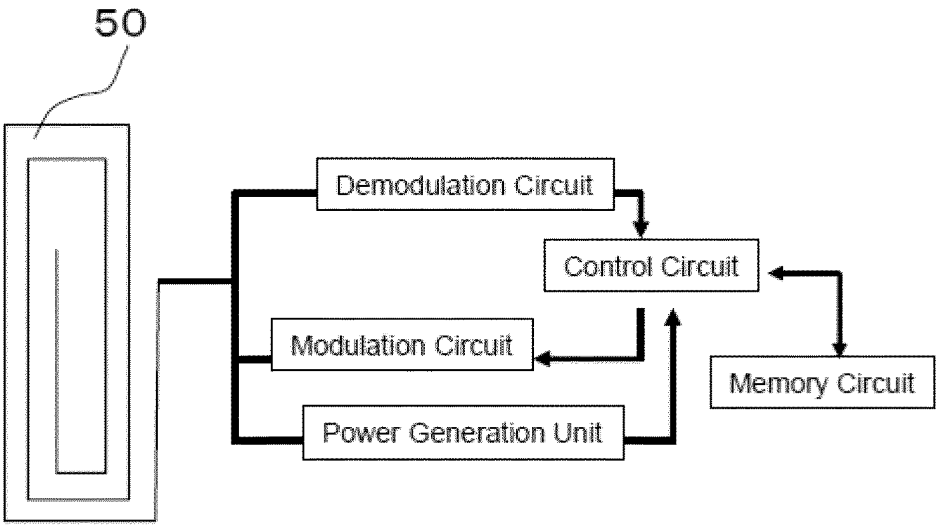


Fig. 11

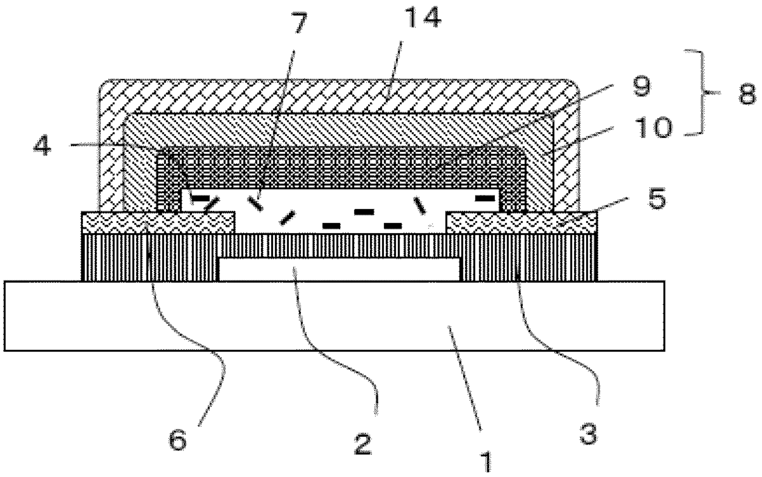


Fig. 12

**INTERNATIONAL SEARCH REPORT**

International application No. PCT/JP2018/007469

A. CLASSIFICATION OF SUBJECT MATTER
Int.Cl. H01L21/336(2006.01)i, C01B32/158(2017.01)i, H01L21/208(2006.01)i, H01L21/312(2006.01)i, H01L29/786(2006.01)i, H01L51/05(2006.01)i, H01L51/30(2006.01)i
According to International Patent Classification (IPC) or to both national classification and IPC

B. FIELDS SEARCHED
Minimum documentation searched (classification system followed by classification symbols)
Int.Cl. H01L21/336, C01B32/158, H01L21/208, H01L21/312, H01L29/786, H01L51/05, H01L51/30

Documentation searched other than minimum documentation to the extent that such documents are included in the fields searched

| | |
|---|---|
| Published examined utility model applications of Japan | 1922-1996 |
| Published unexamined utility model applications of Japan | 1971-2018 |
| Registered utility model specifications of Japan | 1996-2018 |
| Published registered utility model applications of Japan | 1994-2018 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| A | WO 2014/142105 A1 (TORAY INDUSTRIES, INC.) 18 September 2014 & US 2016/0035457 A1 & EP 2975649 A1 & KR 10-2015-0131074 A & CN 105190901 A & TW 201441308 A | 1-24 |
| A | JP 2009-283924 A (TORAY INDUSTRIES, INC.) 03 December 2009 (Family: none) | 1-24 |
| A | WO 2009/139339 A1 (TORAY INDUSTRIES, INC.) 19 November 2009 & US 2011/0121273 A1 & EP 2287936 A1 & CN 102027612 A & KR 10-2011-0021772 A & TW 201005029 A | 1-24 |
| A | WO 2008/023669 A1 (FUJITSU LTD.) 28 February 2008 & US 2009/0221130 A1 & EP 2055672 A1 & KR 10-2009-0039749 A | 1-24 |
| A | WO 2006/085611 A1 (JAPAN SCIENCE AND TECHNOLOGY AGENCY) 17 August 2006 & JP 2006-222279 A & US 2009/0008629 A1 & KR 10-2007-0095991 A & KR 10-0924668 B1 | 1-24 |
| P, A | WO 2017/130836 A1 (TORAY INDUSTRIES, INC.) 03 August 2017 & TW 201727922 A | 1-24 |

☐ Further documents are listed in the continuation of Box C. ☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| | |
|---|---|
| Date of the actual completion of the international search<br>02 May 2018 (02.05.2018) | Date of mailing of the international search report<br>15 May 2018 (15.05.2018) |
| Name and mailing address of the ISA/<br>Japan Patent Office<br>3-4-3, Kasumigaseki, Chiyoda-ku,<br>Tokyo 100-8915, Japan | Authorized officer<br><br>Telephone No. |

Form PCT/ISA/210 (second sheet) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- WO 2009139339 A
- US 2003122133 A1


### Non-patent literature cited in the description


- *Nano Letters,* 2001, vol. 1, 453-456
- *Poly. Eng. Sci.,* 1974, vol. 14 (2), 147-154